(19) Europäisches Patentamt
European Patent Office
Office européen des brevets

(11) **EP 2 649 724 B1**

(12) # EUROPEAN PATENT SPECIFICATION

(45) Date of publication and mention of the grant of the patent:
**21.01.2015 Bulletin 2015/04**

(51) Int Cl.:
***H03F 3/217*** *(2006.01)*

(21) Application number: **11815602.5**

(22) Date of filing: **09.12.2011**

(86) International application number:
**PCT/US2011/064255**

(87) International publication number:
**WO 2012/079031 (14.06.2012 Gazette 2012/24)**

(54) **PSEUDO-ENVELOPE FOLLOWER POWER MANAGEMENT SYSTEM WITH HIGH FREQUENCY RIPPLE CURRENT COMPENSATION**

LEISTUNGSVERWALTUNGSSYSTEM MIT HOCHFREQUENTER MISCHSTROMKOMPENSATION FÜR PSEUD-OHÜLLKURVENVERFOLGER

SYSTÈME DE GESTION DE PUISSANCE À SUIVEUR DE PSEUDO-ENVELOPPE AVEC COMPENSATION DE COURANT D'ONDULATION HAUTE FRÉQUENCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.12.2010 US 201061421348 P**
**25.08.2011 US 201113218400**
**09.12.2010 US 201061421475 P**
**30.03.2011 US 201161469276 P**
**19.04.2011 US 201113089917**

(43) Date of publication of application:
**16.10.2013 Bulletin 2013/42**

(60) Divisional application:
**14190851.7**

(73) Proprietor: **RF Micro Devices, Inc.**
**Greensboro, NC 27409 (US)**

(72) Inventors:
• **KHLAT, Nadim**
**F-31270 Cugnaux (FR)**
• **KAY, Michael, R.**
**Summerfield, NC 27358 (US)**
• **GORISSE, Philippe**
**F-31490 Brax (FR)**

(74) Representative: **Brophy, David Timothy**
**FRKelly**
**27 Clyde Road**
**Ballsbridge**
**Dublin 4 (IE)**

(56) References cited:
**EP-A1- 2 214 304      EP-A1- 2 244 366**
**US-A- 5 905 407       US-A1- 2003 137 286**
**US-A1- 2004 124 913    US-A1- 2009 289 720**
**US-A1- 2010 171 553    US-B1- 6 300 826**

• **JINSUNG CHOI ET AL: "A New Power Management IC Architecture for Envelope Tracking Power Amplifier", IEEE TRANSACTIONS ON MICROWAVE THEORY AND TECHNIQUES, IEEE SERVICE CENTER, PISCATAWAY, NJ, US, vol. 59, no. 7, 1 July 2011 (2011-07-01), pages 1796-1802, XP011369960, ISSN: 0018-9480, DOI: 10.1109/TMTT. 2011.2134108**
• **NAM-IN KIM ET AL: "Ripple feedback filter suitable for analog/digital mixed-mode audio amplifier for improved efficiency and stability", POWER ELECTRONICS SPECIALISTS CONFERENCE; [ANNUAL POWER ELECTRONICS SPECIALISTS CONFERENCE],, vol. 1, 23 June 2002 (2002-06-23), pages 45-49, XP010596063, ISBN: 978-0-7803-7262-7**

**EP 2 649 724 B1**

**Description**

<u>Related Applications</u>

The present application claims priority to U.S. Provisional Patent Application No. 61/421,348, filed December 9, 2010.

The present application claims priority to U.S. Provisional Patent Application No. 61/421,475, filed December 9, 2010.

The present application claims priority to U.S. Provisional Patent Application No. 61/469,276, filed March 30, 2011.

The present application claims priority to and is a continuation-in-part of U.S. Patent Application No. 13/089,917, filed April 19, 2011, entitled "PSEUDO-ENVELOPE FOLLOWING POWER MANAGEMENT SYSTEM," which claims priority to U.S. Provisional Patent Application No. 61/325,659, filed April 19, 2010.

The present application claims priority to and is a continuation-in-part of U.S. Patent Application No. 13/218,400, filed August 25, 2011, entitled "BOOST CHARGE-PUMP WITH FRACTIONAL RATIO AND OFFSET LOOP FOR SUPPLY MODULATION," which claims priority to U.S. Provisional Patent Application No. 61/376,877, filed August 25, 2010. U.S. Patent Application No. 13/218,400 is a continuation-in-part of U.S. Patent Application No. 13/089,917, filed April 19, 2011, which claims priority to U.S. Provisional Patent Application No. 61/325,659, filed April 19, 2010.

<u>Field of the Disclosure</u>

The embodiments described herein relate to a power management system for delivering current to a linear RF power amplifier. More particularly, the embodiments relate to the use of a pseudo-envelope tracker in a power management system of mobile communications equipment.

<u>Background</u>

Next-generation mobile devices are morphing from voice-centric telephones to message and multimedia-based "smart" phones that offer attractive new features. As an example, smart phones offer robust multimedia features such as web-browsing, audio and video playback and streaming, email access and a rich gaming environment. But even as manufacturers race to deliver ever more feature rich mobile devices, the challenge of powering them looms large.

In particular, the impressive growth of high bandwidth applications for radio frequency (RF) hand-held devices has led to increased demand for efficient power saving techniques to increase battery life. Because the power amplifier of the mobile device consumes a large percentage of the overall power budget of the mobile device, various power management systems have been proposed to increase the overall power efficiency of the power amplifier.

As an example, some power managements systems may use a $V_{RAMP}$ power control voltage to control the voltage presented on a power amplifier collector of a linear RF power amplifier. As another example, other power management schemes may use a buck converter power supply and a class AB amplifier in tandem to provide power to the linear RF power amplifier.

Even so, there remains a need to further improve the power efficiency of mobile devices to provide extended battery life. As a result, there is a need to improve the power management system of mobile devices.

Jinsung Choi et al., "A New Power Management IC Architecture for Envelope Tracking Power Amplifier", IEEE TRANSACTIONS ON MICROWAVE THEORY AND TECHNIQUES, vol. 59, no. 7, 1 July 2011, pages 1796-1802 discloses a switched mode assisted linear amplifier comprising a boost converter for assisting the linear class AB amplifier.

<u>Summary</u>

Embodiments disclosed in the detailed description relate to a pseudo-envelope follower power management system including a parallel amplifier and a switch mode power supply converter cooperatively coupled to generate a power supply voltage at a power supply output coupled to a linear RF power amplifier. The parallel amplifier output is in communication with the power amplifier supply output. The parallel amplifier governs operation of the switch mode power supply converter and regulates the power amplifier supply voltage base on a $V_{RAMP}$ signal. The parallel amplifier circuit includes an open loop high frequency compensation assist circuit that generates a high frequency ripple compensation current based on an estimate of the high frequency ripple currents contained in a ripple current of the power inductor. The high frequency ripple compensation current is injected into the parallel amplifier circuit output to cancel out high frequency ripple currents at the power amplifier supply output.

Those skilled in the art will appreciate the scope of the disclosure and realize additional aspects thereof after reading the following detailed description in association with the accompanying drawings.

Brief Description of the Drawings

The accompanying drawings incorporated in and forming a part of this specification illustrate several aspects of the disclosure, and together with the description serve to explain the principles of the disclosure.

Figure 1A depicts an embodiment of a pseudo-envelope follower power management system for managing power supplied to a linear RF power amplifier.

Figure 1B depicts an embodiment of a pseudo-envelope follower power management system for managing power supplied to a linear RF power amplifier.

Figure 2A depicts an embodiment of the pseudo-envelope follower power management system of Figure 1A in further detail.

Figure 2B depicts an embodiment of the pseudo-envelope follower power management system of Figure 1B in further detail.

Figure 3A depicts an embodiment of a pseudo-envelope follower power management system including a multi-level charge pump buck converter and an embodiment of a parallel amplifier circuit that includes an open loop ripple compensation assist circuit.

Figure 3B depicts an embodiment of a pseudo-envelope follower power management system including a buck converter and an embodiment of a parallel amplifier circuit that includes an open loop ripple compensation assist circuit.

Figure 3C depicts an embodiment of a pseudo-envelope follower power management system including a multi-level charge pump buck converter and an embodiment of a parallel amplifier circuit that includes an open loop ripple compensation assist circuit in combination with an open loop assist circuit.

Figure 3D depicts an embodiment of a pseudo-envelope follower power management system including a buck converter and an embodiment of a parallel amplifier circuit that includes an open loop ripple compensation assist circuit in combination with an open loop assist circuit.

Figure 4 depicts an embodiment of the open loop ripple compensation assist circuit and corresponding programmable delay circuitry of the pseudo-envelope follower power management systems depicted in Figures 3A-3D.

Figure 5 depicts three example ripple rejection response curves for an embodiment of the pseudo-envelope follower power management system, where each example ripple rejection response curve corresponds to a different programmable delay.

Figure 6 further depicts an embodiment of the high pass circuitry depicted in Figure 5.

Figure 7A depicts an embodiment of the open loop ripple compensation assist circuit of Figures 3A-3D.

Figure 7B depicts an alternative embodiment of the open loop ripple compensation assist circuit of Figures 3A-3D.

Figure 8A depicts example ripple rejection response curves for an example pseudo-envelope follower power management system having an operational amplifier isolation circuit.

Figure 8B depicts example ripple rejection response curves for an example pseudo-envelope follower power management system not having an operational amplifier isolation circuit.

Figure 9A depicts an example embodiment of the operational amplifier of the embodiment of an operational amplifier circuitry depicted in Figure 7A.

Figure 9B depicts an example embodiment of the operational amplifier depicted in Figure 27B, where the operational amplifier output isolation circuit is eliminated.

Figure 10A depicts example embodiments of the operational amplifier push-pull output state circuit and the operational amplifier controlled $I_{COR}$ current circuit of an operational amplifier.

Figure 10B depicts an example embodiment of the operational amplifier controlled $I_{COR\_SENSE}$ current circuit of an operational amplifier.

Figure 10C depicts an example embodiment of the Gm bias circuit and operational amplifier isolation circuit of the embodiment of the operational amplifier circuitry.

Figure 10D depicts an example embodiment of the Gm bias circuit of the operational amplifier.

Figure 11 depicts a graphical representation of the programmable transconductance (Gm) output current function of an example embodiment of the operational amplifier controlled $I_{COR}$ current circuit.

Detailed Description

The embodiments set forth below represent the necessary information to enable those skilled in the art to practice the disclosure and illustrate the best mode of practicing the disclosure. Upon reading the following description in light of the accompanying drawings, those skilled in the art will understand the concepts of the disclosure and will recognize applications of these concepts not particularly addressed herein. It should be understood that these concepts and applications fall within the scope of the disclosure and the accompanying claims.

Embodiments disclosed herein relate to a pseudo-envelope follower power management system including a parallel amplifier and a switch mode power supply converter cooperatively coupled to generate a power supply voltage at a power supply output coupled to a linear RF power amplifier. The parallel amplifier output is in communication with the power amplifier supply output. The parallel amplifier governs operation of the switch mode power supply converter and regulates the power amplifier supply voltage base on a $V_{RAMP}$ signal. The parallel amplifier circuit includes an open loop high frequency compensation assist circuit that generates a high frequency ripple compensation current based on an estimate of the high frequency ripple currents contained in a ripple current of the power inductor. The high frequency ripple compensation current is injected into the parallel amplifier circuit output to cancel out high frequency ripple currents at the power amplifier supply output.

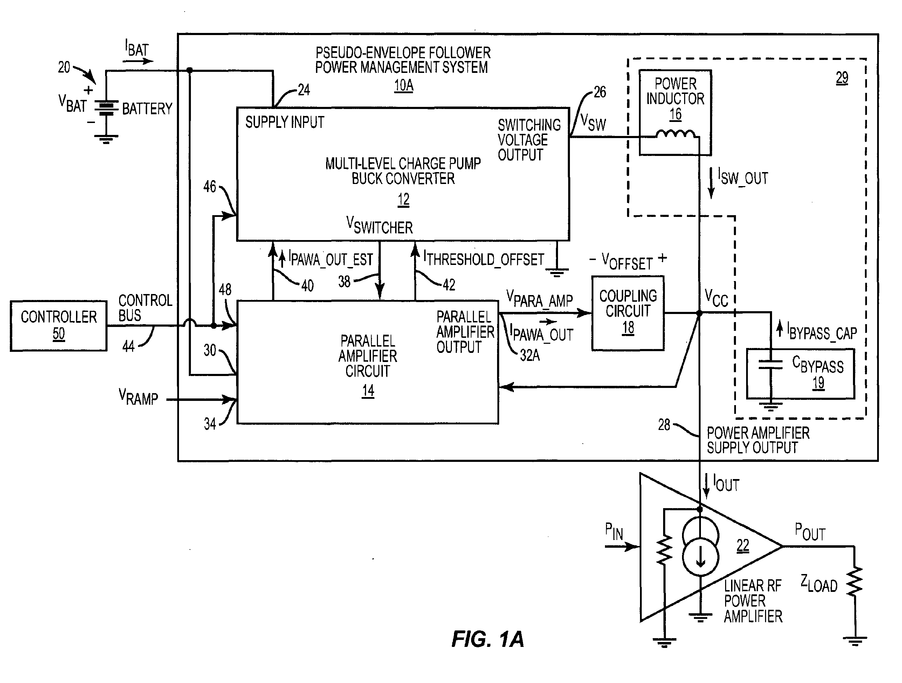

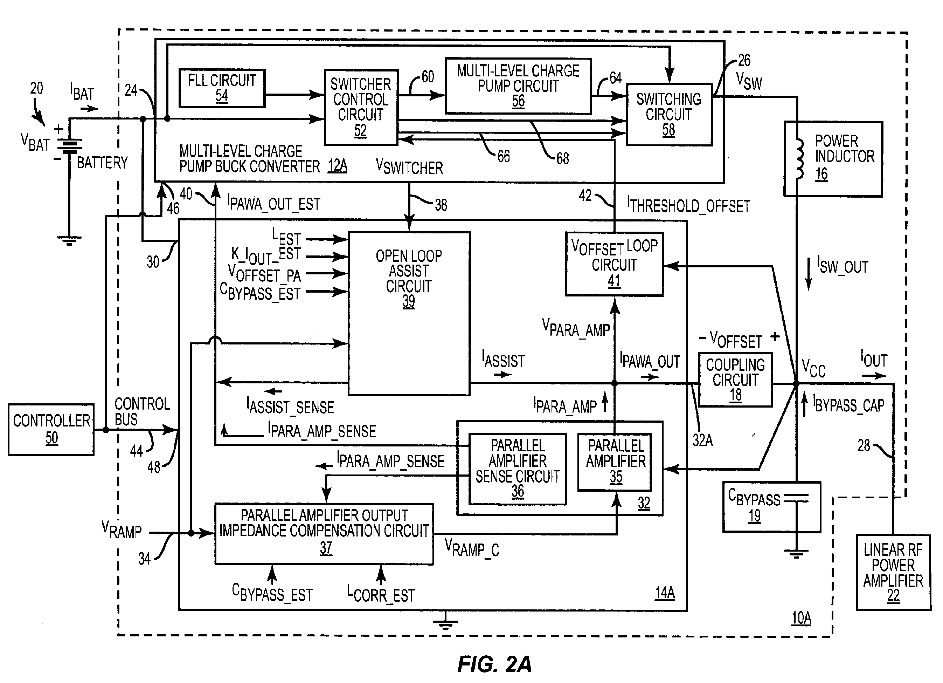

Figures 1A and 2A depict an example embodiment of pseudo-envelope follower power management system 10A including a multi-level charge pump buck converter 12, a parallel amplifier circuit 14, a power inductor 16, a coupling circuit 18, and a bypass capacitor 19. The bypass capacitor 19 has a bypass capacitor capacitance, $C_{BYPASS}$. The multi-level charge pump buck converter 12 and the parallel amplifier circuit 14 may be configured to operate in tandem to generate a power amplifier supply voltage, $V_{CC}$, at a power amplifier supply output 28 of the pseudo-envelope follower power management system 10A for a linear RF power amplifier 22. The power amplifier supply output 28 provides an output current, $I_{OUT}$, to the linear RF power amplifier 22. The linear RF power amplifier 22 may include a power amplifier input, $P_{IN}$, which is configured to receive a modulated RF signal and a power amplifier output, $P_{OUT}$, coupled to an output load, $Z_{LOAD}$. As an example, the output load, $Z_{LOAD}$, may be an antenna.

The multi-level charge pump buck converter 12 may include a supply input 24, which is configured to receive a direct current (DC) voltage, $V_{BAT}$, from a battery 20 and a switching voltage output 26, which is configured to provide a switching voltage, $V_{SW}$. The switching voltage output 26 may be coupled to the power amplifier supply output 28 by the power inductor 16, where the power inductor 16 couples to a bypass capacitor 19 to form an output filter 29 for the switching voltage output 26 of the multi-level charge pump buck converter 12. The power inductor 16 provides an inductor current, $I_{SW\_OUT}$, to the power amplifier supply output 28. The parallel amplifier circuit 14 may include a parallel amplifier supply input 30 configured to receive the DC voltage, $V_{BAT}$, from the battery 20, a parallel amplifier output 32A, a first control input 34, which is configured to receive a $V_{RAMP}$ signal, and a second control input configured to receive the power amplifier supply voltage, $V_{CC}$. The parallel amplifier output 32A of the parallel amplifier circuit 14 may be coupled to the power amplifier supply voltage Vcc, by a coupling circuit 18. A parallel amplifier output voltage, $V_{PARA\_AMP}$, is provided by the parallel amplifier circuit 14.

As an example, the parallel amplifier circuit 14 may generate the parallel amplifier output voltage, $V_{PARA\_AMP}$, based on the difference between the $V_{RAMP}$ signal and the power amplifier supply voltage, $V_{CC}$. Thus, the $V_{RAMP}$ signal may represent either an analog or digital signal that contains the required supply modulation information for a power amplifier collector of a linear RF power amplifier. Typically, the $V_{RAMP}$ signal is provided to the parallel amplifier circuit 14 as a differential analog signal to provide common mode rejection against any noise or spurs that could appear on this signal. The $V_{RAMP}$ signal may be a time domain signal, $V_{RAMP}(t)$, generated by a transceiver or modem and used to transmit radio frequency (RF) signals. For example, the $V_{RAMP}$ signal may be generated by a digital baseband processing portion of the transceiver or modem, where the digital $V_{RAMP}$ signal, $V_{RAMP}\_DIGITAL$, is digital-to-analog converted to form the $V_{RAMP}$ signal in the analog domain. In some embodiments, the "analog" $V_{RAMP}$ signal is a differential signal. The transceiver or a modem may generate the $V_{RAMP}$ signal based upon a known RF modulation Amp(t)*cos(2*pi*$f_{RF}$*t + Phase(t)). The $V_{RAMP}$ signal may represent the target voltage for the power amplifier supply voltage, $V_{CC}$, to be generated at the power amplifier supply output 28 of the pseudo-envelope follower power management system 10A, where the pseudo-envelope follower power management system 10A provides the power amplifier supply voltage, $V_{CC}$, to the linear RF power amplifier 22. Also the $V_{RAMP}$ signal may be generated from a detector coupled to the RF input power amplifier.

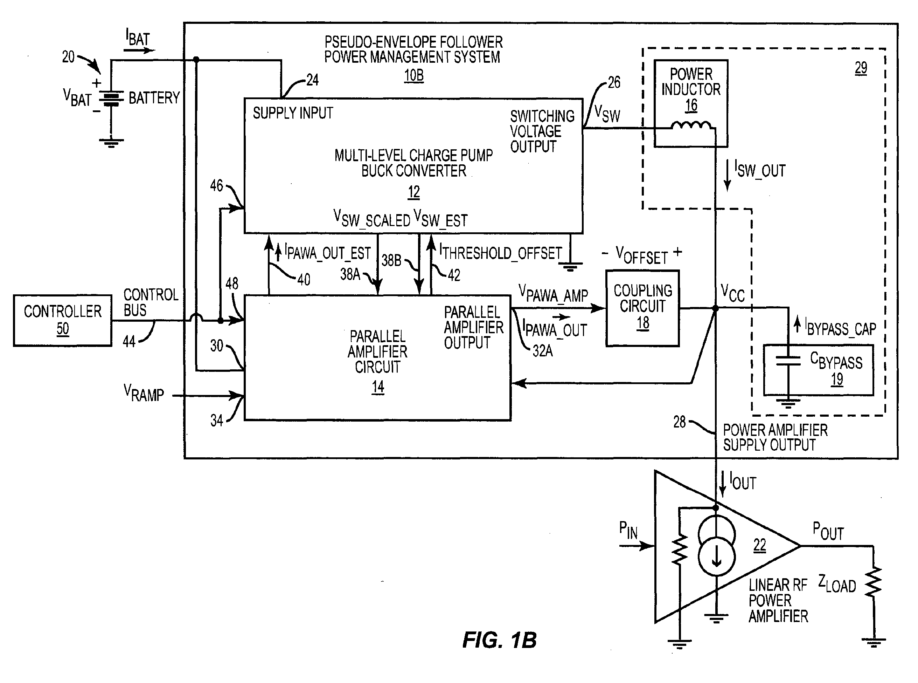

For example, the parallel amplifier circuit 14 includes the parallel amplifier output 32A that provides a parallel amplifier output voltage, $V_{PARA\_AMP}$, to the coupling circuit 18. The parallel amplifier output 32A sources a parallel amplifier circuit output current, $I_{PAWA\_OUT}$, to the coupling circuit 18. The parallel amplifier circuit 14, depicted in Figure 1A and Figure 1B, may provide a parallel amplifier circuit output current estimate 40, $I_{PAWA\_OUT\_EST}$, to the multi-level charge pump buck converter 12 as an estimate of the parallel amplifier circuit output current $I_{PAWA\_OUT}$, of the parallel amplifier circuit 14. Thus, the parallel amplifier circuit output current estimate 40, $I_{PAWA\_OUT\_EST}$, represents an estimate of the parallel amplifier circuit output current $I_{PAWA\_OUT}$, provided by the parallel amplifier circuit 14 as a feedback signal to the multi-level charge pump buck converter 12. Based on the parallel amplifier circuit output current estimate 40, $I_{PAWA\_OUT\_EST}$, the multi-level charge pump buck converter 12 may be configured to control the switching voltage, $V_{SW}$, provided at the switching voltage output 26 of the multi-level charge pump buck converter 12.

In some embodiments of the pseudo-envelope follower power management system 10A, depicted in Figure 1A, and the pseudo-envelope follower power management system 10B, depicted in Figure 1B, the coupling circuit 18 may be an offset capacitor, $C_{OFFSET}$. An offset voltage, $V_{OFFSET}$, may be developed across the coupling circuit 18. In other alternative embodiments, the coupling circuit 18 may be a wire trace such that the offset voltage, $V_{OFFSET}$, between the parallel amplifier output voltage, $V_{PARA\_AMP}$, and the power amplifier supply voltage, $V_{CC}$, is zero volts. In still other embodiments, the coupling circuit 18 may be a transformer.

A pseudo-envelope follower power management system 10A, depicted in Figure 2A, is an example embodiment of the pseudo-envelope follower power management system 10A, depicted in Figure 1A. Unlike the pseudo-envelope follower power management systems 10A, depicted in Figure 1A, the pseudo-envelope follower power management system 10A depicted in Figure 2A includes an embodiment of the multi-level charge pump buck converter 12A and a parallel amplifier circuit 14A having parallel amplifier circuitry 32. The parallel amplifier circuitry 32 includes a parallel amplifier 35 and a parallel amplifier sense circuit 36. The parallel amplifier circuit 14A further includes a parallel amplifier output impedance compensation circuit 37 configured to receive the $V_{RAMP}$ signal and provide a compensated $V_{RAMP}$ signal, $V_{RAMP\_C}$, as an input to the parallel amplifier 35. The parallel amplifier output impedance compensation circuit 37 is configured to receive the $V_{RAMP}$ signal and generate the compensated $V_{RAMP}$ signal, $V_{RAMP\_C}$, as a function of the $V_{RAMP}$ signal. The parallel amplifier 35 generates a parallel amplifier output current, $I_{PARA\_AMP}$, to produce a parallel amplifier output voltage, $V_{PARA\_AMP}$, at the parallel amplifier output 32A based on the difference between the compensated $V_{RAMP}$ signal, $V_{RAMP\_C}$ and the power amplifier supply voltage, $V_{CC}$, generated at power amplifier supply output 28. The parallel amplifier sense circuit 36 generates a scaled parallel amplifier output current estimate, $I_{PARA\_AMP\_SENSE}$, which is a fractional representation of the parallel amplifier output current, $I_{PARA\_AMP}$, generated by the parallel amplifier 35. Alternatively, in those embodiments of the parallel amplifier circuit 14 that do not include the parallel amplifier output impedance compensation circuit 37, the parallel amplifier 35 generates the parallel amplifier output current, $I_{PARA\_AMP}$, to produce the parallel amplifier output voltage, $V_{PARA\_AMP}$, based on the difference between the $V_{RAMP}$ signal and the power amplifier supply voltage, $V_{CC}$.

The parallel amplifier circuit 14A may further include an open loop assist circuit 39 configured to receive a feed forward control signal 38, $V_{SWITCHER}$, the scaled parallel amplifier output current estimate, $I_{PARA\_AMP\_SENSE}$, and the $V_{RAMP}$ signal. In response to the feed forward control signal 38, $V_{SWITCHER}$, the scaled parallel amplifier output current estimate, $I_{PARA\_AMP\_SENSE}$, and the $V_{RAMP}$ signal, the open loop assist circuit 39 may be configured to generate an open loop assist circuit current, $I_{ASSIST}$. The open loop assist circuit current, $I_{ASSIST}$, may be provided to the parallel amplifier output 32A. The parallel amplifier output current, $I_{PARA\_AMP}$, generated by the parallel amplifier 35 and the open loop assist circuit current, $I_{ASSIST}$, generated by the open loop assist circuit 39 may be combined to form the parallel amplifier circuit output current, $I_{PAWA\_OUT}$, of the parallel amplifier circuit 14A. The parallel amplifier circuit 14A may further include a $V_{OFFSET}$ loop circuit 41, configured to generate a threshold offset current 42, $I_{THRESHOLD\_OFFSET}$. The threshold offset current 42, $I_{THRESHOLD\_OFFSET}$, may be provided from the parallel amplifier circuit 14A as a feedback signal to the multi-level charge pump buck converter 12A. The $V_{OFFSET}$ loop circuit 41 may be configured to provide the threshold offset current 42, $I_{THRESHOLD-OFFSET}$, as an estimate of the magnitude of the offset voltage, $V_{OFFSET}$, appearing across the coupling circuit 18. In those cases where the coupling circuit 18 is a wire trace such that the offset voltage, $V_{OFFSET}$, is always zero volts, the parallel amplifier circuit 14A may not provide the threshold offset current 42, $I_{THRESHOLD\_OFFSET}$, to the multi-level charge pump buck converter 12A.

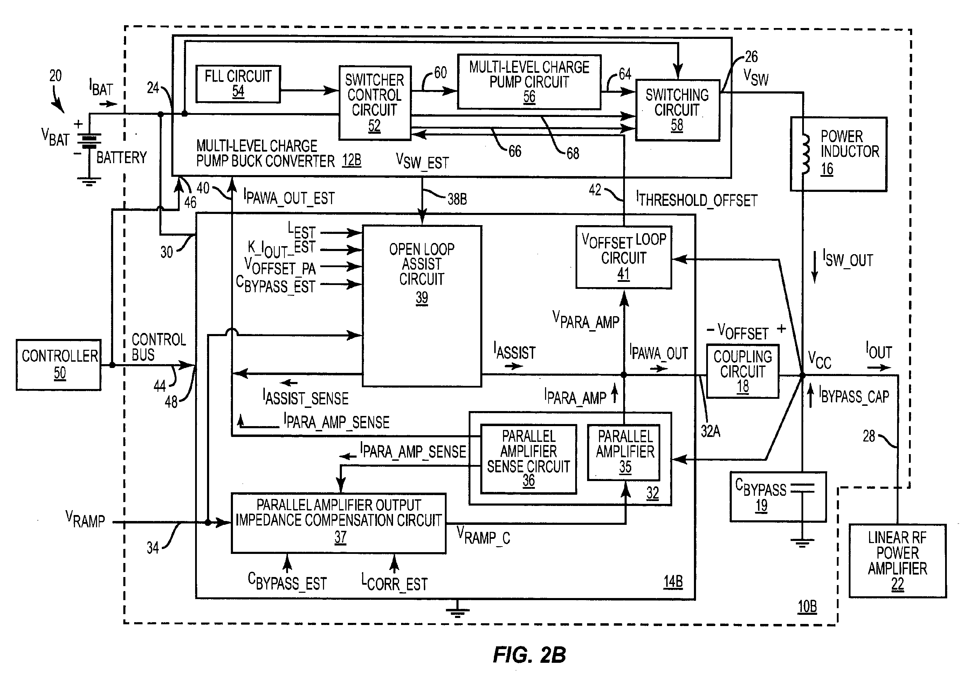

Another example is the pseudo-envelope follower power management system 10B, depicted in Figure 2B, which is similar to the embodiment of the pseudo-envelope follower power management system 10B, depicted in Figure 1B. The pseudo-envelope follower power management system 10B is operationally and functionally similar in form and function to the pseudo-envelope follower power management system 10A, depicted in Figure 2A. However, unlike the pseudo-envelope follower power management system 10A depicted in Figure 2A, the pseudo-envelope follower power management system 10B includes a multi-level charge pump buck converter 12B configured to generate an estimated switching voltage output 38B, $V_{SW\_EST}$, and a parallel amplifier circuit 14B configured to receive the estimated switching voltage output 38B, $V_{SW\_EST}$, instead of the feed forward control signal 38, $V_{SWITCHER}$. Consequentially, as depicted in Figure 2B, the open loop assist circuit 39 of the parallel amplifier circuit 14B is configured to use only the estimated switching voltage output 38B, $V_{SW\_EST}$, instead of the feed forward control signal 38, $V_{SWITCHER}$.

The generation of the parallel amplifier circuit output current estimate 40, $I_{PAWA\_OUT\_EST}$, depicted in Figures 1A and 1B will now be described with continuing reference to the embodiment of the parallel amplifier circuit 14A, depicted in Figure 2A, and the embodiment of the parallel amplifier circuit 14B depicted in Figure 2B. Embodiments of the parallel amplifier circuit 14A and the parallel amplifier circuit 14B, depicted in Figures 2A and 2B, may provide the parallel amplifier circuit output current estimate 40, $I_{PAWA\_OUT\_EST}$, where the parallel amplifier circuit output current estimate 40, $I_{PAWA\_OUT\_EST}$, includes a scaled parallel amplifier output current estimate, $I_{PARA\_AMP\_SENSE}$, and a scaled open loop assist circuit output current estimate, $I_{ASSIST\_SENSE}$. The scaled parallel amplifier output current estimate, $I_{PARA\_AMP\_SENSE}$, is a scaled estimate of the parallel amplifier output current, $I_{PARA\_AMP}$, generated by the parallel amplifier sense circuit 36 of the parallel amplifier circuitry 32. In some alternative embodiments, the parallel amplifier 35 may generate the scaled parallel amplifier output current estimate, $I_{PARA\_AMP\_SENSE}$, directly. The scaled open loop assist circuit output current estimate, $I_{ASSIST\_SENSE}$, is a scaled estimate of the open loop assist circuit current, $I_{ASSIST}$, generated by the open loop assist circuit 39. In other alternative embodiments of the parallel amplifier circuit 14 depicted in Figure 1A and Figure 1B, the parallel amplifier circuit 14 does not include the open loop assist circuit 39. In those embodiments of the parallel amplifier circuit 14 depicted in Figure 1A and Figure 1B that do not include the open loop assist circuit 39, the parallel amplifier circuit output current estimate 40, $I_{PAWA\_OUT\_EST}$, may only be based on the scaled parallel amplifier output current estimate, $I_{PARA\_AMP\_SENSE}$.

Returning to Figures 1A and 1B, the pseudo-envelope follower power management systems 10A and 10B may further include a control bus 44 coupled to a controller 50. The control bus 44 may be coupled to a control bus interface 46 of the multi-level charge pump buck converter 12 and the control bus interface 48 of the parallel amplifier circuit 14. The controller 50 may include various logical blocks, modules, and circuits. The controller 50 may be implemented or performed with a processor, a Digital Signal Processor (DSP), an Application Specific Integrated Circuit (ASIC), a Field Programmable Gate Array (FPGA) or other programmable logic device, discrete gate or transistor logic, discrete hardware components, or any combination thereof designed to perform the functions described herein. A processor may be a microprocessor, but in the alternative, the processor may be any conventional processor, controller, microcontroller, or state machine. A processor may also be implemented as a combination of computing devices. As an example, a combination of computing devices may include a combination of a DSP and a microprocessor, a plurality of microprocessors, one or more microprocessors in conjunction with a DSP core, or any other such configuration. The controller may further include or be embodied in hardware and in computer executable instructions that are stored in memory, and may reside, for example, in Random Access Memory (RAM), flash memory, Read Only Memory (ROM), Electrically Programmable ROM (EPROM), Electrically Erasable Programmable ROM (EEPROM), registers, hard disk, a removable disk, a CD-ROM, or any other form of computer readable medium known in the art. An exemplary storage medium may be coupled to the processor such that a processor can read information from, and write information to, the storage medium. In the alternative, the storage medium or a portion of the storage medium may be integral to the processor. The processor and the storage medium may reside in an ASIC.

Figures 2A and 2B depict a pseudo-envelope follower power management system 10A and a pseudo-envelope follower power management system 10B, respectively, that include embodiments of the multi-level charge pump buck converter 12A and the multi-level charge pump buck converter 12B. As depicted in Figures 2A and 2B, some embodiments of the multi-level charge pump buck converter 12 of Figures 1A and 1B may include an FLL circuit 54 configured to interoperate with a switcher control circuit 52, as depicted in Figures 2A and 2B. Alternatively, some embodiments of the multi-level charge pump buck converter 12A and the multi-level charge pump buck converter 12B may not include an FLL circuit 54 or be configured to operate with the FLL circuit 54 being disabled.

As further depicted in Figures 2A and 2B, some embodiments of the switcher control circuit 52 may be configured to control the operation of the multi-level charge pump circuit 56 and the switching circuit 58 to generate the switching voltage, $V_{SW}$, on the switching voltage output 26 of the multi-level charge pump buck converter 12A or the multi-level charge pump buck converter 12B, respectively. For example, the switcher control circuit 52 may use a charge pump mode control signal 60 to configure the operation of the multi-level charge pump circuit 56 to provide a charge pump output 64 to the switching circuit 58. Alternatively, the switcher control circuit 52 may generate a series switch control signal 66 to configure the switching circuit 58 to provide the switching voltage, $V_{SW}$, substantially equal to the DC voltage, $V_{BAT}$, from the battery 20 via a first switching element coupled between the supply input 24 and the switching voltage output 26. As another example, the switcher control circuit 52 may configure the switching circuit 58 to provide the switching voltage, $V_{SW}$, through a second switching element coupled to ground such that the switching voltage, $V_{SW}$, is substantially equal to ground.

In addition, the parallel amplifier circuit 14A, depicted in Figure 2A, and the parallel amplifier circuit 14B, depicted in Figure 2B, may be configured to provide the parallel amplifier circuit output current estimate 40, $I_{PAWA\_OUT\_EST}$, and the threshold offset current 42, $I_{THRESHOLD\_OFFSET}$, to the switcher control circuit 52 in order to control the operation of the switcher control circuit 52. As discussed in detail below, some embodiments of the switcher control circuit 52 may be configured to receive and use the parallel amplifier circuit output current estimate 40, $I_{PAWA\_OUT\_EST}$, the threshold offset current 42, $I_{THRESHOLD\_OFFSET}$, and/or a combination thereof to control the operation of the switcher control circuit 52.

For example, the switcher control circuit 52 may use the parallel amplifier circuit output current estimate 40, $I_{PAWA\_OUT\_EST}$, the threshold offset current 42, $I_{THRESHOLD\_OFFSET}$, and/or a combination thereof to determine the magnitude of the voltage provided the switching voltage, $V_{SW}$, from the multi-level charge pump circuit 56.

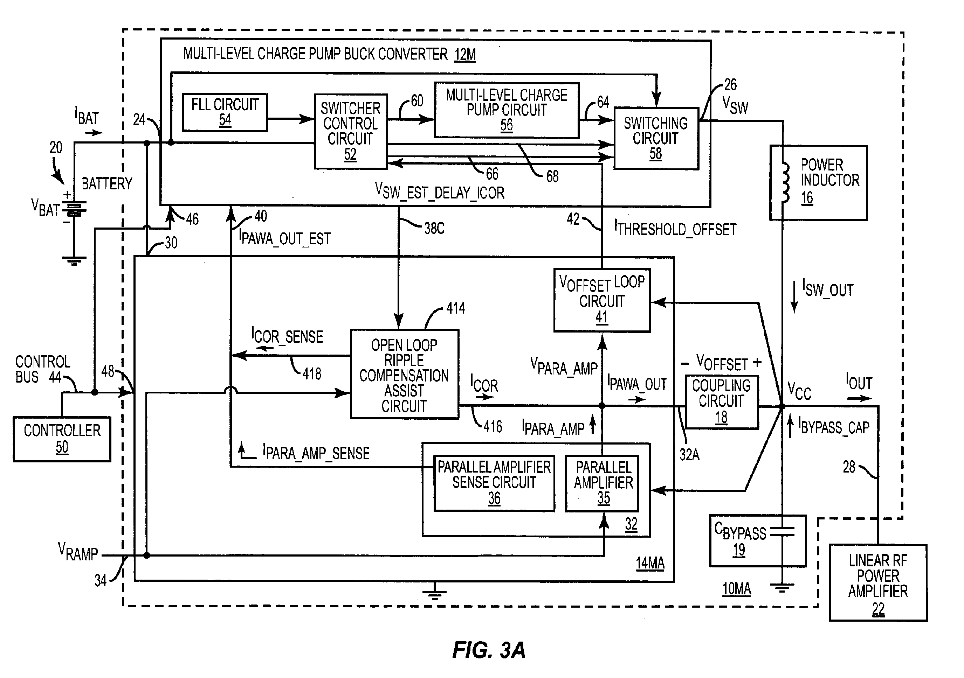

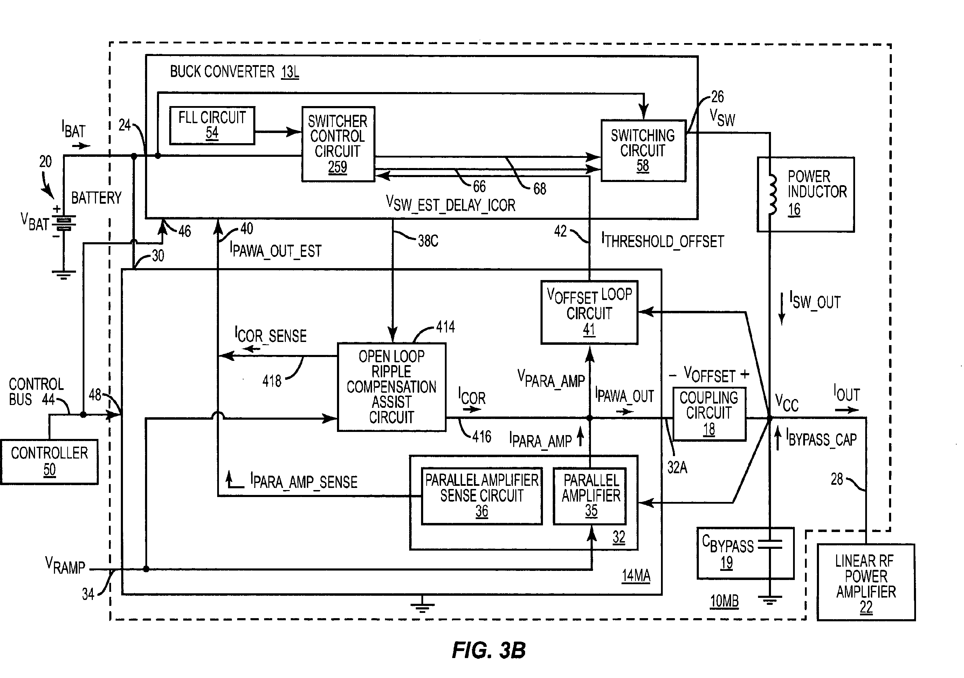

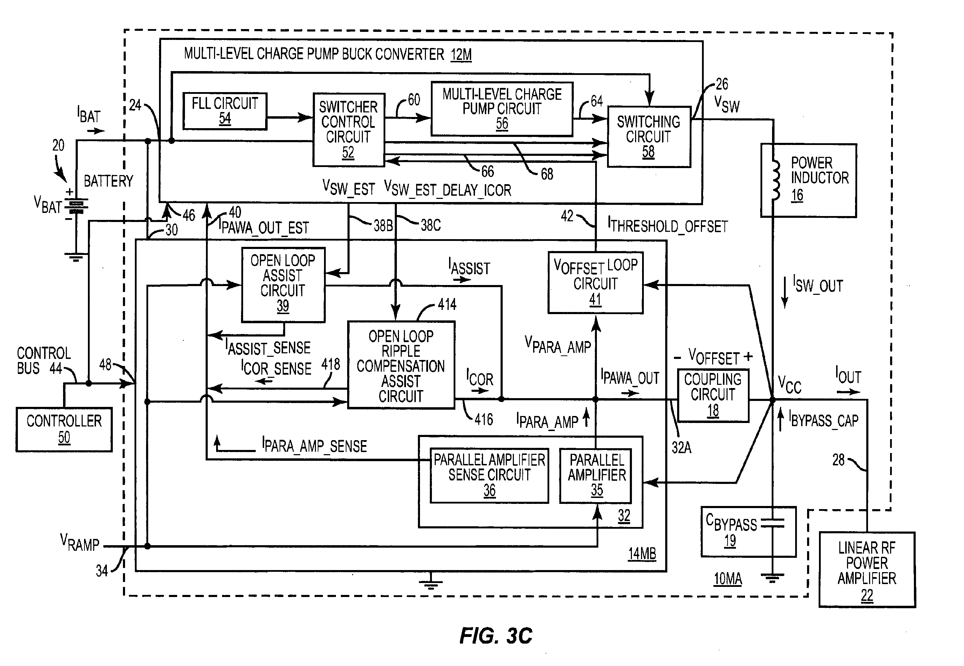

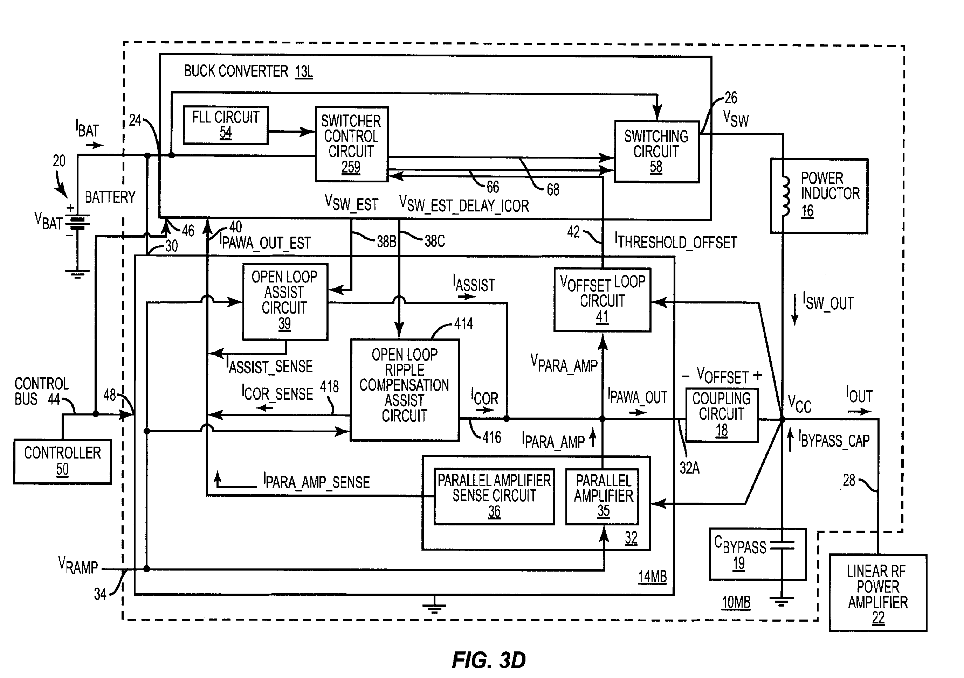

Embodiments of an open loop ripple compensation assist circuit 414, depicted in Figures 3A-3D, will now be described. In order to provide context and not by way of limitation, the open loop ripple compensation assist circuit 414 will be described in the context of the example embodiments of a pseudo-envelope follower power management system 10MA, depicted in Figure 3A and Figure 3C, and a pseudo-envelope follower power management system 10MB, depicted in Figure 3B and Figure 3D.

Figures 3A-D depict the pseudo-envelope follower power management system 10MA and pseudo-envelope follower power management system 10MB, employ a switch mode power supply converter in combination with either an embodiment of the parallel amplifier circuit 14MA or an embodiment of the parallel amplifier circuit 14MB to provide techniques for modulating the power amplifier supply voltage, $V_{CC}$, generated at the power amplifier supply output 28 for use by the linear RF power amplifier 22.

As an example of a switch mode power supply converter, as depicted in Figure 3A, the pseudo-envelope follower power management system 10MA may include an embodiment of a multi-level charge pump buck converter 12M configured to interface with the parallel amplifier circuit 14MA. As another example of a configuration that includes a switch mode power supply converter, as depicted in Figure 3C, an alternative embodiment of the pseudo-envelope follower power management system 10MA may include an embodiment of a multi-level charge pump buck converter 12M configured to interface with the parallel amplifier circuit 14MB. As depicted in both Figure 3A and Figure 3C, the interface between the multi-level charge pump buck converter 12M and either the parallel amplifier circuit 14MA or the parallel amplifier circuit 14MB may be configured to provide a parallel amplifier circuit output current estimate 40, $I_{PAWA\_OUT\_EST}$, a threshold offset current 42, $I_{THRESHOLD\_OFFSET}$, or a combination thereof, to the multi-level charge pump buck converter 12M.

As depicted in Figure 3A and Figure 3C, and not by way of limitation, some embodiments of the multi-level charge pump buck converter 12M may include an FLL circuit 54 similar to the FLL circuit 54 of the multi-level charge pump buck converter 12B, depicted in Figure 2B. For example, some embodiments of the multi-level charge pump buck converter 12M may include a switcher control circuit 52.

As another example of a switch mode power supply converter, as depicted in Figure 3B, an embodiment of the pseudo-envelope follower power management system 10MB may include an embodiment of a buck converter 13L configured to interface with the parallel amplifier circuit 14MA. As another example of a configuration that includes a switch mode power supply converter, as depicted in Figure 3D, an alternative embodiment of the pseudo-envelope follower power management system 10MB may include an embodiment of the buck converter 13L configured to interface with the parallel amplifier circuit 14MB. As depicted in both Figure 3B and Figure 3D, the interface between the buck converter 13L and either the parallel amplifier circuit 14MA or the parallel amplifier circuit 14MB may be configured to provide a parallel amplifier circuit output current estimate 40, $I_{PAWA\_OUT\_EST}$, the threshold offset current 42, $I_{THRESHOLD\_OFFSET}$, or a combination thereof, to the buck converter 13L. Some embodiments of the buck converter 13L may also include the FLL circuit 54, as depicted in Figure 3B and Figure 3D. For example, some embodiments of the buck converter 13L may include a switcher control circuit 259.

Similar to the various example pseudo-envelope follower power management systems described above, the embodiments of the pseudo-envelope follower power management system 10MA and the pseudo-envelope follower power management system 10MB, depicted respectively in Figure 3A, Figure 3C, Figure 3B, and Figure 3D, may be configured to use modulated supply techniques to control the power amplifier supply voltage, $V_{CC}$, generated on the power amplifier supply output 28 in order to meet various communication system standards implemented in various communication devices. Example communication devices may include mobile terminals and mobile phones. Some of the communication system standards may include the use of wide-band modulation to send and receive information and data over a communication network.

As an example, the Long Term Evolution (LTE) communication standard may use wide-bandwidth modulation in specified transmission frequency bands and receive frequency bands to communicate information and data via the linear RF power amplifier 22. In addition, the width of each band allocated for wide-band modulation may vary depending upon the transmission frequency band and the receive frequency band that an example communication device is assigned to use in the communication network. For example, the Long Term Evolution (LTE) standard may specify LTE band numbers, where each of the LTE band number corresponds to a specific transmit channel frequency band and a specific receive channel frequency band. As a non-limiting example, the LTE band number corresponds to a band of operation in which a communication device is assigned to operate in a mobile communication network. Thus, in some cases, the band of operation may include a transmit channel and a receive channel. The transmit channel may have a transmit channel frequency band. The receive channel may have a receive channel frequency band. In addition, each band of operation may be assigned a specified duplex spacing, also referred to as a duplex offset, between the specific transmit channel frequency band and the specific receive channel frequency associated the band of operation. For example, the transmit channel and the receive channel for a band of operation may be spaced apart by a duplex offset. The transmit channel may have a transmit channel frequency band. The receive channel may have a receive channel frequency band. For example, each respective LTE band number may be assigned a specific duplex offset. As used herein, the term transmit to receive duplex offset is defined as a frequency having a magnitude substantially equal to the duplex offset between a transmit channel frequency band and a receive channel frequency band for a band of operation within a frequency spectrum. For example, an example band of operation assigned to a communication device may include a transmit channel and corresponding receive channel. The transmit channel may have a transmit channel frequency band between 1920 MHz and 1980 MHz. The corresponding receive channel may have a receive channel frequency band between 2110 MHz and 2170 MHz. As a result, the width of band for the transmit channel frequency band is 60 MHz and the width of band for the receive channel frequency band is 60 MHz. The duplex offset between the transmit channel and the receive channel is 190 MHz. As a result, the transmit to receive duplex offset is 190 MHz.

However, due to the non-ideal, (non-zero), output impedance of the parallel amplifier 35 and the large ripple currents associated with the power inductor currents, the modulated supply techniques implemented by the different embodiments of the pseudo-envelope follower power management system 10MA and the pseudo-envelope follower power management system 10MB, depicted in Figures 3A-D, may result in generation of ripple voltages in the power amplifier supply voltage, $V_{CC}$, at the power amplifier supply output 28 supplied to the linear RF power amplifier 22. Some of the generated ripple voltages may include high frequency ripple voltages that are located near a frequency substantially equal to the transmit to receive duplex offset of a communication device. The high frequency ripple voltages may be spread out over a frequency band that is near the transmit to receive duplex offset associated for the band of operation of a communication device. For example, the high frequency ripple voltages may be within a frequency band centered about the frequency substantially equal to the transmit to receive duplex offset for the band of operation of the communication device. As a result, the high frequency ripple voltages that are within a band of frequencies substantially equal to at least the bandwidth of the receive channel frequency band, where the band of frequencies is centered at the transmit to receive duplex offset associated with the band of operation of a communication device may be modulated into the RF signal being generated for transmission by the linear RF power amplifier 22.

To compensate for the ripple voltages in the power amplifier supply voltage, $V_{CC}$, the parallel amplifier will attempt to source or sink current to cancel out the ripple voltage on the power amplifier supply voltage, $V_{CC}$. However, the parallel amplifier 35, which is depicted in Figures 3A-D, may exhibit a non-ideal output impedance in the operating frequency range of the linear RF power amplifier 22. In addition, the non-ideal output impedance of the parallel amplifier 35 may also be non-linear. As a result, the parallel amplifier 35 may generate high frequency ripple voltages at the parallel amplifier output 32A. The generated high frequency ripple voltages generated by the parallel amplifier 35 may give rise to the generation of high frequency ripple voltages in the power amplifier supply voltage, $V_{CC}$, supplied to the linear RF power amplifier 22. The frequencies of the high frequency ripple voltages may include frequencies that are near or within a band of frequencies substantially equal to at least the bandwidth of the receive channel frequency band that is centered at the transmit to receive duplex offset associated with the band of operation of a communication device. Thus, the high frequency ripple voltages may be near or in the operational bandwidth of the linear RF power amplifier 22. Figures 3A-3D depict that the open loop ripple compensation assist circuit 414 is in communication with the power amplifier supply output 28 via the coupling circuit 18. As will be described below, embodiments of the open loop ripple compensation assist circuit 414, depicted in Figures 3A-3D, may be configured by the controller 50 to generate or provide a high frequency ripple compensation current 416, $I_{COR}$, at the parallel amplifier output 32A to reduce or cancel out the high frequency ripple currents at the power amplifier supply output 28 to minimize the high frequency ripple voltages generated by the parallel amplifier 35 in response to high frequency ripple currents at the power amplifier supply output 28, where the high frequency ripple currents are at frequencies that are near or within a band of frequencies centered near or at the transmit to receive duplex offset associated with the band of operation of a communication device and having a bandwidth substantially equal to at least the bandwidth of the receive channel frequency band for a mode operation. The high frequency ripple compensation current 416, $I_{COR}$, may be injected into the parallel amplifier output 32A to cancel out high frequency ripple currents at the power amplifier supply output 28 that are induced by the switching action of the switching voltage output 26. A ripple rejection response is a measure of the ability of the pseudo-envelope follower power management system to attenuate ripple voltages at the power amplifier power supply 28 that are due to the switching action at the switching voltage output 26. In other words, the ripple rejection response of the pseudo-envelope follower power management system is a measurement of the peak-to-peak ripple voltage on the power amplifier supply voltage, $V_{CC}$, with respect to the peak-to-peak switching voltage, $V_{SW}$. The high frequency ripple compensation current 416, $I_{COR}$, injected into the parallel amplifier output 32A cancels out high frequency ripple currents such that a ripple rejection response of the pseudo-envelope follower power management system includes a notch located in a frequency band within an operational bandwidth of a linear RF power amplifier. For example, the notch of the ripple rejection response may be located at or near the transmit to receive duplex offset for a band of operation in which the linear radio frequency power amplifier is configured to be used. In addition, as will be described, some embodiments of the open loop ripple compensation assist circuit 414, depicted in Figures 3A-3D, may be configured to generate the high frequency ripple compensation current 416, $I_{COR}$, independent of the non-ideal output impedance of the parallel amplifier 35.

Operationally, the open loop ripple compensation assist circuit 414 effectively develops an estimate of the high frequency current components in the inductor current, $I_{SW\_OUT}$, to be cancelled out. The open loop ripple compensation assist circuit 414 is in communication with the power amplifier supply output 28 via the coupling circuit 18. The high frequency ripple compensation current 416, $I_{COR}$, is injected into the parallel amplifier output 32A to substantially cancel out the high frequency ripple currents in the inductor current, $I_{SW\_OUT}$, that correspond to a $V_{RAMP}$ signal, where the high frequency ripple currents are at frequencies that are near or within a band of frequencies centered near or at the transmit to receive duplex offset associated with the band of operation of a communication device, and where the band of frequencies has a bandwidth substantially equal to at least the bandwidth of the receive channel frequency band for a mode operation of the communication device. As a result, the high frequency ripple compensation current 416, $I_{COR}$, cancel out the high frequency ripple currents that would create noise on the transmit signal generated by the linear RF power amplifier 22. To limit the frequency band of the portion of the inductor current, $I_{SW\_OUT}$, to be cancelled out by the injection of the high frequency ripple compensation current 416, $I_{COR}$, the open loop ripple compensation assist circuit 414 high pass filters an estimate of the inductor current, $I_{SW\_OUT}$, based on the transmit to receive duplex offset and the bandwidth of the receive channel frequency band for the band of operation the communication device is configured to used.

The parallel amplifier output impedance compensation circuit 37 may use a programmable value of a parallel amplifier inductance estimate parameter, $L_{CORR\_EST}$, as the estimated inductance of the parallel amplifier 35 at the frequencies near or within operational bandwidth of the linear RF power amplifier 22. Accordingly, as described above with respect to the operation of the parallel amplifier output impedance compensation circuit 37, the compensated $V_{RAMP}$ signal, $V_{RAMP\_C}$, is used by the parallel amplifier 35 instead of the $V_{RAMP}$ signal in order to reduce the high frequency ripple voltages present in the parallel amplifier output voltage, $V_{PARA\_AMP}$, generated by the parallel amplifier 35 in the parallel amplifier output 32A due to the non-ideal output impedance characteristics of the parallel amplifier. Thus, the effectiveness of the cancellation or reduction of the high frequency ripple voltages generated by the parallel amplifier 35 by the parallel amplifier output impedance compensation circuit 37 may be dependent on the frequency dependent output impedance characteristics of the parallel amplifier 35 measured at the time of calibration of the communication device.

Figure 3A depicts an embodiment of a pseudo-envelope follower power management system 10MA that is similar to the pseudo-envelope follower power management system 10B, depicted in Figure 2B. However, unlike the pseudo-envelope follower power management system 10B, depicted in Figure 2B, the pseudo-envelope follower power management system 10MA, depicted in Figure 3A includes an embodiment of a multi-level charge pump buck converter 12M instead of multi-level charge pump buck converter 12B. Also, unlike the pseudo-envelope follower power management system 10B, depicted in Figure 2B, the pseudo-envelope follower power management system 10MA, depicted in Figure 3A includes an embodiment of a parallel amplifier circuit 14MA.

However, similar to the embodiment of the parallel amplifier circuit 14B, depicted in Figure 2B, the embodiment of the parallel amplifier circuit 14MA, depicted in Figure 3A, includes parallel amplifier circuitry 32 and a $V_{OFFSET}$ loop circuit 41. The embodiment of the parallel amplifier circuitry 32, depicted in Figure 3A, may include an embodiment of the parallel amplifier 35 and an embodiment of the parallel amplifier sense circuit 36, similar to the parallel amplifier 35 and the parallel amplifier sense circuit 36 depicted in Figure 2B. In addition, some embodiments of the parallel amplifier 35, depicted in Figure 3A, may be similar to one of the embodiments of the parallel amplifier 35.

In some embodiments of the parallel amplifier circuit 14MA, a parallel amplifier supply voltage, $V_{SUPPLY\_PARA\_AMP}$, is provided to provide a supply voltage to the parallel amplifier 35, parallel amplifier sense circuit 36, some portions of the parallel amplifier circuitry 32, and/or a combination thereof.

In the embodiments of the pseudo-envelope follower power management system 10MA, the parallel amplifier circuit 14MA may be configured to provide the threshold offset current 42, $I_{THRESHOLD\_OFFSET}$, to the switcher control circuit 52 of the multi-level charge pump buck converter 12M. The multi-level charge pump buck converter 12M may use the threshold offset current 42, $I_{THRESHOLD\_OFFSET}$, to adjust the switching operation of the multi-level charge pump buck converter 12M.

Continuing with the description of Figure 3A, as discussed above, the parallel amplifier circuit 14MA may further include an embodiment of the open loop ripple compensation assist circuit 414. The open loop ripple compensation assist circuit 414 may be configured by the controller 50 via the control bus 44. The open loop ripple compensation assist circuit 414 may include or be associated with programmable filter parameter(s), programmable gain parameter(s), and programmable delay parameter(s). In some embodiments, some of the programmable filter parameter(s), the programmable gain parameter(s), and the programmable delay parameter(s) are determined at calibration. However, in some embodiments of the open loop ripple compensation assist circuit 414, at least some of the programmable filter parameter(s), the programmable gain parameter(s), and the programmable delay parameter(s) may be optimized by the controller 50 based on the operational mode of the pseudo-envelope follower power management system 10MA.

The open loop ripple compensation assist circuit 414 may be configured to inject the high frequency ripple compensation current 416, $I_{COR}$, at or into the parallel amplifier output 32A to provide the high frequency ripple compensation current 416, $I_{COR}$, to the power amplifier supply output 28. As will be discussed in further detail below, the open loop ripple compensation assist circuit 414 generates the high frequency ripple compensation current 416, $I_{COR}$, to minimize the high frequency ripple voltages on the power amplifier supply voltage, $V_{CC}$, supplied to the linear RF power amplifier 22.

In some embodiments, the open loop ripple compensation assist circuit 414 may use the $V_{RAMP}$ signal and an estimate of the switching voltage, $V_{SW}$, provided at the switching voltage output 26 of the multi-level charge pump buck converter 12M, to determine or generate an estimate of the ripple currents present at the power amplifier supply output 28. The open loop ripple compensation assist circuit 414 may be configured to high pass filter the estimate of the ripple currents present at the power amplifier supply output 28 to obtain an estimate of the high frequency ripple currents located near or within a band of frequencies centered near or at the transmit to receive duplex offset associated with the band of operation in which the linear RF power amplifier 22 is being used, where the band of frequencies has a bandwidth substantially equal to at least the bandwidth of the receive channel frequency band for a band of operation at the power amplifier supply output 28. For example, some embodiments of the open loop ripple compensation assist circuit 414 may include programmable filters or filtering circuits, where the filter characteristics of the programmable filters may be adjusted based on the programmable filter parameter(s). For example, the programmable filters may provide a first high pass filter response and a second high pass filter response, where the first high pass filter response is associated with a first corner frequency, $f_{C1}$, and the second high pass filter response is associated with a second corner frequency, $f_{C2}$. The controller 50 may be configured to adjust the programmable filter parameter(s) associated with each of the first high pass filter response and a second high pass filter response. In addition, the magnitude of the high frequency ripple compensation current 416, $I_{COR}$, may be adjusted based on the programmable gain parameter(s).. In some embodiments, the programmable gain parameter(s) may be parameters used to set a programmable transconductance related parameter.

Based on the estimate of the high frequency ripple currents that include frequencies near or within a band of frequencies centered near or at the transmit to receive duplex offset associated with the band of operation in which the linear RF power amplifier 22 is being used, where the band of frequencies has a bandwidth substantially equal to at least the bandwidth of the receive channel frequency band for the band of operation, the open loop ripple compensation assist circuit 414 may generate the high frequency ripple compensation current 416, $I_{COR}$. In addition, as will be discussed, the open loop ripple compensation assist circuit 414 may adjust the magnitude of the high frequency ripple compensation current 416, $I_{COR}$, and time align the generation of the high frequency ripple compensation current 416, $I_{COR}$, such that the high frequency ripple compensation current 416, $I_{COR}$, maximally cancels out the high frequency ripple currents, present at the power amplifier supply output 28, that are near or within operational bandwidth of the linear RF power amplifier 22. In other words, the controller 50 may configure the open loop ripple compensation assist circuit 414 to inject the high frequency ripple compensation current 416, $I_{COR}$, at the parallel amplifier output 32A to create a notch in the ripple rejection response, measured at the power amplifier supply output 28, that is located near a transmit to receive duplex offset for a band of operation in which the linear radio frequency power amplifier is configured to be used. As an example, the controller 50 may adjust the programmable delay parameter(s) to move the location of the notch in the ripple rejection response to be a function of the transmit to receive duplex offset for the band of operation for which the linear RF power amplifier 22 is configured to be used. For example, the controller 50 may be configured to adjust the programmable delay parameter(s) to temporally align the injection of the high frequency ripple compensation current 416, $I_{COR}$, at the parallel amplifier output 32A to create a notch in a ripple rejection response of the power amplifier supply output 28 that is located near a transmit to receive duplex offset for a band of operation in which the linear RF power amplifier 22 is configured to be used.

In addition, in some embodiments, the controller 50 may be configured to adjust the programmable filter parameter(s) to adjust the width, depth, shape, and/or a combination thereof such that the high frequency ripple compensation current 416, $I_{COR}$, maximally cancels out the high frequency ripple currents generated by the parallel amplifier 35 in frequencies near or within the operational bandwidth of the linear RF power amplifier 22.

In addition, the open loop ripple compensation assist circuit 414 may be further configured to generate a scaled high frequency ripple compensation current estimate 418, $I_{COR\_SENSE}$. The scaled high frequency ripple compensation current estimate 418, $I_{COR\_SENSE}$, may be a fractional representation of the high frequency ripple compensation current 416, $I_{COR}$, provided to the output of the parallel amplifier output 32A. For example, the scaled high frequency ripple compensation current estimate 418, $I_{COR\_SENSE}$, may be linearly related to the high frequency ripple compensation current 416, $I_{COR}$, by a sense scaling factor, $C_{SENSE\_SCALING}$. As depicted in Figure 3A, the scaled high frequency ripple compensation current estimate 418, $I_{COR\_SENSE}$, may be combined with the scaled parallel amplifier output current estimate, $I_{PARA\_AMP\_SENSE}$, generated by the parallel amplifier sense circuit 36 to form the parallel amplifier circuit output current estimate 40, $I_{PAWA\_OUT\_EST}$. The parallel amplifier circuit output current estimate 40, $I_{PAWA\_OUT\_EST}$, including the scaled high frequency ripple compensation current estimate 418, $I_{COR\_SENSE}$, and the scaled parallel amplifier output current estimate, $I_{PARA\_AMP\_SENSE}$, may be provided to the multi-level charge pump buck converter 12M. Accordingly, similar to the embodiment of the multi-level charge pump buck converter 12B, depicted in Figure 2B, the multi-level charge pump buck converter 12M may use the parallel amplifier circuit output current estimate 40, $I_{PAWA\_OUT\_EST}$, to adjust the switching operation of the multi-level charge pump buck converter 12M.

For the sake of simplicity of description, and not by way of limitation, Figure 3A depicts the embodiment of the parallel amplifier circuit 14MA, as not including an open loop assist circuit 39, which is included as part of the parallel amplifier circuit 14B depicted in Figure 2B. Also, unlike the multi-level charge pump buck converter 12B depicted in Figure 2B, for the sake of simplicity of description, and not by way of limitation, the embodiment of the multi-level charge pump buck converter 12M depicted in Figure 3A does not depict the multi-level charge pump buck converter 12M providing an estimated switching voltage output 38B, $V_{SW\_EST}$, as an output to the parallel amplifier circuit 14MA.

However, Figure 3C depicts an example embodiment of the pseudo-envelope follower power management system 10MA that includes a multi-level charge pump buck converter 12M and an embodiment of a parallel amplifier circuit 14MB that includes an open loop ripple compensation assist circuit 414 in combination with an open loop assist circuit 39, where the open loop assist circuit 39 may be similar to the embodiment of the open loop assist circuit 39 depicted in Figure 2B. Accordingly, as depicted in Figure 3C, embodiments of the pseudo-envelope follower power management system 10MA that include the parallel amplifier circuit 14MB, may provide a parallel amplifier circuit output current estimate 40, $I_{PAWA\_OUT\_EST}$, to adjust the switching operation of the multi-level charge pump buck converter 12M, where the parallel amplifier circuit output current estimate 40, $I_{PAWA\_OUT\_EST}$, is generated by combining the scaled parallel amplifier output current estimate, $I_{PARA\_AMP\_SENSE}$, the scaled high frequency ripple compensation current estimate 418, $I_{COR\_SENSE}$, and the scaled open loop assist circuit output current estimate, $I_{ASSIST\_SENSE}$.

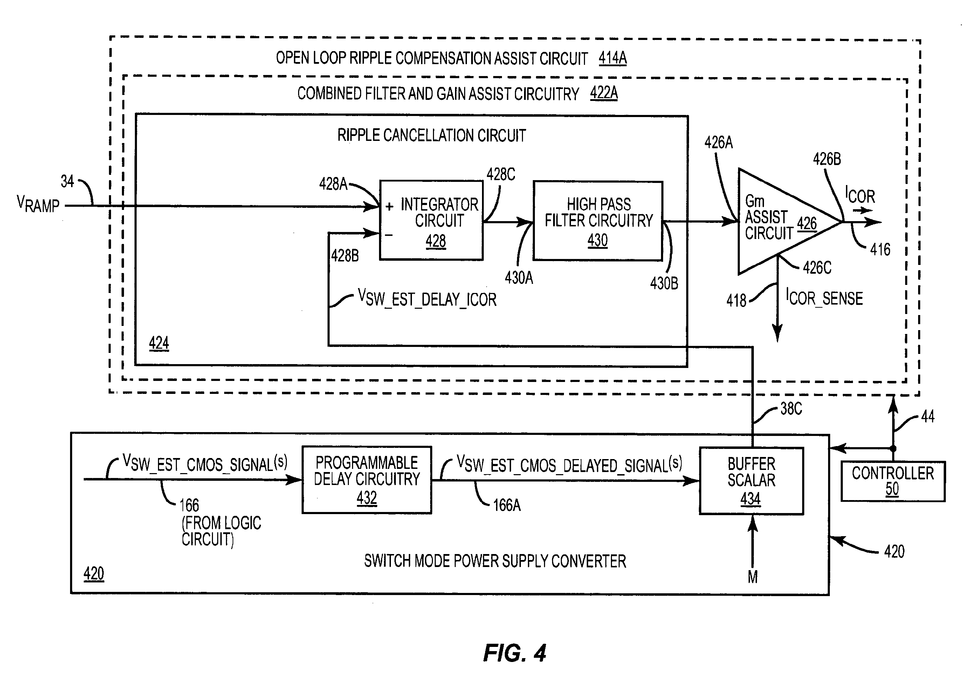

As further depicted in Figure 3A, the multi-level charge pump buck converter 12M is further configured to provide a delayed $I_{COR}$ estimated switching voltage output 38C, $V_{SW\_EST\_DELAY\_ICOR}$, to a programmable delayed switching voltage input (not shown) of the parallel amplifier circuit 14MA. The programmable delayed switching voltage input is in communication with the open loop ripple compensation assist circuit 414 of the parallel amplifier circuit 14MA and configured to receive the delayed $I_{COR}$ estimated switching voltage output 38C, $V_{SW\_EST\_DELAY\_ICOR}$. Similar to the estimated switching voltage output 38B, $V_{SW\_EST}$, generated by the multi-level charge pump buck converter 12B, depicted in Figure 2B, the delayed $I_{COR}$ estimated switching voltage output 38C, $V_{SW\_EST\_DELAY\_ICOR}$, is a feed forward signal generated based on the state of the switcher control circuit 52, where the delayed $I_{COR}$ estimated switching voltage output 38C, $V_{SW\_EST\_DELAY\_ICOR}$, provides an early indication of what the switching voltage , $V_{SW}$, will become based on the state of the switcher control circuit 52. Thus, the delayed $I_{COR}$ estimated switching voltage output 38C, $V_{SW\_EST\_DELAY\_ICOR}$, may be a feed forward signal that indicates a future voltage level of the switching voltage, $V_{SW}$, at the switching voltage output 26 based on the state of the switcher control circuit 52 before the switching voltage output 26 is configured to provide a switching voltage , $V_{SW}$, substantially equal to the future voltage level. In other words, the delayed $I_{COR}$ estimated switching voltage output 38C, $V_{SW\_EST\_DELAY\_ICOR}$, provides a switching output voltage estimate that that may be programmably delayed by programmable delay circuitry 432 (Figure 4). In this way, the delayed $I_{COR}$ estimated switching voltage output 38C, $V_{SW\_EST\_DELAY\_ICOR}$, may be considered a version of the estimated switching voltage output 38B, $V_{SW\_EST}$, that may be programmably delayed by the programmable delay circuitry 432 to time align generation of the high frequency ripple compensation current 416, $I_{COR}$. For example, the programmable delay circuitry 432 may be configured to have a programmable delay period such that the delayed $I_{COR}$ estimated switching voltage output 38C, $V_{SW\_EST\_DELAY\_ICOR}$, is delayed in time by substantially the programmable delay period relative to the estimated switching voltage output 38B, $V_{SW\_EST}$. The controller 50 may programmatically configure programmable delay circuitry in the multi-level charge pump buck converter 12M to provide a programmable delay period between generation of the delayed $I_{COR}$ estimated switching voltage output 38C, $V_{SW\_EST\_DELAY\_ICOR}$, relative to generation of the estimated switching voltage output 38B, $V_{SW\_EST}$. The controller 50 may adjust the programmable delay period to align the generation of the high frequency ripple compensation current 416, $I_{COR}$, to cancel out the high frequency ripple currents generated by the parallel amplifier 35 in response to the $V_{RAMP}$ signal. Illustratively, the controller 50 may be configured to adjust the programmable delay period to temporally align the injection of the high frequency ripple compensation current 416, $I_{COR}$, at parallel amplifier output 32A, to create a notch in a ripple rejection response of the power amplifier supply output 28 that is located near a transmit to receive duplex offset for a band of operation in which the linear RF power amplifier 22 is configured to be used.

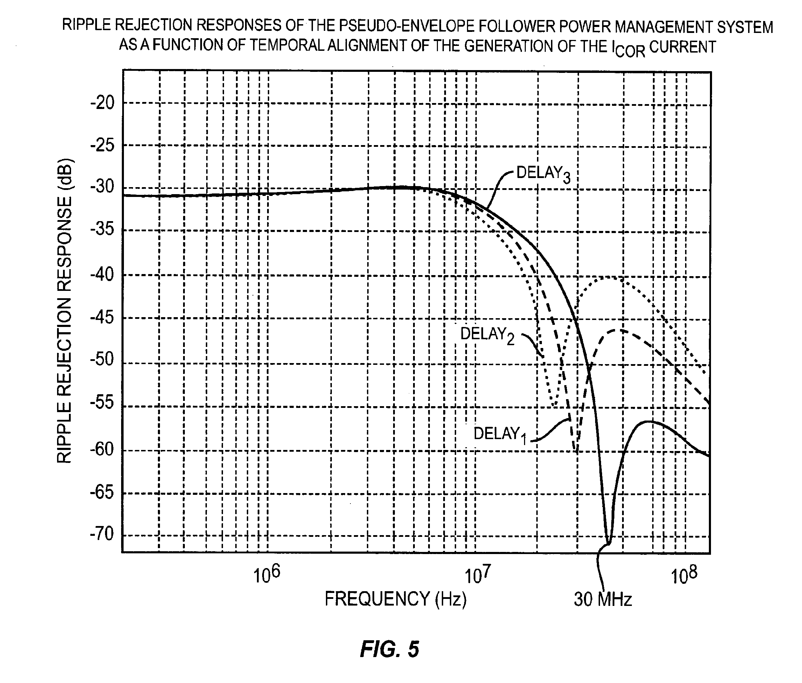

As will be discussed below, the controller 50 may be further configured to programmatically change the values of the programmable filter parameter(s), programmable gain parameter(s), and programmable delay parameter(s) to obtain an optimized overall system response of the pseudo-envelope follower power management system 10MA to place a notch in the ripple rejection response at the power amplifier supply output 28 as a function of the duplex offset for each band of operation. Thus, depending on the band of operation in which the linear RF power amplifier 22 is configured to be used, the controller 50 may configure the notch in the ripple rejection response to be located near or at the transmit to receive duplex offset associated with the selected band of operation. In addition, the bandwidth of the receive channel frequency band for the band of operation is used to configure the ripple rejection response to substantially cancel output of the high frequency ripple currents that could be modulated onto the transmit signal generated by the linear RF power amplifier 22. For example, Figure 5 depicts the notch response of example pseudo-envelope follower power management systems 10MA and 10MB, as depicted in Figures 3A-D, as a function of the programmable delay period.

As previously discussed, Figure 3B depicts an embodiment of a pseudo-envelope follower power management system 10MB that includes a buck converter 13L and an embodiment of the parallel amplifier circuit 14MA. As discussed above, the buck converter 13L interfaces with the parallel amplifier circuit 14MA. The operation of the parallel amplifier circuit 14MA in conjunction with the buck converter 13L is substantially similar to the operation of the embodiments of the parallel amplifier circuit 14MA with the multi-level charge pump buck converter 12M. Likewise, the pseudo-envelope follower power management system 10MB may include the features and functions of the various embodiments and alternative embodiments of the pseudo-envelope follower power management system 10MA, as described above, except, the buck converter 13L may not generate an internal charge pump node parallel amplifier supply 294 because the buck converter 13L does not include an embodiment of the multi-level charge pump circuit 56 that is included in the multi-level charge pump buck converter 12M of the pseudo-envelope follower power management system 10MA, depicted in Figure 3A. Even so, although not depicted in Figure 3B, some alternative embodiments of the pseudo-envelope follower power management system 10MB may include an embodiment of a μC charge pump circuit 262 and associated circuitry in order to provide a parallel amplifier supply voltage, $V_{SUPPLY\_PARA\_AMP}$, to an embodiment of the parallel amplifier 35.

Figure 3C depicts an alternative embodiment of the pseudo-envelope follower power management system 10MA that is similar in form and function to the embodiments of the pseudo-envelope follower power management system 10MA discussed with reference to Figure 3A. However, unlike the alternative embodiment of the pseudo-envelope follower power management system 10MA depicted in Figure 3A, the pseudo-envelope follower power management system 10MA depicted in Figure 3C includes the parallel amplifier circuit 14MB instead of the parallel amplifier circuit 14MA. As previously discussed, the parallel amplifier circuit 14MB is similar in form and function to the parallel amplifier circuit 14MA, described previously, except that the parallel amplifier circuit 14MB includes an embodiment of the open loop assist circuit 39. Accordingly, the alternative embodiment of the pseudo-envelope follower power management system 10MA depicted in Figure 3C is functionally similar to the embodiment of the pseudo-envelope follower power management system 10MA depicted in Figure 3A, except the parallel amplifier circuit output current estimate 40, $I_{PAWA\_OUT\_EST}$, further includes the scaled open loop assist circuit output current estimate, $I_{ASSIST\_SENSE}$, and the open loop assist circuit 39 provides the open loop assist circuit current, $I_{ASSIST}$, at the parallel amplifier output 32A.

Figure 3D depicts an alternative embodiment of the pseudo-envelope follower power management system 10MB that is substantially similar in form and function to the embodiment of the pseudo-envelope follower power management system 10MB depicted in Figure 3B except the alternative embodiment of the pseudo-envelope follower power management system 10MB depicted in Figure 3D includes the parallel amplifier circuit 14MB instead of the parallel amplifier circuit 14MA. Accordingly, the alternative embodiment of the pseudo-envelope follower power management system 10MB depicted in Figure 3D is functionally similar to the pseudo-envelope follower power management system 10MB, depicted in Figure 3B, except the parallel amplifier circuit output current estimate 40, $I_{PAWA\_OUT\_EST}$, further includes the scaled open loop assist circuit output current estimate, $I_{ASSIST\_SENSE}$, and the open loop assist circuit 39 provides the open loop assist circuit current, $I_{ASSIST}$, at the parallel amplifier output 32A.

Figure 4 depicts an embodiment of the open loop ripple compensation assist circuit 414A and a portion of a switch mode power supply converter 420. The switch mode power supply converter 420 may be similar in form and function to the embodiment of the multi-level charge pump buck converter 12M, depicted in Figure 3A and Figure 3C, or the buck converter 13L, depicted in Figure 3B and Figure 3D. The switcher control circuit (not shown) of the switch mode power supply converter 420 may be configured as one of the embodiments of the switcher control circuit 52 when the switch mode power supply converter 420 is configured as one of the embodiments of a multi-level charge pump buck converter as described herein. Alternatively, the switcher control circuit (not shown) of the switch mode power supply converter 420 may be configured as one of the embodiments of the switcher control circuit 52 when the switch mode power supply converter 420 is configured as one of the embodiments of a buck converter as described herein. Accordingly, similar to the previously described embodiments of the multi-level charge pump buck converter 12M and the buck converter 13L, the switch mode power supply converter 420 may be configured to provide a delayed $I_{COR}$ estimated switching voltage output 38C, $V_{SW\_EST\_DELAY\_ICOR}$, to the open loop ripple compensation assist circuit 414A. Although not depicted in Figure 4, it will be understood that controller 50, depicted in Figures 3A-D, may be configured to control or configure the elements of the open loop ripple compensation assist circuit 414A.

The open loop ripple compensation assist circuit 414A may include an embodiment of a combined filter and gain assist circuitry 422A. The combined filter and gain assist circuitry 422A may include a ripple cancellation circuit 424 and a Gm assist circuit 426. The Gm assist circuit 426 may include an input port 426A, a Gm assist $I_{COR}$ output 426B, and a Gm assist $I_{COR\_SENSE}$ output 426C. The controller 50 may be configured to adjust the transconductance of the Gm assist circuit 426.

The combined filter and gain assist circuitry 422A may include an integrator circuit 428 and high pass filter circuitry 430. The high pass filter circuitry 430 may include a high pass filter circuitry input 430A and a high pass filter circuitry output 430B. The controller 50 may configure the high pass filter circuitry 430 to provide a desired high pass frequency response by adjusting the time constants associated with the high pass filter circuitry 430. The integrator circuit 428 may include a non-inverting input 428A configured to receive the $V_{RAMP}$ signal and an inverting input 428B configured to receive the delayed $I_{COR}$ estimated switching voltage output 38C, $V_{SW\_EST\_DELAY\_ICOR}$. Although not depicted in Figure 4, in some embodiments of the open loop ripple compensation assist circuit 414A, the $V_{RAMP}$ signal may be scaled by a scaling factor, $K_{VRAMP\_SCALE}$, such that the non-inverting input 428A of the integrator circuit 428 receives a scaled $V_{RAMP}$ signal, $V_{RAMP\_SCALED}$, where $V_{RAMP\_SCALED} = K \times V_{RAMP}$. The integrator output 428C is coupled to the high pass filter circuitry input 430A of the high pass filter circuitry 430. The high pass filter circuitry output 430B of the high pass filter circuitry 430 is coupled to the input port 426A of the Gm assist circuit 426. Based on the integrated and high pass filtered signal generated by the ripple cancellation circuit 424, the Gm assist circuit 426 generates the high frequency ripple compensation current 416, $I_{COR}$, at the Gm assist $I_{COR}$ output 426B and the scaled high frequency ripple compensation current estimate 418, $I_{COR\_SENSE}$, at the Gm assist $I_{COR\_SENSE}$ output 426C.

In order to place a notch in the ripple rejection response of the power amplifier supply output 28 as a function of the transmit to receive duplex offset for each band of operation, the open loop ripple compensation assist circuit 414A may be configured to generate a predicted estimated inductor current, $I_{SW\_OUT\_EST}$, for the inductor current, $I_{SW\_OUT}$, that is provided by the power inductor 16, as depicted in Figure 3A, based on a difference between the $V_{RAMP}$ signal and the delayed $I_{COR}$ estimated switching voltage output 38C, $V_{SW\_EST\_DELAY\_ICOR}$, and the inductance value of the power inductor 16, depicted in Figures 3A-D. The predicted estimated inductor current, $I_{SW-\_OUT\_EST}$, is an estimate of the inductor current, $I_{SW\_OUT}$, in the power inductor 16 corresponding temporally to when the switching voltage, $V_{SW}$, to be generated at the switching voltage output 26 which is represented by the value of the delayed $I_{COR}$ estimated switching voltage output 38C, $V_{SW\_EST\_DELAY\_ICOR}$, and the $V_{RAMP}$ signal reflects the voltage level of the power amplifier supply voltage, $V_{CC}$. However, in order to simplify circuitry, and because the high frequency ripple compensation current 416, $I_{COR}$, is injected at or into the parallel amplifier output 32A to cancel out the high frequency ripple components of the inductor current, $I_{SW\_OUT}$, near or within a band of frequencies substantially equal to at least the bandwidth of the receive channel frequency band that is centered at the transmit to receive duplex offset associated with the band of operation in which the of the linear RF power amplifier 22 is being used, the ripple cancellation circuit generates the negative of the predicted estimated inductor current, $I_{SW\_OUT\_EST}$. As an example, the integrator circuit 428 may be configured to integrate the difference between the $V_{RAMP}$ signal and the delayed $I_{COR}$ estimated switching voltage output 38C, $U_{SW\_EST\_DELAY\_ICOR}$, to generate the negative of the predicted estimated inductor current, $I_{SW\_OUT\_EST}$. The negative of the predicted estimated inductor current, $I_{SW\_OUT\_EST}$, may be represented by the Laplace transfer function of the integrator circuit 428, shown in equation (1) as follows:

$$(1) \qquad -I_{SW\_OUT\_EST}(s) = \frac{(V_{RAMP} - V_{SW\_OUT\_EST})}{L_{POWER\_INDUCTOR}s} \ ,$$

where $L_{POWER\_INDUCTOR}$ represents the inductance of the power inductor 16 depicted in Figures 3A-D.

Thus, referring to Figures 3A-D, the predicted estimated inductor current, $I_{SW-\_OUT\_EST}$, provides an estimate of the current through the power inductor 16 corresponding to the time when the delayed $I_{COR}$ estimated switching voltage output 38C, $V_{SW\_EST\_DELAY\_ICOR}$, reflects the voltage level of the switching voltage, $V_{SW}$, provided at the switching voltage output 26 and the $V_{RAMP}$ signal reflects the voltage level of the power amplifier supply voltage, $V_{CC}$. The negative of the predicted estimated inductor current, $I_{SW\_OUT\_EST}$, is provided to the high pass filter circuitry 430, which high pass filters the negative of the predicted estimated inductor current, $I_{SW\_OUT\_EST}$, to generate an estimate of the predicted high frequency ripple currents, $I_{HIGH\_FREQUENCY\_RIPPLE}$, to be cancelled out, at the power amplifier supply output 28 when the switching voltage, $V_{SW}$, to be generated at the switching voltage output 26 is represented by the value of the delayed $I_{COR}$ estimated switching voltage output 38C, $V_{SW\_EST\_DELAY\_ICOR}$, and the $V_{RAMP}$ signal represents the power amplifier supply voltage, $V_{CC}$. The pass band characteristics of the high pass filter circuitry 430 may be adjusted by the controller 50 based on the programmable filter parameter(s) such that the frequency content of the predicted high frequency ripple currents $I_{HIGH\_FREQUENCY\_RIPPLE}$, to be cancelled out, at the power amplifier supply output 28, includes frequencies that are near or within a band of frequencies substantially equal to at least the bandwidth of the receive channel frequency band that is centered at the transmit to receive duplex offset associated with the band of operation for which the linear RF power amplifier 22 is being used.

As an example, the high pass filter circuitry 430 may provide a first high pass filter response and a second high pass filter response, where the first high pass filter response corresponds to a first corner frequency, $f_{C1}$, and the second high pass filter response corresponds to a second corner frequency, $f_{C2}$. In some embodiments, the first corner frequency, $f_{C1}$, and the second corner frequency, $f_{C2}$, may be configured by the controller 50. The first corner frequency, $f_{C1}$, and the second corner frequency, $f_{C2}$, may be adjusted based on the bandwidth of the receive channel frequency band associated with each band of operation of the linear RF power amplifier 22.

The high pass filter circuitry 430 provides the predicted high frequency ripple currents , $I_{HIGH\_FREQUENCY\_RIPPLE}$, to be cancelled out, to the Gm assist circuit 426. The Gm assist circuit 426 gain scales the predicted high frequency ripple currents , $I\text{-}H_{IGH\_FREQUENCY\_RIPPLE}$, to be cancelled out, to generate the high frequency ripple compensation current 416, $I_{COR}$, based on the predicted high frequency ripple currents, $I_{HIGH\_FREQUENCY\_RIPPLE}$, to be cancelled out, and the programmable gain parameter(s) provided by the controller 50. In addition, the Gm assist circuit 426 also generates the scaled high frequency ripple compensation current estimate 418, $I_{COR\_SENSE}$, which is a fractional representation of the high frequency ripple compensation current 416, $I_{COR}$, used to generate the parallel amplifier circuit output current estimate 40, $I_{PAWA\_OUT\_EST}$. Because the predicted estimated inductor current, $I_{SW\_OUT\_EST}$, is high pass filtered, the predicted high frequency ripple currents, $I_{HIGH\_FREQUENCY\_RIPPLE}$, to be cancelled out, do not reflect the low-frequency modulation of the power amplifier supply output 28. As a result, the high frequency ripple compensation current 416, $I_{COR}$, does not conflict with the efforts of the parallel amplifier 35 to compensate for the low-frequency modulation of the power amplifier supply voltage, $V_{CC}$, due to the change in the switching voltage, $V_{SW}$, at the switching voltage output 26, depicted in Figures 3A-D.

As further depicted in Figure 4, the switch mode power supply converter 420 includes programmable delay circuitry 432 and a buffer scalar 434. For the sake of simplicity, and not by way of limitation, the generation of the delayed $I_{COR}$ estimated switching voltage output 38C, $V_{SW\_EST\_DELAY\_ICOR}$, by the switch mode power supply converter 420 will now be discussed. A threshold detector and control circuit 132A may generate one or more switching voltage output cmos signal(s) 166, $V_{SW\_EST\_CMOS\_SIGNAL}$(S). The one or more switching voltage output cmos signal(s) 166, $V_{SW\_EST\_CMOS\_SIGNAL}$(S), indicate the state of the switch control circuit (not shown) of the switch mode power supply converter 420 before the switch mode power supply converter 420 transitions to provide the switching voltage, $V_{SW}$, represented by the switching voltage output cmos signal(s) 166, $V_{SW\_EST\_CMOS\_SIGNAL}$(S). For example, in the case where the switch mode power supply converter 420 is similar to the embodiment of the multi-level charge pump buck converter 12B, depicted in Figure 2B, the one or more switching voltage output cmos signal(s) 166, $V_{SW\_EST\_CMOS\_SIGNAL}$(S), may be used by the third output buffer 161 to generate one of the various embodiments of the estimated switching voltage output 38B, $V_{SW\_EST}$. In the simplest form, the one or more switching voltage output cmos signal(s) 166, $V_{SW\_EST\_CMOS\_SIGNAL}$(S), may be a single digital signal that represents the future state of the switching voltage output 26 as being in either the shunt level or providing a voltage greater than ground to the power inductor 16, as depicted in Figure 2B. Similarly, in the case where the switch mode power supply converter 420 is similar to the buck converter 13L depicted in Figure 3B, the one or more switching voltage output cmos signal(s) 166, $V_{SW\_EST\_CMOS\_SIGNAL}$(S), may be a single digital signal that represents the future state of the switching voltage output 26 as being in either the shunt level or the series level.

Returning to Figure 4, the programmable delay circuitry 432 is configured to receive the one or more switching voltage output cmos signal(s) 166, $V_{SW\_EST\_CMOS\_SIGNAL}$(S). The controller 50 may use the programmable delay parameter(s) to delay the propagation of the one or more switching voltage output cmos signal(s) 166, $V_{SW\_EST\_CMOS-SIGNAL}$(S), through the programmable delay circuitry 432 by a programmable delay period to generate the one or more programmably delayed switching voltage output cmos signal(s) 166A, $V_{SW\_EST\_CMOS\_DELAYED\_SIGNAL}$(S). The one or more programmably delayed switching voltage output cmos signal(s) 166A, $v_{SW\_EST\_CMOS\_DELAYED\_SIGNAL}$(S) are provided to the buffer scalar 434. The controller 50 may provide a scaling factor, M, based on a scaling factor parameter stored in association with the controller 50, the parallel amplifier circuit, or the switch mode power supply converter 420. Accordingly, based on the scaling factor parameter, the controller 50 may set the value of the scaling factor, M, received by the buffer scalar 434. The buffer scalar 434 generates the delayed $I_{COR}$ estimated switching voltage output 38C, $V_{SW\_EST\_DELAY\_ICOR}$, based on the one or more programmably delayed switching voltage output cmos signal(s) 166A, $V_{SW\_EST\_CMOS\_DELAYED\_SIGNAL}$(S), and the scaling factor, M, provided by the controller 50. The controller 50 may adjust the value of the scaling factor, M, to account for variations in the magnitude of the $V_{RAMP}$ signal and to ensure proper performance of the ripple cancellation circuit 424. In other embodiments, the controller 50 may adjust the scaling factor, M, to compensate for changes in the direct current (DC) voltage, $V_{BAT}$, from the battery 20.

To time align the generation of the high frequency ripple compensation current 416, $I_{COR}$, the controller 50 programmatically adjusts the delay provided by the programmable delay circuitry 432 based on the programmable delay parameter(s). The controller 50 may configure the delay time through the programmable delay circuitry 432 to move the placement of the notch in the ripple rejection response of the pseudo-envelope follower power management system 10MA. As an example, the controller 50 may adjust the delay to place the notch in the ripple rejection response of the pseudo-envelope follower power management system 10MA as function of the transmit to receive duplex offset for each band of operation in which the linear RF power amplifier 22 is configured to be used. Accordingly, as discussed above, the controller 50 may be configured to programmatically change the values of the programmable filter parameter(s), programmable gain parameter(s), and programmable delay parameter(s) to obtain an optimized notch depth, a notch width, and a notch frequency of the notch in the ripple rejection response of the embodiments of the pseudo-envelope follower power management system 10MA, depicted in Figure 3A and Figure 3C, and the pseudo-envelope follower power management system 10MB, depicted in Figure 3B and Figure 3D, as a function of the transmit to receive duplex offset for each band of operation for which the linear RF power amplifier 22 is configured to be used.

Figure 5 depicts three example ripple rejection responses of an embodiment of the pseudo-envelope follower power management system similar to the pseudo-envelope follower power management system 10MA and the pseudo-envelope follower power management system 10MB, depicted in Figures 3A-D, where the desired maximum ripple rejection response is near 30 MHz.

The first ripple rejection response depicted in Figure 5 may be obtained by the controller 50 configuring the programmable delay circuitry 432 to provide a first programmable delay period substantially equal to $DELAY_1$ in order to temporally align the delayed $I_{COR}$ estimated switching voltage output 38C, $V_{SW\_EST\_DELAY\_ICOR}$, to provide a maximum ripple rejection response near 30 MHz. The second ripple rejection response depicted in Figure 5 may be obtained by the controller 50 configuring the programmable delay circuitry 432 to provide a second programmable delay period substantially equal to $DELAY_2$, where $DELAY_2 > DELAY_1$. This results in the second ripple rejection response having a maximum ripple rejection response at a frequency less than the desired 30 MHz and the depth of the notch in the ripple rejection response is reduced. The third ripple rejection response depicted in Figure 5 may be obtained by the controller 50 configuring the programmable delay circuitry 432 to provide a third programmable delay period substantially equal to $DELAY_3$, where $DELAY_1 > DELAY_3$. This results in the third ripple rejection response having a maximum ripple rejection response at a frequency greater than the desired 30MHz and locates the notch in the ripple rejection response at a frequency that is higher than the desired 30 MHZ. As depicted in Figure 5, the controller 50 may configure the programmable delay provided by the programmable delay circuitry 432 to locate the notch in the ripple rejection response of the pseudo-envelope follower power management systems 10MA and 10MB at or near the receive duplex offset for each band of operation for which the linear RF power amplifier 22 is configured to be used.

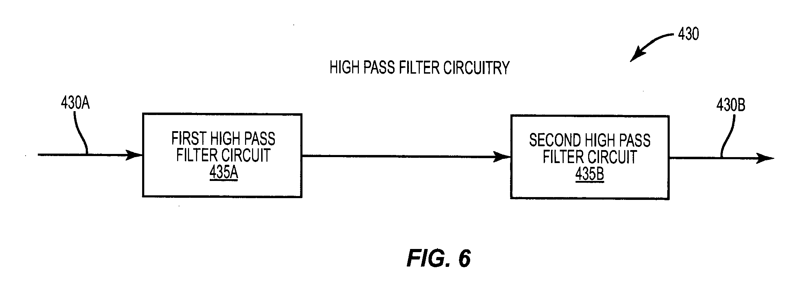

Figure 6 depicts an embodiment of the high pass filter circuitry 430 that may include a first high pass filter circuit 435A and a second high pass filter circuit 435B. The first high pass filter circuit 435A may have a first corner frequency, $f_{C1}$, which is determined by the first high pass filter time constant, $\tau_{C1}$. The second high pass filter circuit 435B may have a second corner frequency, $f_{C2}$, which is determined by the second high pass filter time constant, $\tau_{C2}$. Accordingly, the combined transfer function of the first high pass filter circuit 435A and the second high pass filter circuit 435B may provide a first high pass filter response and a second high pass filter response, where the first high pass filter response corresponds to a first corner frequency, $\tau_{C1}$, and the second high pass filter response corresponds to a second corner frequency, $f_{C2}$. The combined transfer function of the first high pass filter circuit 435A and the second high pass filter circuit 435B, $H_{HP}(s)$, may be represented by the Laplace transfer function shown in equation (2) as follows:

$$(2) \qquad H_{HP}(s) = \left[\frac{\tau_{C1}s}{1+\tau_{C1}s}\right]\left[\frac{\tau_{C2}s}{1+\tau_{C2}s}\right].$$

The first high pass filter time constant, $\tau_{C1}$ and the second high pass filter time constant, $\tau_{C2}$, may be independently set such that the first corner frequency, $f_{C1}$, does not equal the second corner frequency, $f_{C2}$. For example, the first high pass filter time constant, $\tau_{C1}$, may be configured by the controller 50 (not shown) such that the first corner frequency, $f_{C1}$, has a range between 3M Hz and 11.5 MHz. In some embodiments, the first corner frequency, $f_{C1}$, may have a range between 3 MHz and 3 MHz. Similarly, the controller 50 (not shown) may configure the second high pass filter time constant, $\tau_{C2}$, such that the second corner frequency, $f_{C2}$, has a range between 3 MHz and 11.5 MHz. In some embodiments, the second corner frequency, $f_{C2}$, may have a range between 3 MHz and 8 MHz.

In some embodiments of the high pass filter circuitry 430, the first corner frequency, $f_{C1}$, of the first high pass filter circuit 435A and the second corner frequency, $f_{C2}$, of the second high pass filter circuit 435B are each set to be approximately 6 MHz. In some embodiments, the controller 50 (not shown) may configure the first high pass filter time constant, $\tau_{C1}$, and the second high pass filter time constant, $\tau_{C2}$. For example, the first high pass filter time constant, $\tau_{C1}$, may be configured by the controller 50 (not shown) such that the first corner frequency, $f_{C1}$, has a range between 3 MHz and 11.5 MHz. In some embodiments, the first corner frequency, $f_{C1}$, may have a range between 3 MHz and 11.5 MHz. In still other embodiments the first corner frequency, $f_{C1}$, and the second corner frequency, $f_{C2}$, may be configured to be substantially the same. For example, the first corner frequency, $f_{C1}$, may be configured to be around 6 MHz, and the second corner frequency, $f_{C2}$, may be configured to be around 6 MHz. In some embodiments, the first corner frequency, $f_{C1}$, and the second corner frequency, $f_{C2}$, are configured by the controller 50 as a function of the bandwidth of the receive channel frequency band associated with each band of operation.

Returning to Figure 4, assuming that the high pass filter circuitry 430 includes both the first high pass filter circuit 435A and the second high pass filter circuit 435B, the desired Laplace transfer function for the high frequency ripple compensation current 416, $I_{COR}$, provided at the Gm assist $I_{COR}$ output 426B of the Gm assist circuit 426 is shown in equation (3) as follows:

$$(3) \qquad I_{COR}(s) = \frac{(V_{RAMP}-V_{SW\_OUT\_EST})}{L_{POWER\_INDUCTOR}s}\frac{\tau_{C1}s}{1+\tau_{C1}s}\frac{\tau_{C2}s}{1+\tau_{C2}s}$$

where $V_{RAMP}$ represents the future value of the power amplifier supply voltage, $V_{CC}$, the delayed $I_{COR}$ estimated switching voltage output 38C, $V_{SW\_EST\_DELAY\_ICOR}$, represents the future value of the switching voltage, $V_{SW}$, at the switching voltage output 26 based on the operational state of the switcher control circuit (not shown) of the switch mode power supply converter 420, and $L_{POWER\_INDUCTOR}$ represents the inductance of the power inductor 16. In some embodiments of the open loop ripple compensation assist circuit 414A, the inductance of the power inductor 16 may be represented by the estimated power inductor inductance parameter, $L_{EST}$, discussed above with reference to the open loop assist circuit 39, depicted in Figure 2A and Figure 2B, where the estimated power inductor inductance parameter, $L_{EST}$, may be either the measured or estimated inductance of the power inductor 16 between a specific range of frequencies. For example, the estimated power inductor inductance parameter, $L_{EST}$, may be either the measured or estimated inductance of the power inductor 16 between approximately 10MHz and 30MHz. As another example, the estimated power inductor inductance parameter, $L_{EST}$, may be either the measured or estimated inductance of the power inductor 16 within a band of frequencies near or within operational bandwidth of the linear RF power amplifier 22. In this case, the Laplace transfer function for the high frequency ripple compensation current 416, $I_{COR}$, provided by the Gm assist circuit 426 may be given by equation (4) as follows:

$$(4) \qquad I_{COR}(s) = \frac{\left(V_{RAMP} - V_{SW\_OUT\_EST}\right)}{L_{EST}} \frac{\tau_{C1}}{1 + \tau_{C1}s} \frac{\tau_{C2}s}{1 + \tau_{C2}s}$$

As shown in equation (4), the Laplace transfer function for the high frequency ripple compensation current 416, $I_{COR}$, includes a low pass filter having a low pass time constant, $\tau_{C1}$, and a high pass filter having a high pass time constant, $\tau_{C2}$.

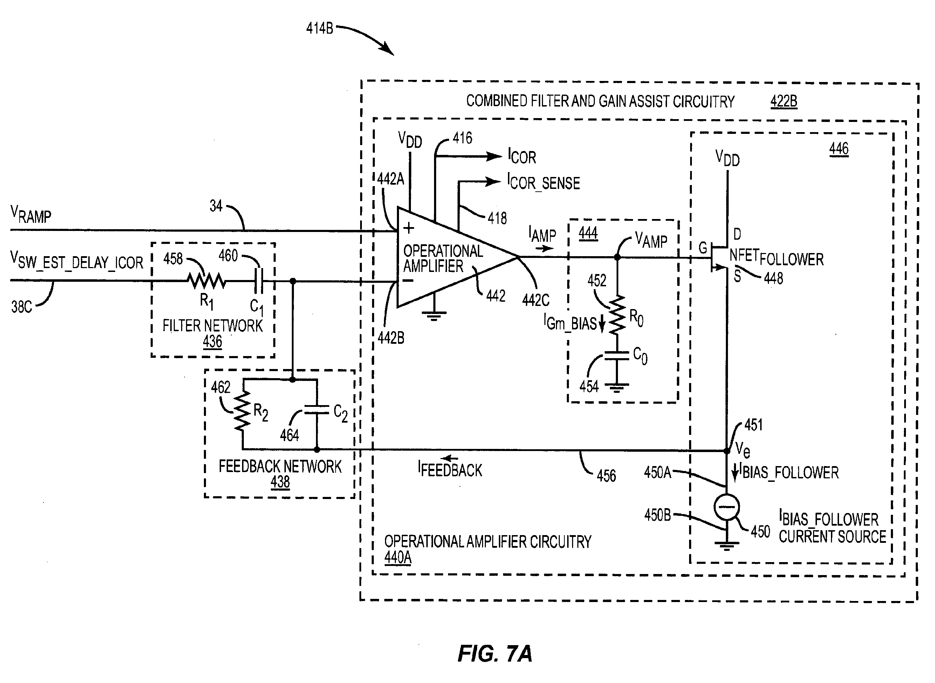

Figure 7A depicts another embodiment of the open loop ripple compensation assist circuit 414B which is similar to the open loop ripple compensation assist circuit 414 depicted in Figures 3A-D. For the sake of brevity, and not by way of limitation, the switch mode power supply converter 420 and circuitry associated with generation of the delayed $I_{COR}$ estimated switching voltage output 38C, $V_{SW\_EST\_DELAY\_ICOR}$, depicted in Figure 4 are not depicted in Figure 7A. Also, while controller 50 is not depicted in Figure 7A, it will be understood that as depicted in Figures 3A-D, controller 50 may configure the various elements of the open loop ripple compensation assist circuit 414B depicted in Figure 7A.

The open loop ripple compensation assist circuit 414B includes combined filter and gain assist circuitry 422B, a filter network 436, and a feedback network 438. The combined filter and gain assist circuitry 422B includes operational amplifier circuitry 440A having an operational amplifier 442, a Gm bias circuit 444, and an operational amplifier output isolation circuit 446.

The operational amplifier 442 includes a non-inverting input 442A, an inverting input 442B, and an operational amplifier output 442C. The operational amplifier 442 may include a first operational amplifier push-pull output stage circuit (not shown) that generates the operational amplifier output 442C. The non-inverting input 442A of the operational amplifier 442 is configured to receive the $V_{RAMP}$ signal. The operational amplifier output 442C may be configured to source an operational amplifier output current, $I_{AMP}$, to produce an operational amplifier output voltage, $V_{AMP}$, across the Gm bias circuit 444.

In addition, the operational amplifier 442 may be further configured to generate or provide the high frequency ripple compensation current 416, $I_{COR}$, and the scaled high frequency ripple compensation current estimate 418, $I_{COR\_SENSE}$. As an example, the operational amplifier 442 may further include a second operational amplifier push-pull output stage circuit (not shown) configured to generate the high frequency ripple compensation current 416, $I_{COR}$. In addition, as another example, the operational amplifier 442 may further include a third operational amplifier push-pull output stage circuit (not shown) configured to generate the scaled high frequency ripple compensation current estimate 418, $I_{COR\_SENSE}$.

In some embodiments of the operational amplifier 442, the high frequency ripple compensation current 416, $I_{COR}$, generated by the second operational amplifier push-pull output stage circuit may be substantially a mirrored current of the operational amplifier output current, $I_{AMP}$, provided by the first operational amplifier push-pull output stage circuit (not shown). Similarly, in some embodiments of the operational amplifier 442, the scaled high frequency ripple compensation current estimate 418, $I_{COR\_SENSE}$, may be a mirrored current of the operational amplifier output current, $I_{AMP}$, provided by the first operational amplifier push-pull output stage circuit (not shown).

In the cases where the high frequency ripple compensation current 416, $I_{COR}$, and the scaled high frequency ripple compensation current estimate 418, $I_{COR\_SENSE}$, are related to the operational amplifier output current, $I_{AMP}$, by a current mirroring arrangement, the relative dimensional relationships of the channel widths of the respective transistor elements may be used to implement the first operational amplifier push-pull output stage circuit (not shown), the second operational amplifier push-pull output stage circuit (not shown), and the third operational amplifier push-pull output stage circuit (not shown), may be configured to relate the magnitudes of the operational amplifier output current, $I_{AMP}$, to the magnitudes of the high frequency ripple compensation current 416, $I_{COR}$, and the scaled high frequency ripple compensation current estimate 418, $I_{COR-SENSE}$.

The operational amplifier output isolation circuit 446 includes a follower NFET 448, $NFET_{FOLLOWER}$, and an $I_{BIAS\_FOLLOWER}$ current source 450. The drain of the follower NFET 448, $NFET_{FOLLOWER}$, is coupled to a circuit supply voltage, $V_{DD}$. The gate of the follower NFET 448, $NFET_{FOLLOWER}$, provides a high impedance input of the operational amplifier output isolation circuit 446, and is coupled to the operational amplifier output 442C. As a result, the gate voltage at the gate of the follower NFET 448, $NFET_{FOLLOWER}$ is equal to the operational amplifier output voltage, $V_{AMP}$. The follower NFET 448, $NFET_{FOLLOWER}$, may be configured such that the input gate impedance of the follower NFET 448, $NFET_{FOLLOWER}$, is very high relative to other impedances coupled to the operational amplifier output 442C in the operational frequency range of the open loop ripple compensation assist circuit 414B. As a result, the gate current, $I_{GATE}$, flowing into the gate of the follower NFET 448, $NFET_{FOLLOWER}$, approaches zero. The source of the follower NFET 448, $NFET_{FOLLOWER}$, is coupled to the first node 450A of the $I_{BIAS\_FOLLOWER}$ current source 450. The second node 450B of the $I_{BIAS\_FOLLOWER}$ current source 450 is coupled to ground. The $I_{BIAS\_FOLLOWER}$ current source 450 may be configured to sink an $NFET_{FOLLOWER}$ bias current, $I_{BIAS\_FOLLOWER}$, to provide a bias current for the follower NFET 448, $NFET_{FOLLOWER}$. The gate-to-source voltage of the follower NFET 448, $NFET_{FOLLOWER}$, is $V_{GS\_NFET\_FOLLOWER}$. The source voltage on the source of the follower NFET 448, $NFET_{FOLLOWER}$, is the feedback voltage, $V_e$, where $V_e$ = $V_{AMP}$ - $V_{GS\_NFET\_FOLLOWER}$. Thus, from a small signal modeling perspective, the follower NFET 448, $NFET_{FOLLOWER}$, effectively isolates the feedback voltage, $V_e$, from the operational amplifier output 442C. As a result, the operational amplifier circuitry 440A includes an isolated feedback node 451 at the node created at the connection of the source of the follower NFET 448, $NFET_{FOLLOWER}$, and the first node 450A of the $I_{BIAS\_FOLLOWER}$ current source 450. The isolated feedback node 451 provides the feedback voltage, $V_e$, to the feedback network 438.

The feedback network 438 may be coupled between the inverting input 442B of the operational amplifier 442 and the isolated feedback node 451 to provide the feedback path for the feedback current 456, $I_{FEEDBACK}$. The inverting input 442B of the operational amplifier 442 is also coupled to the delayed $I_{COR}$ estimated switching voltage output 38C, $V_{SW\_EST\_DELAY\_ICOR}$, via the filter network 436, as depicted in Figure 7A. The filter network 436 includes a filter resistor 458 coupled in series with a filter capacitor 460. The filter resistor 458 may have a filter resistance substantially equal to $R_1$. The filter capacitor 460 may have a filter capacitance substantially equal to $C_1$. The feedback network 438 may include a feedback resistor 462 coupled in parallel with a feedback capacitor 464. The feedback resistor 462 may have a feedback resistance substantially equal to $R_2$. The feedback capacitor 464 may have a feedback capacitance substantially equal to $C_2$. In some embodiments, the filter resistor 458 and/or the feedback resistor 462 may be configured to be programmable by the controller 50 (not shown). For example, the filter resistor 458 and/or the feedback resistor 462 may be a binary weighted resistor array configured to be controlled by the controller 50. As an example, the filter resistor 458 and/or the feedback resistor 462 may each be implemented as a resistor array including switches that may be programmed to be open or closed by the controller 50 (not shown). As a result, the controller 50 may selectively set the resistance value of the filter resistance, $R_1$ of the filter resistor 458, and the resistance value of the feedback resistance, $R_2$, of the feedback resistor 462, to change the frequency response of the open loop ripple compensation assist circuit 414B. In a similar fashion, or in addition to, in some embodiments, the filter capacitor 460 and/or the feedback capacitor 464 may each be implemented as a capacitor array that may be configured by the controller 50. For example, the filter capacitor 460 and/or the feedback capacitor 464 may be a binary weighted capacitor array configured to be controlled by the controller 50. The effective capacitance of the capacitor array may be configured by the controller 50 by selectively switching in and out different capacitors in each respective capacitor array. As a result, in some embodiments, the controller 50 may be configured to selectively set the capacitance value of the filter capacitance, $C_1$, of the filter capacitor 460 and the capacitance value of the feedback capacitance, $C_2$, of the feedback capacitor 464, to change the frequency response of the open loop ripple compensation assist circuit 414B.

In addition, in some embodiments of the open loop ripple compensation assist circuit 414B, the filter resistance, $R_1$, of the filter resistor 458, the feedback resistance, $R_2$, of the feedback resistor 462, the filter capacitance, $C_1$, of the filter capacitor 460, and the feedback capacitance, $C_2$, of the feedback capacitor 464, are independently programmable by the controller 50.

Alternatively, in some embodiments, the capacitance value of the filter capacitance, $C_1$, of the filter capacitor 460 may be a fixed value. Similarly, in some embodiments, the feedback capacitance, $C_2$, of the feedback capacitor 464 may be a fixed value. Likewise, in other embodiments, the resistance value of the filter resistance, $R_1$, of the filter resistor 458 may be a fixed value and/or the resistance value of the feedback resistance, $R_2$, of the feedback resistor 462 may be a fixed value. Moreover, in some embodiments, different combinations of the filter resistance, $R_1$ the feedback resistance, $R_2$, the filter capacitance, $C_1$, and the feedback capacitance, $C_2$, of the respective filter resistor 458, the filter capacitor 460, the feedback resistor 462, and the feedback capacitor 464 may have either fixed values or programmable values of resistances and capacitances.

Similar to the open loop ripple compensation assist circuit 414A, depicted in Figure 4, the open loop ripple compensation assist circuit 414B, depicted in Figure 7A, may be configured to provide substantially the same Laplace transfer function as the open loop ripple compensation assist circuit 414A without an integrator circuit 428 and high pass filter circuitry 430, where the high pass filter circuitry 430 includes a first high pass filter circuit 435A and a second high pass filter circuit 435B, as depicted in Figures 4 and 6 respective. Instead, the open loop ripple compensation assist circuit 414B, depicted in Figure 7A, may be described as having a low pass filter followed by a high pass filter. Similar to the open loop ripple compensation assist circuit 414A, depicted in Figure 4, the open loop ripple compensation assist circuit 414B, depicted in Figure 7A, has a first time constant $\tau_1$ and a second time constant $\tau_2$, which may be configured by the controller 50. The first time constant $\tau_1$ is associated with the filter network 436. The second time constant $\tau_2$ is associated with the feedback network 438. The first time constant $\tau_1$ is substantially equal to the product of the resistance, $R_1$, of the filter resistor 458 and the filter capacitance, $C_1$, of the filter capacitor 460, and corresponds to the first corner frequency, $f_{C1}$. The second time constant $\tau_2$ is substantially equal to the product of the feedback resistance, $R_2$, of the feedback resistor 462 and the feedback capacitance, $C_2$, of the feedback capacitor 464, and corresponds to the second corner frequency, $f_{C2}$.

In some embodiments, the filter resistance, $R_1$, of the filter resistor 458 and the filter capacitance, $C_1$, of the filter capacitor 460 may be configured such that the first corner frequency, $f_{C1}$, may have a range between 3 MHz and 11.5 MHz. In other embodiments, the filter resistance, $R_1$, of the filter resistor 458 and the filter capacitance, $C_1$, of the filter capacitor 460 may be configured such that the first corner frequency, $f_{C1}$, may have a range between 3 MHz and 8 MHz. Similarly, the feedback resistance, $R_2$, of the feedback resistor 462 and the feedback capacitance, $C_2$, of the feedback capacitor 464 may be configured such that the second corner frequency, $f_{C2}$, may have a range between 4 MHz and 11.5 MHz. In other embodiments, the feedback resistance, $R_2$, of the feedback resistor 462 and the feedback capacitance, $C_2$, of the feedback capacitor 464 may be configured such that the second corner frequency, $f_{C2}$, may have a range between 4 MHz and 8 MHz. As another example, the controller 50 may configure the filter resistance, $R_1$, the filter capacitance, $C_1$, feedback resistance, $R_2$, and the feedback capacitance, $C_2$, as a function of the bandwidth of the receive channel frequency band associated with each band of operation.

The Gm bias circuit 444 may include a bias resistor 452 coupled in series with a bias capacitor 454 between the operational amplifier output 442C and ground. The bias resistor 452 may have a bias resistance, $R_0$. As an example, in some embodiments, the bias resistor 452 may be a resistor array that is configurable by the controller 50. The value of the bias resistance, $R_0$, may be set by the controller 50 by selecting one or a combination of the resistors to obtain a desired effective resistance of the resistor array. In other embodiments, the value of the bias resistance, $R_0$, may be fixed. The bias capacitor 454 may have a bias capacitance $C_0$. In some embodiments, the bias capacitance, $C_0$, of the bias capacitor 454 may also be programmable by the controller 50. As an example, the bias capacitor 454 may be a capacitor array. As a result, the controller 50 may configure the value of the bias capacitance, $C_0$, of the bias capacitor 454 by selectively switching in and out various combinations of the capacitors in the capacitor array. However, in some embodiments, the value of the bias capacitance, $C_0$, may be fixed.

As an example configuration of the series arrangement of the bias resistor 452 and the bias capacitor 454 of the Gm bias circuit 444, the bias resistor 452 may include a first terminal and a second terminal. The bias capacitor 454 may include a first terminal coupled to the second terminal of the bias resistor 452 and a second terminal coupled to ground. The first terminal of the bias resistor 452 may be coupled to the operational amplifier output 442C.

The operational amplifier output voltage, $V_{AMP}$, generated at the operational amplifier output 442C may induce a Gm bias current, $I_{GM\_BIAS}$, through the Gm bias circuit 444. The impedance of the Gm bias circuit 444 is configured to set the transconductance of the operational amplifier 442 within the operational bandwidth of the operational amplifier 442. Because the bias capacitor 454 blocks direct currents, the impedance of the Gm bias circuit 444 may be used to set the small signal transconductance of the operational amplifier 442. The bias capacitance, $C_0$, of the bias capacitor 454 may be selected such that the impedance of the Gm bias circuit 444 is dominated by the bias resistance, $R_0$, of the bias resistor 452 within the frequency band of operation of the open loop ripple compensation assist circuit 414B. For example, because the open loop ripple compensation assist circuit 414B is configured to generate the high frequency ripple compensation current 416, $I_{COR}$, to cancel out high frequency ripple currents at the power amplifier supply output 28, the bias capacitance, $C_0$, may be selected such that the impedance of the bias capacitor 454 is dominated by the impedance of the bias resistor 452 within the frequency band of operation of the open loop ripple compensation assist circuit 414B. Advantageously, the bias capacitor 454 is included in the Gm bias circuit 444 to reduce the current drawn by the operational amplifier 442. Accordingly, as will be described, the operational amplifier transconductance, $Gm_{OP\_AMP}$, of the operational amplifier 442 within the frequency band of operation of the open loop ripple compensation assist circuit 414B may be set based on the value of the bias resistance, $R_0$, of the bias resistor 452, where the operational amplifier transconductance, $Gm_{OP\_AMP}$, refers to the small signal transconductance of the operational amplifier 442. If the bias capacitor 454 is removed such that the bias resistor 452 is coupled between the operational amplifier output 442C and ground, the impedance of the Gm bias circuit 444 would set both the direct current transconductance and small signal transconductance of the operational amplifier 442.

Because the input gate impedance of the follower NFET 448, $NFET_{FOLLOWER}$, may be configured to be several orders of magnitude greater than the impedance of the Gm bias circuit 444, the operational amplifier transconductance, $Gm_{OP\_AMP}$, of the operational amplifier 442 may be set based on the value of the bias resistance, $R_0$, of the bias resistor 452. In particular, assuming that the gate current, $I_{GATE}$, into the gate of the follower NFET 448, $NFET_{FOLLOWER}$, is near zero, the operational amplifier output current, $I_{AMP}$, is equal to an operational amplifier output voltage, $V_{AMP}$, divided by the impedance of the Gm bias circuit 444. By selecting a value of the bias capacitance, $C_0$, of the bias capacitor 454 such that the impedance of the bias capacitor 454 is dominated by the bias resistance, $R_0$, of the bias resistor 452 within the frequency band of operation of the open loop ripple compensation assist circuit 414B, the impedance of the Gm bias circuit 444 is approximately equal to the bias resistance, $R_0$, of the bias resistor 452. As a result, the operational amplifier 442 may have an operational amplifier transconductance, $Gm_{OP\_AMP}$, within the frequency band of operation of the open loop ripple compensation assist circuit 414B that is approximately $1/R_0$. In some embodiments, because the bias resistance, $R_0$, may be configured by the controller 50, the controller 50 may set the operational amplifier transconductance, $Gm_{OP\_AMP}$, of the operational amplifier 442 by setting the resistance level of the bias resistance, $R_0$, of the bias resistor 452. However, if the bias capacitor 454 is removed such that the bias resistor 452 is coupled between the operational amplifier output 442C and ground, the impedance of the Gm bias circuit 444 would set both the direct current transconductance and small signal transconductance of the operational amplifier 442. The Laplace transfer function for the operational amplifier output current, $I_{AMP}$, when the Gm bias circuit 444 does not include the bias capacitor 454 is shown in equation (5) as follows:

$$(5) \qquad I_{AMP}(s) = \frac{1}{R_0} \frac{R_2 C_1 s(V_{RAMP} - V_{SW\_EST\_DELAY\_ICOR})}{(1 + R_1 C_1 s)(1 + R_2 C_2 s)} + I_{DC}$$

where $I_{DC}$ represents the direct current flowing through the bias resistor 452 as if the bias capacitor 454 is not present and the bias resistor 452 is coupled between the operational amplifier output 442C and ground, and the $V_{RAMP}$ signal represents the future value of the power amplifier supply voltage, $V_{CC}$ and the delayed $I_{COR}$ estimated switching voltage output 38C, $V_{SW\_EST\_DELAY\_ICOR}$, represents the future value of the switching voltage, $V_{SW}$, at the switching voltage output 26. If the Gm bias circuit 444 includes the bias capacitor 454, where the bias capacitance, $C_0$, of the bias capacitor 454 is selected such that the impedance of the Gm bias circuit 444 within the frequency band of operation of the operational amplifier 442 is dominated by the bias resistance, $R_0$, of the bias resistor 452, the Laplace transfer function for the operational amplifier output current, $I_{AMP}$, is given by equation (6) as follows:

$$(6) \qquad I_{AMP}(s) = \frac{1}{R_0} \frac{R_2 C_1 s(V_{RAMP} - V_{SW\_EST\_DELAY\_ICOR})}{(1 + R_1 C_1 s)(1 + R_2 C_2 s)} \quad,$$

where, for the purposes of small single gain, the direct current, $I_{DC}$, is blocked by the bias capacitor 454.

As a non-limiting example, mapping the elements of equation (4) to the elements of equation (6), shows that the open loop ripple compensation assist circuit 414B may provide the same Laplace transfer function as the open loop ripple compensation assist circuit 414A, depicted in Figure 4. For example, setting $\tau_{C1} = \tau_1 = R_1 C_1$, $\tau_{C2} = \tau_2 = R_2 C_2$ and $R_2 C_1/R_0 = \tau_{C2}/L_{EST}$, the transfer function of $I_{COR}(S) = I_{AMP}(S)$. Thus, for the transfer function of the open loop ripple compensation assist circuit 414B depicted in Figure 7A, the first corner frequency, $f_{C1}$, = $1/(2\pi R_1 C_1)$ and the second corner frequency, $f_{C2}$, = $1/(2\pi R_2 C_2)$. Because the controller 50 may configure the filter resistance, $R_1$, of the filter resistor 458, the feedback resistance, $R_2$, of the feedback resistor 462, the filter capacitance, $C_1$, of the filter capacitor 460, and the feedback capacitance, $C_2$, of the feedback capacitor 464, the first high pass filter response having a first corner frequency, $f_{C1}$, and a second high pass filter response having a first corner frequency, are also independently programmable.

If, for the sake of simplicity, and not by way of limitation, the filter capacitance, $C_1$, and the feedback capacitance, $C_2$, are selected such that $C_1 = C_2 = C$, mapping of the elements of equation (4) to the elements of equation (6) yields the

relationships of $\tau_{C1=}R_1 C$, $\tau_{C2=}R_2 C$, and $R_0 = \dfrac{L_{EST}}{\tau_{C1}} = \dfrac{L_{EST}}{R_1 C}$ .

Based on the non-limiting example mapping described above, the transfer function for the operational amplifier output current, $I_{AMP}$, described in equation (6) would be substantially equal to the desired transfer function for the high frequency ripple compensation current 416, $I_{COR}$, described in equation (4). However, as will be described below, in some embodiments of the open loop ripple compensation assist circuit 414B, the operational amplifier output current, $I_{AMP}$, is proportional to the high frequency ripple compensation current 416, $I_{COR}$, generated by the operational amplifier 442. In other words, the magnitude of the bias resistance, $R_0$, of the bias resistor 452, may be selected such that $R_0$ is

proportional to $\dfrac{L_{EST}}{\tau_{C1}}$, where the relative ratios of the channel widths of the transistor elements used to implement the first operational amplifier push-pull output stage circuit of the operational amplifier 442 and the transistor elements used to implement the second operational amplifier push-pull output stage circuit of the operational amplifier 442 are configured such that the high frequency ripple compensation current 416, $I_{COR}$, generated by the operational amplifier 442 is consistent with the desired transfer function for the high frequency ripple compensation current 416, $I_{COR}$, described by equation (4), with respect to the open loop ripple compensation assist circuit 414A depicted in Figure 4.

As shown by the non-limiting example mapping of equation (4) to equation (6), the open loop ripple compensation assist circuit 414B, depicted in Figure 7A may be configured to provide a similar function as the open loop ripple compensation assist circuit 414A depicted in Figure 4. In other words, the embodiment of the open loop ripple compensation assist circuit 414B that includes the operational amplifier 442, the operational amplifier output isolation circuit 446, the feedback network 438, and the filter network 436, as depicted in Figure 7A, may be configured to provide a substantially similar transfer function as the open loop ripple compensation assist circuit 414A depicted in Figure 4.

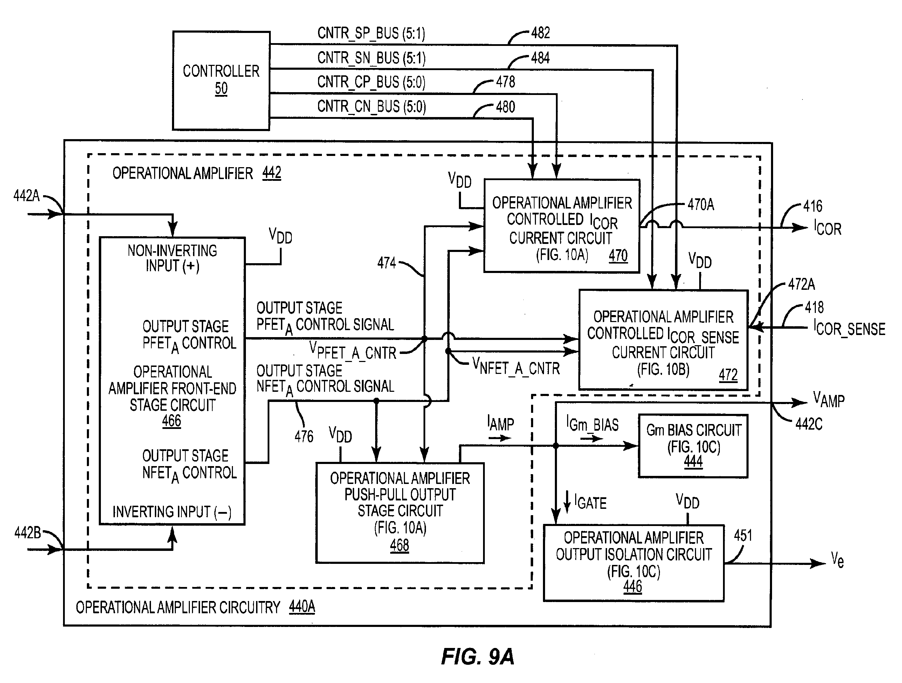

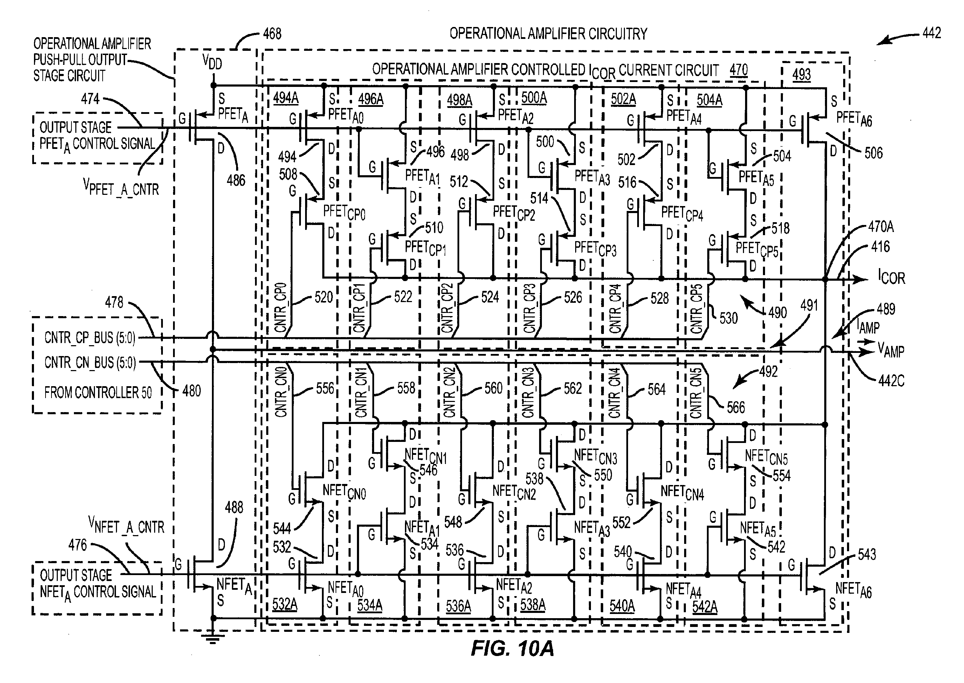

Generation of the high frequency ripple compensation current 416, $I_{COR}$, and the scaled high frequency ripple compensation current estimate 418, $I_{COR\_SENSE}$, as a function of the operational amplifier output current, $I_{AMP}$, will now be discussed with reference to Figure 9A and Figures 10A-10C.

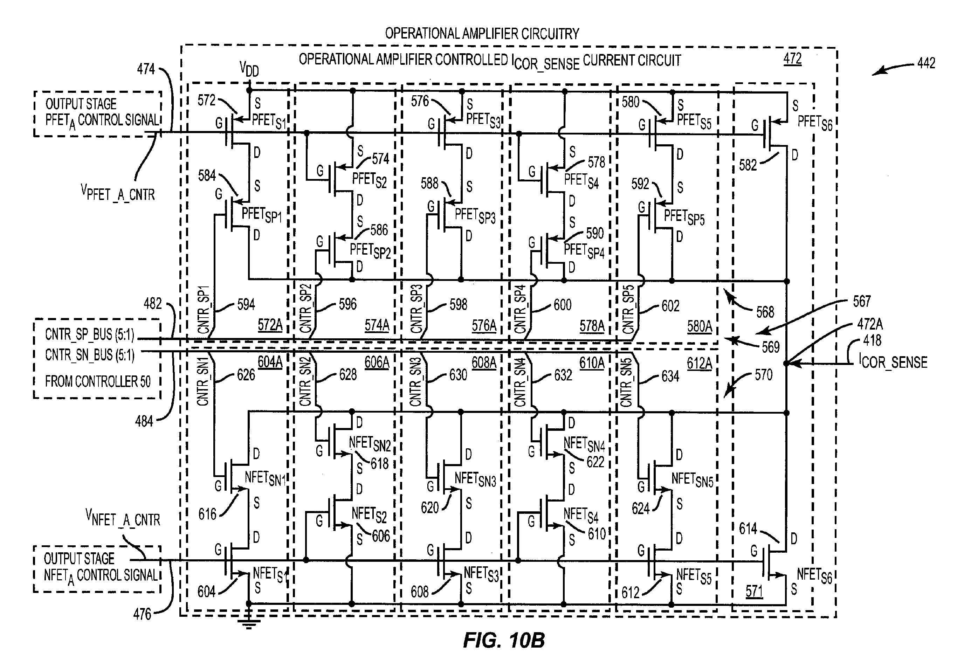

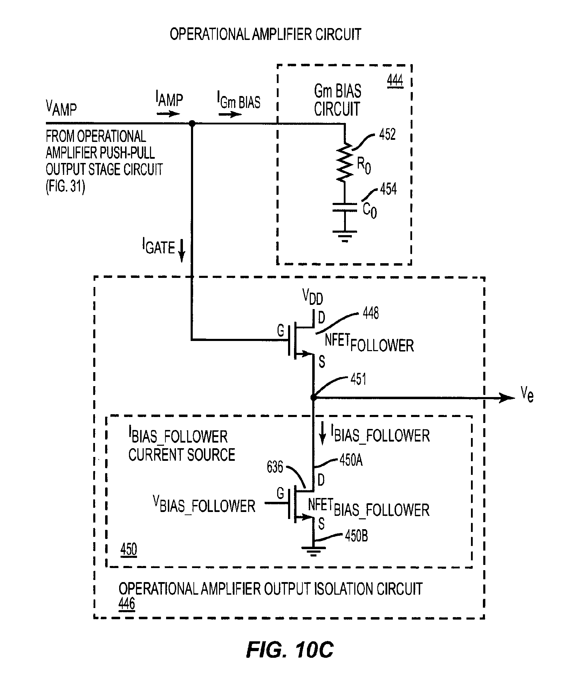

Figure 9A depicts an embodiment of the operational amplifier circuitry 440A having the operational amplifier 442, where the operational amplifier circuitry 440A includes the operational amplifier 442 in combination with both an embodiment of the Gm bias circuit 444 and an embodiment of the operational amplifier output isolation circuit 446. The embodiment of the operational amplifier circuitry 440A depicted in Figure 9A will be described with continuing reference to the operational amplifier circuitry 440A depicted in Figure 7A, with reference to Figure 10A and Figure 10B, and the embodiments of the Gm Bias Circuit 444 and the operational amplifier output isolation circuit 446 depicted in Figure 10C.

The embodiment of the operational amplifier 442, depicted in Figure 9A, may include an embodiment of the operational amplifier front-end stage circuit 466, an embodiment of the operational amplifier push-pull output stage circuit 468, an embodiment of the operational amplifier controlled $I_{COR}$ current circuit 470, and an embodiment of the operational amplifier controlled $I_{COR\_SENSE}$ current circuit 472. The embodiments of the operational amplifier front-end stage circuit 466, the operational amplifier push-pull output stage circuit 468, the operational amplifier controlled $I_{COR}$ current circuit 470, and the operational amplifier controlled $I_{COR\_SENSE}$ current circuit 472 depicted in Figure 9A are each configured to receive the circuit supply voltage, $V_{DD}$. The embodiment of the operational amplifier output isolation circuit 446 depicted in Figure 10C is configured receive the circuit supply voltage, $V_{DD}$.

The operational amplifier push-pull output stage circuit 468 may be a push-pull output stage operably coupled to the operational amplifier output 442C. The operational amplifier push-pull output stage circuit 468 may be configured to provide an operational amplifier output current, $I_{AMP}$, and to generate an operational amplifier output voltage, $V_{AMP}$, at the operational amplifier output 442C.

The operational amplifier controlled $I_{COR}$ current circuit 470 includes an operational amplifier controlled $I_{COR}$ current output 470A configured to provide the high frequency ripple compensation current 416, $I_{COR}$. In addition, the operational amplifier controlled $I_{COR}$ current circuit 470 may be configured as a push-pull output stage having a programmable $I_{COR}$ transconductance, $Gm_{ICOR}$, where the magnitude of the high frequency ripple compensation current 416, $I_{COR}$, is proportionally related to the operational amplifier output current, $I_{AMP}$, based on the relative dimensional relationships of the channel widths of the transistor elements used to implement the operational amplifier push-pull output stage circuit 468 and the operational amplifier controlled $I_{COR}$ current circuit 470. Similarly, the operational amplifier controlled $I_{COR\_SENSE}$ current circuit 472 includes an operational amplifier controlled $I_{COR\_SENSE}$ current output 472A configured to provide the scaled high frequency ripple compensation current estimate 418, $I_{COR\_SENSE}$, where the relative dimensional relationships of the channel widths of the transistor elements used to implement the operational amplifier controlled $I_{COR}$ current circuit 470 and the operational amplifier controlled $I_{COR\_SENSE}$ current circuit 472 may be configured to determine a relationship between the magnitude of the high frequency ripple compensation current 416, $I_{COR}$, and the magnitude of the scaled high frequency ripple compensation current estimate 418, $I_{GOR\_SENSE}$. For example, the relative dimensional relationships of the channel widths of the transistor elements used to implement the operational amplifier controlled $I_{COR}$ current circuit 470 and the operational amplifier controlled $I_{COR\_SENSE}$ current circuit 472 may be configured such that the operational amplifier controlled $I_{COR\_SENSE}$ current circuit 472 may be configured to provide a scaled high frequency ripple compensation current estimate 418, $I_{COR\_SENSE}$, that is fractionally proportional to the high frequency ripple compensation current 416, $I_{COR}$. For example, the scaled high frequency ripple compensation current estimate 418, $I_{COR\_SENSE}$, may be fractionally related to the high frequency ripple compensation current 416, $I_{COR}$, by a sense scaling factor, $C_{SENSE\_SCALING}$.

The operational amplifier front-end stage circuit 466 includes a non-inverting input (+) that corresponds to the non-inverting input 442A of the operational amplifier 442 depicted in Figure 7A. In addition, the operational amplifier front-end stage circuit 466 includes an inverting input (-) that corresponds to the inverting input 442B of the operational amplifier 442 depicted in Figure 7A. Based on the voltage difference between the non-inverting input 442A and the inverting input 442B of the operational amplifier 442, the operational amplifier front-end stage circuit 466 generates an output stage $PFET_A$ control signal 474 and an output stage $NFET_A$ control signal 476 that are used to control the operation of the operational amplifier push-pull output stage circuit 468, the operational amplifier controlled $I_{COR}$ current circuit 470, and the operational amplifier controlled $I_{COR\_SENSE}$ current circuit 472.

The controller 50 may be configured to provide an $I_{COR}$ source current weight control bus 478, CNTR_CP_BUS (5:0) and an $I_{COR}$ sink current weight control bus 480, CNTR_CN_BUS (5:0) to the operational amplifier controlled $I_{COR}$ current circuit 470. As will be described, the controller 50 may programmatically control the magnitude of the high frequency ripple compensation current 416, $I_{COR}$, via the $I_{COR}$ source current weight control bus 478, CNTR_CP_BUS (5:0) and the $I_{COR}$ sink current weight control bus 480, CNTR_CN_BUS (5:0). Similarly, the controller 50 may be configured to provide an $I_{COR\_SENSE}$ source current weight control bus 482, CNTR_SP_BUS (5:1), and an $I_{COR\_SENSE}$ sink current weight control bus 484, CNTR_SN_BUS (5:1), to the operational amplifier controlled $I_{COR\_SENSE}$ current circuit 472. As will also be described, the controller 50 may programmatically control the magnitude of a scaled high frequency ripple compensation current estimate 418, $I_{COR\_SENSE}$, via the $I_{COR\_SENSE}$ source current weight control bus 482, CNTR_SP_BUS (5:1), and the $I_{COR\_SENSE}$ sink current weight control bus 484, CNTR_SN_BUS (5:1).

The operational amplifier push-pull output stage circuit 468 is configured to receive the output stage $PFET_A$ control signal 474 and the output stage $NFET_A$ control signal 476. Based on the output stage $PFET_A$ control signal 474 and the output stage $NFET_A$ control signal 476, the operational amplifier push-pull output stage circuit 468 is configured to generate the operational amplifier output current, $I_{AMP}$, at the operational amplifier output 442C. operational

As further depicted in Figure 10A, the operational amplifier push-pull output stage circuit 468 includes a first push-pull output PFET 486, $PFET_A$, and a first push-pull output NFET 488, $NFET_A$. The drain of the first push-pull output PFET 486, $PFET_A$, and the drain of the first push-pull output NFET 488, $NFET_A$, are coupled to form a substantially symmetrical push-pull output arrangement that forms the operational amplifier output 442C. The source of the first push-pull output PFET 486, $PFET_A$, is coupled to the circuit supply voltage, $V_{DD}$. The source of the first push-pull output NFET 488, $NFET_A$, is coupled to ground. The gate of the first push-pull output PFET 486, $PFET_A$, is configured to receive the output stage $PFET_A$ control signal 474, which sets the voltage on the gate of the first push-pull output PFET 486, $PFET_A$, to a $PFET_A$ control voltage, $V_{PFET\_A\_CNTR}$. The gate of the first push-pull output NFET 488, $NFET_A$, is configured to receive the output stage $NFET_A$ control signal 476, which sets the voltage on the gate of the first push-pull output NFET 488, $NFET_A$, to an $NFET_A$ control voltage, $V_{NFET\_A\_CNTR}$.

The operational amplifier front-end stage circuit 466 controls the $PFET_A$ control voltage, $V_{PFET\_A\_CNTR}$ and the $NFET_A$ control voltage, $V_{NFET\_A\_CNTR}$ such that when the voltage difference between the non-inverting input 442A and the inverting input 442B of the operational amplifier 442 is substantially equal to zero, the current passing through the first push-pull output PFET 486, $PFET_A$, is substantially equal to the current passing through the first push-pull output NFET 488, $NFET_A$, such that the operational amplifier output current, $I_{AMP}$, generated by the operational amplifier push-pull output stage circuit 468, at the operational amplifier output 442C, is substantially equal to zero. As a result, the operational amplifier output voltage, $V_{AMP}$, generated at the connection of the drain of the first push-pull output PFET 486, $PFET_A$, and the drain of the first push-pull output NFET 488, $NFET_A$, is also substantially equal to zero.

Otherwise, depending upon the voltage difference developed between the non-inverting input 442A and the inverting input 442B of the operational amplifier 442, the operational amplifier front-end stage circuit 466 controls the $PFET_A$ control voltage, $V_{PFET\_A\_CNTR}$ and the $NFET_A$ control voltage, $V_{NFET\_A\_CNTR}$, such that the operational amplifier output current, $I_{AMP}$, generated by the operational amplifier push-pull output stage circuit 468 either sources or sinks current. When the operational amplifier push-pull output stage circuit 468 sources current, in other words, the operational amplifier output current, $I_{AMP}$, is greater than zero, the current flowing through the drain of the first push-pull output PFET 486, $PFET_A$, is greater than the current flowing through the first push-pull output NFET 488, $NFET_A$. Correspondingly, when the operational amplifier push-pull output stage circuit 468 sinks current, in other words the operational amplifier output current, $I_{AMP}$, is less than zero, the current flowing through the drain of the first push-pull output PFET 486, $PFET_A$, is less than the current flowing through the first push-pull output NFET 488, $NFET_A$.

The operational amplifier controlled $I_{COR}$ current circuit 470 may be configured as an array of mirrored transistor elements arranged to form a substantially symmetric push-pull output stage 489 for providing the high frequency ripple compensation current 416, $I_{COR}$. The substantially symmetric push-pull output stage 489 may include a programmable array of mirrored source current elements 490 and a programmable array of mirrored sink current elements 492 coupled to form a substantially symmetric programmable push-pull output stage 491. Each of the mirrored transistor elements in the programmable array of mirrored source current elements 490 is associated with a corresponding transistor element of the mirrored transistor elements in the programmable array of mirrored sink current elements 492.

The substantially symmetric push-pull output stage 489 may further include mirrored transistor elements configured to form a substantially symmetric $I_{COR}$ current push-pull output stage 493. The substantially symmetric $I_{COR}$ current push-pull output stage 493 may be configured to provide an $I_{COR}$ offset current carrying capacity in the case where the programmable array of mirrored source current elements 490 and the programmable array of mirrored sink current elements 492 are disabled or turned off.

The mirrored source transistor elements of the substantially symmetric push-pull output stage 489 may include a first push-pull output PFET 486, $PFET_A$, a second mirrored PFET 496, $PFET_{A1}$, a third mirrored PFET 498, $PFET_{A2}$,

a fourth mirrored PFET 500, $PFET_{A3}$, a fifth mirrored PFET 502, $PFET_{A4}$, a sixth mirrored PFET 504, $PFET_{A5}$, and a seventh mirrored PFET 506, $PFET_{A6}$.

The channel width of each of the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, and the sixth mirrored PFET 504, $PFET_{A5}$ are configured such that the current carrying capacity of the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, and the sixth mirrored PFET 504, $PFET_{A5}$, are binary weighted. As a result, the current carrying capacity of the second mirrored PFET 496, $PFET_{A1}$, is substantially twice the current carrying capacity of the first mirrored PFET 494, $PFET_{A0}$, the current carrying capacity of the third mirrored PFET 498, $PFET_{A2}$ is substantially twice the current carrying capacity of the second mirrored PFET 496, $PFET_{A1}$, the current carrying capacity of the fourth mirrored PFET 500, $PFET_{A3}$ is substantially twice the current carrying capacity of the third mirrored PFET 498, $PFET_{A2}$, the current carrying capacity of the fifth mirrored PFET 502, $PFET_{A4}$, is substantially twice the current carrying capacity of the fourth mirrored PFET 500, $PFET_{A3}$, and the current carrying capacity of the sixth mirrored PFET 504, $PFET_{A5}$ is substantially twice the current carrying capacity of the fifth mirrored PFET 502, $PFET_{A4}$. The channel width of the seventh mirrored PFET 506, $PFET_{A6}$ is configured relative to the channel width of the first push-pull output PFET 486, $PFET_A$, to provide an $I_{COR}$ offset source current carrying capacity for the substantially symmetric $I_{COR}$ current push-pull output stage 493 of the operational amplifier controlled $I_{COR}$ current circuit 470.

The programmable array of mirrored source current elements 490 may further include a first control mirrored PFET 508, $PFET_{CP0}$, a second control mirrored PFET 510, $PFET_{CP1}$, a third control mirrored PFET 512, $PFET_{CP2}$, a fourth control mirrored PFET 514, $PFET_{CP3}$, a fifth control mirrored PFET 516, $PFET_{CP4}$, and a sixth control mirrored PFET 518, $PFET_{CP5}$. As further depicted in Figure 10A, the programmable array of mirrored source current elements 490 may be coupled to or further include the $I_{COR}$ source current weight control bus 478, CNTR_CP_BUS (5:0). The $I_{COR}$ source current weight control bus 478, CNTR_CP_BUS (5:0) includes a first control mirrored PFET signal 520, CNTR_CP0, a second control mirrored PFET signal 522, CNTR_CP1, a third control mirrored PFET signal 524, CNTR_CP2, a fourth control mirrored PFET signal 526, CNTR_CP3, a fifth control mirrored PFET signal 528, CNTR_CP4, and a sixth control mirrored PFET signal 530, CNTR_CP5.

The first control mirrored PFET signal 520, CNTR_CP0, the second control mirrored PFET signal 522, CNTR_CP1, the third control mirrored PFET signal 524, CNTR_CP2, the fourth control mirrored PFET signal 526, CNTR_CP3, the fifth control mirrored PFET signal 528, CNTR_CP4, and the sixth control mirrored PFET signal 530, CNTR_CP5 are respectively coupled to and configured so as to control the gate of each of the first control mirrored PFET 508, $PFET_{CP0}$, the second control mirrored PFET 510, $PFET_{CP1}$, the third control mirrored PFET 512, $PFET_{CP2}$, the fourth control mirrored PFET 514, $PFET_{CP3}$, the fifth control mirrored PFET 516, $PFET_{CP4}$, and the sixth control mirrored PFET 518, $PFET_{CP5}$.

Accordingly, as will be described in further detail below, the programmable array of mirrored source current elements 490 includes the first control mirrored PFET 508, $PFET_{CP0}$, the second control mirrored PFET 510, $PFET_{CP1}$, the third control mirrored PFET 512, $PFET_{CP2}$, the fourth control mirrored PFET 514, $PFET_{CP3}$, the fifth control mirrored PFET 516, $PFET_{CP4}$, and the sixth control mirrored PFET 518, $PFET_{CP5}$, that are respectively combined with the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, and the sixth mirrored PFET 504, $PFET_{A5}$ in order to form a first programmable mirrored source current element 494A, a second programmable mirrored source current element 496A, a third programmable mirrored source current element 498A, a fourth programmable mirrored source current element 500A, a fifth programmable mirrored source current element 502A, and a sixth programmable mirrored source current element 504A.

The programmable array of mirrored source current elements 490 of the substantially symmetric push-pull output stage 489 will now be described. The gate of each of the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, the sixth mirrored PFET 504, $PFET_{A5}$, and the seventh mirrored PFET 506, $PFET_{A6}$ are each coupled to the output stage $PFET_A$ control signal 474 such that the each of the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, and the sixth mirrored PFET 504, $PFET_{A5}$, and the seventh mirrored PFET 506, $PFET_{A6}$ is current mirrored to the first push-pull output PFET 486, $PFET_A$ of the operational amplifier push-pull output stage circuit 468. As a result, the gate voltage for each of the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, and the sixth mirrored PFET 504, $PFET_{A5}$, and the seventh mirrored PFET 506, $PFET_{A6}$ is substantially set equal to the $PFET_A$ control voltage, $V_{PFET-A-CNTR}$.

The programmable array of mirrored source current elements 490 includes the first programmable mirrored source current element 494A, the second programmable mirrored source current element 496A, the third programmable mirrored source current element 498A, the fourth programmable mirrored source current element 500A, the fifth programmable mirrored source current element 502A, and the sixth programmable mirrored source current element 504A, where the current carrying capacity of the first programmable mirrored source current element 494A, the second programmable mirrored source current element 496A, the third programmable mirrored source current element 498A, the fourth programmable mirrored source current element 500A, the fifth programmable mirrored source current element 502A, and the sixth programmable mirrored source current element 504A, are substantially binary weighted. The current contribution of each of the first programmable mirrored source current element 494A, the second programmable mirrored source current element 496A, the third programmable mirrored source current element 498A, the fourth programmable mirrored source current element 500A, the fifth programmable mirrored source current element 502A, and the sixth programmable mirrored source current element 504A, to form the high frequency ripple compensation current 416, $I_{COR}$, is governed by the controller 50 via the $I_{COR}$ source current weight control bus 478, CNTR_CP_BUS (5:0).

The first programmable mirrored source current element 494A includes the first mirrored PFET 494, $PFET_{A0}$, and is formed by coupling the source of the first mirrored PFET 494, $PFET_{A0}$, to circuit supply voltage, $V_{DD}$, and the drain of the first mirrored PFET 494, $PFET_{A0}$, to the source of the first control mirrored PFET 508, $PFET_{CP0}$. The drain of the first control mirrored PFET 508, $PFET_{CP0}$, is coupled to the operational amplifier controlled $I_{COR}$ current output 470A. The gate of the first control mirrored PFET 508, $PFET_{CP0}$, is coupled to the first control mirrored PFET signal 520, CNTR_CP0, such that the controller 50 may control the operation state (on/off) of the first programmable mirrored source current element 494A. The second programmable mirrored source current element 496A includes the second mirrored PFET 496, $PFET_{A1}$, and is formed by coupling the source of the second mirrored PFET 496, $PFET_{A}$, to circuit supply voltage, $V_{DD}$, and the drain of the second mirrored PFET 496, $PFET_{A1}$, to the source of the second control mirrored PFET 510, $PFET_{CP1}$. The drain of the second control mirrored PFET 510, $PFET_{CP1}$, is coupled to the operational amplifier controlled $I_{COR}$ current output 470A. The gate of the second control mirrored PFET 510, $PFET_{CP1}$, is coupled to the second control mirrored PFET signal 522, CNTR_CP1, such that the controller 50 may control the operation state (on/off) of the second programmable mirrored source current element 496A. The third programmable mirrored source current element 498A includes the third mirrored PFET 498, $PFET_{A2}$, and is formed by coupling the source of the third mirrored PFET 498, $PFET_{A2}$, to circuit supply voltage, $V_{DD}$, and the drain of the third mirrored PFET 498, $PFET_{A2}$, to the source of the third control mirrored PFET 512, $PFET_{CP2}$. The drain of the third control mirrored PFET 512, $PFET_{CP2}$, is coupled to the operational amplifier controlled $I_{COR}$ current output 470A. The gate of the third control mirrored PFET 512, $PFET_{CP2}$, is coupled to the third control mirrored PFET signal 524, CNTR_CP2, such that the controller 50 may control the operation state (on/off) of the third programmable mirrored source current element 498A. The fourth programmable mirrored source current element 500A includes the fourth mirrored PFET 500, $PFET_{A3}$, and is formed by coupling the source of the fourth mirrored PFET 500, $PFET_{A3}$, to circuit supply voltage, $V_{DD}$, and the drain of the fourth mirrored PFET 500, $PFET_{A3}$, to the source of the fourth control mirrored PFET 514, $PFET_{CP3}$. The drain of the fourth control mirrored PFET 514, $PFET_{CP3}$, is coupled to the operational amplifier controlled $I_{COR}$ current output 470A. The gate of the fourth control mirrored PFET 514, $PFET_{CP3}$, is coupled to the fourth control mirrored PFET signal 526, CNTR_CP3, such that the controller 50 may control the operation state (on/off) of the fourth programmable mirrored source current element 500A. The fifth programmable mirrored source current element 502A includes the fifth mirrored PFET 502, $PFET_{A4}$, and is formed by coupling the source of the fifth mirrored PFET 502, $PFET_{A4}$, to circuit supply voltage, $V_{DD}$, and the drain of the fifth mirrored PFET 502, $PFET_{A4}$, to the source of the fifth control mirrored PFET 516, $PFET_{CP4}$. The drain of the fifth control mirrored PFET 516, $PFET_{CP4}$, is coupled to the operational amplifier controlled $I_{COR}$ current output 470A. The gate of the fifth control mirrored PFET 516, $PFET_{CP4}$, is coupled to the fifth control mirrored PFET signal 528, CNTR_CP4, such that the controller 50 may control the operation state (on/off) of the fifth programmable mirrored source current element 502A. The sixth programmable mirrored source current element 504A includes the sixth mirrored PFET 504, $PFET_{A5}$, and is formed by coupling the source of the sixth mirrored PFET 504, $PFET_{A5}$, to circuit supply voltage, $V_{DD}$, and the drain of the sixth mirrored PFET 504, $PFET_{A5}$, to the source of the sixth control mirrored PFET 518, $PFET_{CP5}$. The drain of the sixth control mirrored PFET 518, $PFET_{CP5}$, is coupled to the operational amplifier controlled $I_{COR}$ current output 470A. The gate of the sixth control mirrored PFET 518, $PFET_{CP5}$, is coupled to the sixth control mirrored PFET signal 530, CNTR_CP5, such that the controller 50 may control the operation state (on/off) of the sixth programmable mirrored source current element 504A.

Similar to the programmable array of mirrored source current elements 490, the programmable array of mirrored sink current elements 492 of the mirrored sink transistor elements of the substantially symmetric push-pull output stage 489 may include a first mirrored NFET 532, $NFET_{A0}$, a second mirrored NFET 534, $NFET_{A1}$, a third mirrored NFET 536, $NFET_{A2}$, a fourth mirrored NFET 538, $NFET_{A3}$, a fifth mirrored NFET 540, $NFET_{A4}$, a sixth mirrored NFET 542, $NFET_{A5}$, and a seventh mirrored NFET 543, $NFET_{A6}$.

The channel width of each of the first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, and the sixth mirrored NFET 542, $NFET_{A5}$ are binary weighted or configured such that the current carrying capacity of the second mirrored NFET 534, $NFET_{A1}$, is substantially twice the current carrying capacity of the first mirrored NFET 532, $NFET_{A0}$, the current carrying capacity of the third mirrored NFET 536, $NFET_{A2}$ is substantially twice the current carrying capacity of the second mirrored NFET 534, $NFET_{A1}$, the current carrying capacity of the fourth mirrored NFET 538, $NFET_{A3}$ is substantially twice the current carrying capacity of the third mirrored NFET 536, $NFET_{A2}$, the current carrying capacity of the fifth mirrored NFET 540, $NFET_{A4}$, is substantially twice the current carrying capacity of the fourth mirrored NFET 538, $NFET_{A3}$, and the current carrying capacity of the sixth mirrored NFET 542, $NFET_{A5}$ is substantially twice the current carrying capacity of the fifth mirrored NFET 540, $NFET_{A4}$. The channel width of the seventh mirrored NFET 543, $NFET_{A6}$ is configured relative to the channel width of the first push-pull output NFET 488, $NFET_A$, to provide an $I_{COR}$ offset sink current carrying capacity for the substantially symmetric $I_{COR}$ current push-pull output stage 493 of the operational amplifier controlled $I_{COR}$ current circuit 470.

Furthermore, the channel width of each of the first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, the sixth mirrored NFET 542, $NFET_{A5}$, and the seventh mirrored NFET 543, $NFET_{A6}$, is configured such that the current carrying capacity of each of the first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, the sixth mirrored NFET 542, $NFET_{A5}$, and the seventh mirrored NFET 543, $NFET_{A6}$, substantially matches the respective current carrying capacity of the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, the sixth mirrored PFET 504, $PFET_{A5}$ and the seventh mirrored PFET 506, $PFET_{A6}$.

Accordingly, the respective channel widths of the first mirrored PFET 494, $PFET_{A0}$, and the first mirrored NFET 532, $NFET_{A0}$, are configured such that the current sourcing capacity of the first mirrored PFET 494, $PFET_{A0}$, is substantially matched to the current sinking capacity of the first mirrored NFET 532, $NFET_{A0}$. The respective channel widths of the second mirrored PFET 496, $PFET_{A1}$, and the second mirrored NFET 534, $NFET_{A1}$, are configured such that the current sourcing capacity of the second mirrored PFET 496, $PFET_{A1}$, is substantially matched to the current sinking capacity of the second mirrored NFET 534, $NFET_{A1}$. The respective channel widths of the third mirrored PFET 498, $PFET_{A2}$, and the third mirrored NFET 536, $NFET_{A2}$, are configured such that the current sourcing capacity of the third mirrored PFET 498, $PFET_{A2}$, is substantially matched to the current sinking capacity of the third mirrored NFET 536, $NFET_{A2}$. The respective channel widths of the fourth mirrored PFET 500, $PFET_{A3}$, and the fourth mirrored NFET 538, $NFET_{A3}$, are configured such that the current sourcing capacity of the fourth mirrored PFET 500, $PFET_{A3}$, is substantially matched to the current sinking capacity of the fourth mirrored NFET 538, $NFET_{A3}$. The respective channel widths of the fifth mirrored PFET 502, $PFET_{A4}$, and the fifth mirrored NFET 540, $NFET_{A4}$, are configured such that the current sourcing capacity of the fifth mirrored PFET 502, $PFET_{A4}$, is substantially matched to the current sinking capacity of the fifth mirrored NFET 540, $NFET_{A4}$. The respective channel widths of the sixth mirrored PFET 504, $PFET_{A5}$, and the sixth mirrored NFET 542, $NFET_{A5}$, are configured such that the current sourcing capacity of the sixth mirrored PFET 504, $PFET_{A5}$, is substantially matched to the current sinking capacity of the sixth mirrored NFET 542, $NFET_{A5}$. And, the respective channel widths of the seventh mirrored PFET 506, $PFET_{A6}$, and the seventh mirrored NFET 543, $NFET_{A6}$, are configured such that the current sourcing capacity of the seventh mirrored PFET 506, $PFET_{A6}$, is substantially matched to the current sinking capacity of the seventh mirrored NFET 543, $NFET_{A6}$.

The programmable array of mirrored sink current elements 492 may further include a first control mirrored NFET 544, $NFET_{CN0}$, a second control mirrored NFET 546, $NFET_{CN1}$, a third control mirrored NFET 548, $NFET_{CN2}$, a fourth control mirrored NFET 550, $NFET_{CN3}$, a fifth control mirrored NFET 552, $NFET_{CN4}$, and a sixth control mirrored NFET 554, $NFET_{CN5}$. As further depicted in Figure 10A, the programmable array of mirrored sink current elements 492 may further include or be coupled to the $I_{COR}$ sink current weight control bus 480, CNTR_CN_BUS (5:0). The $I_{COR}$ sink current weight control bus 480, CNTR_CN_BUS (5:0) includes a first control mirrored NFET signal 556, CNTR_CN0, a second control mirrored NFET signal 558, CNTR_CN1, a third control mirrored NFET signal 560, CNTR_CN2, a fourth control mirrored NFET signal 562, CNTR_CN3, a fifth control mirrored NFET signal 564, CNTR_CN4, and a sixth control mirrored NFET signal 566, CNTR_CN5.

The first control mirrored NFET signal 556, CNTR_CN0, the second control mirrored NFET signal 558, CNTR_CN1, the third control mirrored NFET signal 560, CNTR_CN2, the fourth control mirrored NFET signal 562, CNTR_CN3, the fifth control mirrored NFET signal 564, CNTR_CN4, and the sixth control mirrored NFET signal 566, CNTR_CN5 are respectively coupled to and configured so as to control the gate of each of the first control mirrored NFET 544, $NFET_{CN0}$, the second control mirrored NFET 546, $NFET_{CN1}$, the third control mirrored NFET 548, $NFET_{CN2}$, the fourth control mirrored NFET 550, $NFET_{CN3}$, the fifth control mirrored NFET 552, $NFET_{CN4}$, and the sixth control mirrored NFET 554, $NFET_{CN5}$.

Accordingly, as will be described in further detail below, the programmable array of mirrored sink current elements 492 includes the first control mirrored NFET 544, $NFET_{CN0}$, a second control mirrored NFET 546, $NFET_{CN1}$, a third control mirrored NFET 548, $NFET_{CN2}$, a fourth control mirrored NFET 550, $NFET_{CN3}$, a fifth control mirrored NFET 552, $NFET_{CN4}$, and a sixth control mirrored NFET 554, $NFET_{CN5}$, that are respectively combined with the first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, and the sixth mirrored NFET 542, $NFET_{A5}$ in order to form a first programmable mirrored sink current element 532A, a second programmable mirrored sink current element 534A, a third programmable mirrored sink current element 536A, a fourth programmable mirrored sink current element 538A, a fifth programmable mirrored sink current element 540A, and a sixth programmable mirrored sink current element 542A.

The programmable array of mirrored sink current elements 492 of the substantially symmetric push-pull output stage 489 will now be described. The gate of each of the first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, the sixth mirrored NFET 542, $NFET_{A5}$, and the seventh mirrored NFET 543, $NFET_{A6}$ are each coupled to the output stage $NFET_A$ control signal 476 such that the each of the first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, the sixth mirrored NFET 542, $NFET_{A5}$, and the seventh mirrored NFET 543, $NFET_{A6}$ is current mirrored to the first push-pull output NFET 488, $NFET_A$, of the operational amplifier push-pull output stage circuit 468. As a result, the gate voltage for each of the first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, the sixth mirrored NFET 542, $NFET_{A5}$, and the seventh mirrored NFET 543, $NFET_{A6}$ is substantially set equal to the $NFET_A$ control voltage, $V_{NFET\_A\_CNTR}$.

The programmable array of mirrored sink current elements 492 includes the first programmable mirrored sink current element 532A, the second programmable mirrored sink current element 534A, the third programmable mirrored sink current element 536A, the fourth programmable mirrored sink current element 538A, the fifth programmable mirrored sink current element 540A, and the sixth programmable mirrored sink current element 542A, where the current carrying capacity of the first programmable mirrored sink current element 532A, the second programmable mirrored sink current element 534A, the third programmable mirrored sink current element 536A, the fourth programmable mirrored sink current element 538A, the fifth programmable mirrored sink current element 540A, and the sixth programmable mirrored sink current element 542A are substantially binary weighted. The current contribution of each of the first programmable mirrored sink current element 532A, the second programmable mirrored sink current element 534A, the third programmable mirrored sink current element 536A, the fourth programmable mirrored sink current element 538A, the fifth programmable mirrored sink current element 540A, and the sixth programmable mirrored sink current element 542A to form the high frequency ripple compensation current 416, $I_{COR}$, is governed by the controller 50 via the $I_{COR}$ sink current weight control bus 480, CNTR_CN_BUS (5:0).

The first programmable mirrored sink current element 532A includes the first mirrored NFET 532, $NFET_{A0}$, and is formed by coupling the source of the first mirrored NFET 532, $NFET_{A0}$, to ground and the drain of the first mirrored NFET 532, $NFET_{A0}$, to the source of the first control mirrored NFET 544, $NFET_{CN0}$. The drain of the first control mirrored NFET 544, $NFET_{CN0}$, is coupled to the operational amplifier controlled $I_{COR}$ current output 470A. The gate of the first control mirrored NFET 544, $NFET_{CN0}$, is coupled to the first control mirrored NFET signal 556, CNTR_CN0, such that the controller 50 may control the operation state (on/off) of the first programmable mirrored sink current element 532A. The second programmable mirrored sink current element 534A includes the second mirrored NFET 534, $NFET_{A1}$, and is formed by coupling the source of the second mirrored NFET 534, $NFET_{A1}$, to ground, and the drain of the second mirrored NFET 534, $NFET_{A1}$, to the source of the second control mirrored NFET 546, $NFET_{CN1}$. The drain of the second control mirrored NFET 546, $NFET_{CN1}$, is coupled to the operational amplifier controlled $I_{COR}$ current output 470A. The gate of the second control mirrored NFET 546, $NFET_{CN1}$, is coupled to the second control mirrored NFET signal 558, CNTR_CN1, such that the controller 50 may control the operation state (on/off) of the second programmable mirrored sink current element 534A. The third programmable mirrored sink current element 536A includes the third mirrored NFET 536, $NFET_{A2}$, and is formed by coupling the source of the third mirrored NFET 536, $NFET_{A2}$, to ground, and the drain of the third mirrored NFET 536, $NFET_{A2}$, to the source of the third control mirrored NFET 548, $NFET_{CN2}$. The drain of the third control mirrored NFET 548, $NFET_{CN2}$, is coupled to the operational amplifier controlled $I_{COR}$ current output 470A. The gate of the third control mirrored NFET 548, $NFET_{CN2}$, is coupled to the third control mirrored NFET signal 560, CNTR_CN2, such that the controller 50 may control the operation state (on/off) of the third programmable mirrored sink current element 536A. The fourth programmable mirrored sink current element 538A includes the fourth mirrored NFET 538, $NFET_{A3}$, and is formed by coupling the source of the fourth mirrored NFET 538, $NFET_{A3}$, to ground, and the drain of the fourth mirrored NFET 538, $NFET_{A3}$, to the source of the fourth control mirrored NFET 550, $NFET_{CN3}$. The drain of the fourth control mirrored NFET 550, $NFET_{CN3}$ is coupled to the operational amplifier controlled $I_{COR}$ current output 470A. The gate of the fourth control mirrored NFET 550, $NFET_{CN3}$, is coupled to the fourth control mirrored NFET signal 562, CNTR_CN3, such that the controller 50 may control the operation state (on/off) of the fourth programmable mirrored sink current element 538A. The fifth programmable mirrored sink current element 540A includes the fifth mirrored NFET 540, $NFET_{A4}$, and is formed by coupling the source of the fifth mirrored NFET 540, $NFET_{A4}$, to ground, and the drain of the fifth mirrored NFET 540, $NFET_{A4}$, to the source of the fifth control mirrored NFET 552, $NFET_{CN4}$. The drain of the fifth control mirrored NFET 552, $NFET_{CN4}$ is coupled to the operational amplifier controlled $I_{COR}$ current output 470A. The gate of the fifth control mirrored NFET 552, $NFET_{CN4}$, is coupled to the fifth control mirrored NFET signal 564, CNTR_CN4, such that the controller 50 may control the operation state (on/off) of the fifth programmable mirrored sink current element 540A. The sixth programmable mirrored sink current element 542A includes the sixth mirrored NFET 542, $NFET_{A5}$, and is formed by coupling the source of the sixth mirrored NFET 542, $NFET_{A5}$, to ground, and the drain of the sixth mirrored NFET 542, $NFET_{A5}$, to the source of the sixth control mirrored NFET 554, $NFET_{CN5}$. The drain of the sixth control mirrored NFET 554, $NFET_{CN5}$ is coupled to the operational amplifier controlled $I_{COR}$ current output 470A. The gate of the sixth control mirrored NFET 554, $NFET_{CN5}$, is coupled to the sixth control mirrored NFET signal 566, CNTR_CN5, such that the controller 50 may control the operation state (on/off) of the sixth programmable mirrored sink current element 542A.

The substantially symmetric $I_{COR}$ current push-pull output stage 493 may include the seventh mirrored PFET 506, $PFET_{A6}$, and the seventh mirrored NFET 543, $NFET_{A6}$. As described above, the respective channel widths of the seventh mirrored PFET 506, $PFET_{A6}$, and the seventh mirrored NFET 543, $NFET_{A6}$, are configured such that the current sourcing capacity of the seventh mirrored PFET 506, $PFET_{A6}$, is substantially matched to the current sinking capacity of the seventh mirrored NFET 543, $NFETA_6$. As a result, the substantially symmetric $I_{COR}$ current push-pull output stage 493 may provide an $I_{COR}$ offset current carrying capacity when the programmable array of mirrored source current elements 490 and the programmable array of mirrored sink current elements 492 are disabled or turned off. Because the channel widths of the seventh mirrored PFET 506, $PFET_{A6}$ and the seventh mirrored NFET 543, $NFET_{A6}$, are configured such that the current carrying capacity of the seventh mirrored PFET 506, $PFET_{A6}$, matches the seventh mirrored NFET 543, $NFET_{A6}$, the $I_{COR}$ offset current carrying capacity is governed by the ratio of the channel width of the seventh mirrored PFET 506, $PFET_{A6}$, to the first push-pull output PFET 486, $PFET_A$, and the ratio of the channel width of the seventh mirrored NFET 543, $NFET_{A6}$, to the first push-pull output NFET 488, $NFET_A$,

To maintain symmetric operation of the substantially symmetric $I_{COR}$ current push-pull output stage 493, the controller 50 controls the $I_{COR}$ source current weight control bus 478, CNTR_CP_BUS (5:0), and the $I_{COR}$ sink current weight control bus 480, CNTR_CN_BUS (5:0), such that the operational state of the first programmable mirrored source current element 494A follows the operational state of the corresponding first programmable mirrored sink current element 532A, the operational state of the second programmable mirrored source current element 496A follows the operational state of the corresponding second programmable mirrored sink current element 534A, the operational state of the third programmable mirrored source current element 498A follows the operational state of the corresponding third programmable mirrored sink current element 536A, the operational state of the fourth programmable mirrored source current element 500A follows the operational state of the corresponding fourth programmable mirrored sink current element 538A, the operational state of the fifth programmable mirrored source current element 502A follows the operational state of the corresponding fifth programmable mirrored sink current element 540A, and the operational state of the sixth programmable mirrored source current element 504A follows the operational state of the corresponding sixth programmable mirrored sink current element 542A.

In the case where the controller 50 configures the $I_{COR}$ source current weight control bus 478, CNTR_CP_BUS (5:0), and the $I_{COR}$ sink current weight control bus 480, CNTR_CN_BUS (5:0), to turn off the first programmable mirrored source current element 494A, the second programmable mirrored source current element 496A, the third programmable mirrored source current element 498A, the fourth programmable mirrored source current element 500A, the fifth programmable mirrored source current element 502A, the sixth programmable mirrored source current element 504A, the first programmable mirrored sink current element 532A, the second programmable mirrored sink current element 534A, the third programmable mirrored sink current element 536A, the fourth programmable mirrored sink current element 538A, the fifth programmable mirrored sink current element 540A, and the sixth programmable mirrored sink current element 542A. The substantially symmetric $I_{COR}$ current push-pull output stage 493 provides the $I_{COR}$ offset current capacity as the output of the substantially symmetric push-pull output stage 489 of the operational amplifier controlled $I_{COR}$ current circuit 470.

The programmable $I_{COR}$ transconductance, $Gm_{ICOR}$, of the operational amplifier controlled $I_{COR}$ current circuit 470 may now be described. For the sake of simplicity of the description, and not by way of limitation, the first push-pull output PFET 486, $PFET_A$, and the first push-pull output NFET 488, $NFET_A$, of the operational amplifier push-pull output stage circuit 468 are used as a reference transistor such that the characteristics of the first mirrored PFET 494, $PFET_{A0}$, are similar to the characteristics of the first push-pull output PFET 486, $PFET_A$, and the characteristics of the first mirrored NFET 532, $NFET_{A0}$, are similar to the characteristics of the first push-pull output NFET 488, $NFET_A$. As previously discussed, the relative channel widths of the first push-pull output PFET 486, $PFET_A$, and the first push-pull output NFET 488, $NFET_A$, to the channel widths of the first mirrored PFET 494, $PFET_{A0}$, and the first mirrored NFET 532, $NFET_{A0}$, may be configured to obtain a desired proportionality between the high frequency ripple compensation current 416, $I_{COR}$, to the operational amplifier output current, $I_{AMP}$.

The individual control signals of the $I_{COR}$ source current weight control bus 478, CNTR_CP_BUS (5:0), and the $I_{COR}$ sink current weight control bus 480, CNTR_CN_BUS (5:0), may be characterized as corresponding to a six bit programmable control word CNTRN, where the least significant bit corresponds to the state of the CNTR_CP0 and CNTR_CN0, and the most significant bit corresponds to the state of CNTR_CP5 and CNTR_CN5. As a result, the six bit programmable control word CNTRN may be characterized as having the binary weighted values of between 0 and 63. Thus, the six bit programmable control word CNTRN may be characterized as the function CNTRN = P, such that $0 \le P \le 63$. Thus, the programmable $I_{COR}$ transconductance, $Gm_{ICOR}$, of the operational amplifier controlled $I_{COR}$ current circuit 470 may be characterized by equation (7) as follows:

$$(7) \qquad Gm_{ICOR}(P) = \frac{(P + P_{OFFSET})}{R_0},$$

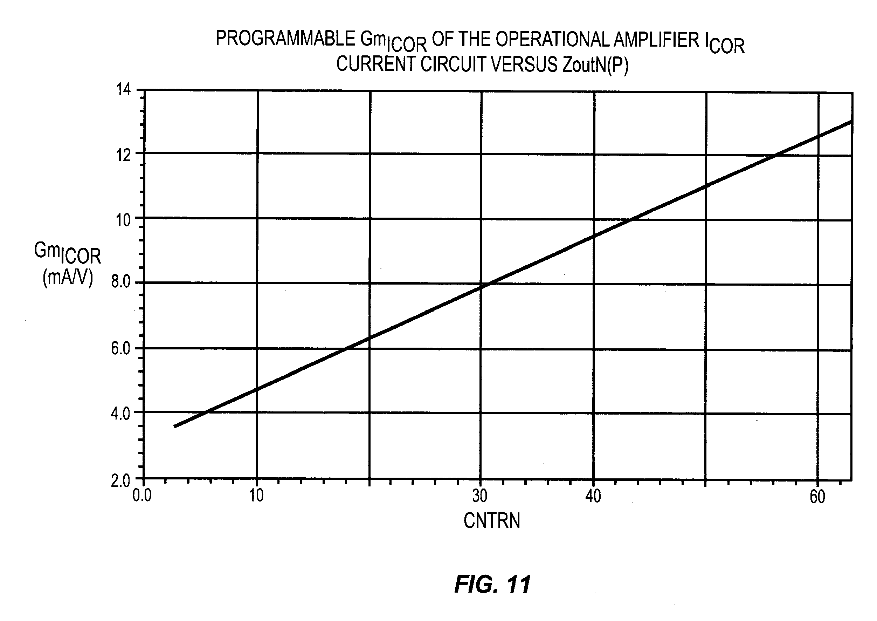

where $P_{OFFSET}$ reflects the contribution of the substantially symmetric $I_{COR}$ current push-pull output stage 493. Figure 11 depicts the programmable $I_{COR}$ transconductance $Gm_{ICOR}$ of the operational amplifier controlled $I_{COR}$ current circuit 470 versus the value (P) of the six bit programmable control word, CNTRN. In some embodiments, the channel width ratio of the seventh mirrored PFET 506, $PFET_{A6}$ to the channel width of the seventh mirrored NFET 543, $NFET_{A6}$ may be configured such that $P_{OFFSET}$ has a minimum value of around 20. In the case where $P_{OFFSET} = 20$, the minimum programmable $I_{COR}$ transconductance $Gm_{ICCR\_MIN} = 20/R_0$, where $R_0$ is the bias resistance of the bias resistor 452 of the Gm bias circuit 444, depicted in Figure 10C.

Furthermore, relative channel widths of the first mirrored PFET 494, $PFET_{A0}$, the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, the sixth mirrored PFET 504, $PFET_{A5}$, and the seventh mirrored PFET 506, $PFET_{A6}$, to the channel width of the first push-pull output PFET 486, $PFET_A$, and the relative channel widths of first mirrored NFET 532, $NFET_{A0}$, the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, the sixth mirrored NFET 542, $NFET_{A5}$, and the seventh mirrored NFET 543, $NFET_{A6}$, to the first push-pull output NFET 488, $NFET_A$, may be adjusted such that the operational amplifier output current, $I_{AMP}$, is proportional to the high frequency ripple compensation current 416, $I_{COR}$. It will be appreciated that when the operational amplifier controlled $I_{COR}$ current circuit 470 is configured to have the minimum programmable $I_{COR}$ transconductance $Gm_{ICOR\_MIN}$, the high frequency ripple compensation current 416, $I_{COR}$, is sourced only by the substantially symmetric $I_{COR}$ current push-pull output stage 493.

Typically, the ratio of the channel width of the first push-pull output PFET 486, $PFET_A$, to the channel width of the first mirrored PFET 494, $PFET_{A0}$, and the ratio of the channel width of the first push-pull output NFET 488, $NFET_A$, to the channel width of the first mirrored NFET 532, $NFET_{A0}$, is approximately set to one. However, in some embodiments, the ratio of the channel width of the first push-pull output PFET 486, $PFET_A$, to the channel width of the first mirrored PFET 494, $PFET_{A0}$, and the ratio of the channel width of the first push-pull output NFET 488, $NFET_A$, to the channel width of the first mirrored NFET 532, $NFET_{A0}$, may be greater than one or less than one. For example, in the case where the ratio of the channel width of the first push-pull output PFET 486, $PFET_A$, to the channel width of the first mirrored PFET 494, $PFET_{A0}$, and the ratio of the channel width of the first push-pull output NFET 488, $NFET_A$, to the channel width of the first mirrored NFET 532, $NFET_{A0}$, is less than one, the bias resistance, $R_0$, of the bias resistor 452, depicted in Figure 10C, may be increased to obtain the same value of the programmable $I_{COR}$ transconductance, $Gm_{ICOR}$, of the operational amplifier controlled $I_{COR}$ current circuit 470, depicted in Figure 10A, and reduce the Gm bias current, $I_{Gm\_BIAS}$. However, this may reduce the operational bandwidth of the operational amplifier 442.

Figure 11 depicts a graphical representation of the programmable $I_{COR}$ transconductance, $Gm_{ICOR}$, of the operational amplifier controlled $I_{COR}$ current circuit 470 provided at the operational amplifier controlled $I_{COR}$ current output 470A as a function of the six bit programmable control word, CNTRN, formed by the bits of the $I_{COR}$ source current weight control bus 478, CNTR_CP_BUS (5:0), and the $I_{COR}$ sink current weight control bus 480, CNTR_CN_BUS (5:0). The six bit programmable control word, CNTRN, may be characterized as having the binary weighted values equal to "P" such that $0 \le P \le 63$. As depicted in Figure 11, the programmable $I_{COR}$ transconductance, $Gm_{ICOR}$, is substantially linear with respect to "P" for $0 \le P \le 63$. The minimum programmable $I_{COR}$ transconductance $Gm_{ICOR-MIN}$, corresponds to the value of $Gm_{ICOR}(0)$. In other words, the programmable $I_{COR}$ transconductance, $Gm_{ICOR}$, of the operational amplifier controlled $I_{COR}$ current circuit 470 may be configured to provide 64 transconductance values.

The embodiment of the operational amplifier controlled $I_{COR\_SENSE}$ current circuit 472, depicted in Figure 10B, is similar in form and function to the embodiment of the operational amplifier controlled $I_{COR}$ current circuit 470 depicted in Figure 10A. Similar to the operational amplifier controlled $I_{COR}$ current circuit 470, the operational amplifier controlled $I_{COR\_SENSE}$ current circuit 472 may be configured as an array of mirrored transistor elements arranged to form a substantially symmetric push-pull output stage 567 for providing the scaled high frequency ripple compensation current estimate 418, $I_{COR\_SENSE}$. The substantially symmetric push-pull output stage 567 may include a programmable array of mirrored sense source current elements 568 and a programmable array of mirrored sense sink current elements 570 coupled to form a substantially symmetric programmable $I_{COR\_SENSES}$ push-pull output stage 569. Each of the mirrored transistor elements in the programmable array of mirrored sense source current elements 568 is associated with a corresponding transistor element of the mirrored transistor elements in the programmable array of mirrored sense sink current elements 570.

The substantially symmetric programmable $I_{COR\_SENSES}$ push-pull output stage 569 may further include mirrored transistor elements configured to form a substantially symmetric $I_{COR\_SENSE}$ current push-pull output stage 571. The substantially symmetric $I_{COR\_SENSE}$ current push-pull output stage 571 may be configured to provide an $I_{COR\_SENSE}$ offset current carrying capacity in the case when the programmable array of mirrored sense source current elements 568 and the programmable array of mirrored sense sink current elements 570 are disabled or turned off. Accordingly, the substantially symmetric $I_{COR\_SENSE}$ current push-pull output stage 571 complements the operation of the substantially symmetric $I_{COR}$ current push-pull output stage 493. Accordingly, as will be described, the minimum $I_{COR\_SENSE}$ transconductance, $Gm_{ICOR\_SENSE\_MIN}$ of the operational amplifier controlled $I_{COR\_SENSE}$ current circuit 472 is scaled by the sense scaling factor, $C_{SENSE\_SCALING}$, such that $Gm_{ICOR-SENCE-MIN} = Gm_{ICOR-MIN\,x}\,C_{SENSE\_SCALING}$.

However, by way of example and not by limitation, unlike the substantially symmetric programmable push-pull output stage 491 of the operational amplifier controlled $I_{COR}$ current circuit 470, depicted in Figure 10A, which includes six programmable sense mirrored source current elements and six programmable sense mirrored sink current elements, as will be described, the embodiment of the substantially symmetric programmable $I_{COR\_SENSES}$ push-pull output stage 569 of the operational amplifier controlled $I_{COR\_SENSE}$ current circuit 472, depicted in Figure 10B, includes five programmable sense mirrored source current elements and five corresponding programmable sense mirrored sink current elements. In addition, the channel widths of the sense mirrored transistor elements of the operational amplifier controlled $I_{COR-SENSE}$ current circuit 472 may be scaled by the sense scaling factor, $C_{SENSE\_SCALING}$, such that the scaled high frequency ripple compensation current estimate 418, $I_{COR\_SENSE}$, generated by the operational amplifier controlled $I_{COR\_SENSE}$ current circuit 472, is a fractional representation of the high frequency ripple compensation current 416, $I_{COR}$, generated by the operational amplifier controlled $I_{COR}$ current circuit 470. For example, in some embodiments of the operational amplifier controlled $I_{COR\_SENSE}$ current circuit 472, the sense scaling factor, $C_{SENSE-SCAUNG}$, is 1/20. In other words, the magnitude of the high frequency ripple compensation current 416, $I_{COR}$, is substantially linearly related to the scaled high frequency ripple compensation current estimate 418, $I_{COR\_SENSE}$, by the sense scaling factor, $C_{SENCE\_SCALING}$, such that $I_{COR} = I_{COR\_SENSE}\,x\,C_{SENSE\_SCALING}$.

In addition, as described above, in some embodiments of the operational amplifier controlled $I_{COR\_SENSE}$ current circuit 472, the programmable array of mirrored sense source current elements 568 and the programmable array of mirrored sense sink current elements 570 may each have fewer mirrored transistor elements than the programmable array of mirrored source current elements 490 and the programmable array of mirrored sink current elements 492 of the operational amplifier controlled $I_{COR}$ current circuit 470. For example, because the embodiment of the operational amplifier controlled $I_{COR\_SENSE}$ current circuit 472, depicted in Figure 10B, only includes five programmable sense mirrored source current elements and five corresponding programmable sense mirrored sink current elements, changes in the magnitude of the current of the high frequency ripple compensation current 416, $I_{COR}$, due to the operation of the first programmable mirrored source current element 494A and the first programmable mirrored sink current element 532A are not represented by a corresponding change in the magnitude of current of the scaled high frequency ripple compensation current estimate 418, $I_{COR\_SENSE}$.

The substantially symmetric push-pull output stage 567 may include a first sense mirrored PFET 572, $PFET_{S1}$, a second sense mirrored PFET 574, $PFET_{S2}$, a third sense mirrored PFET 576, $PFET_{S3}$, a fourth sense mirrored PFET 578, $PFET_{S4}$, a fifth sense mirrored PFET 580, $PFET_{S5}$, and a sixth sense mirrored PFET 582, $PFET_{S6}$. The respective channel widths of each of the first sense mirrored PFET 572, $PFET_{S1}$, the second sense mirrored PFET 574, $PFET_{S2}$, the third sense mirrored PFET 576, $PFET_{S3}$, the fourth sense mirrored PFET 578, $PFET_{S4}$, and the fifth sense mirrored PFET 580, $PET_{S5}$, may be configured such that the current carrying capacity of each one of the first sense mirrored PFET 572, $PFET_{S1}$, the second sense mirrored PFET 574, $PET_{S2}$, the third sense mirrored PFET 576, $PFET_{S3}$, the fourth sense mirrored PFET 578, $PFET_{S4}$, and the fifth sense mirrored PFET 580, $PFET_{S5}$, is fractionally related to the current carrying capacity of the second mirrored PFET 496, $PFET_{A1}$, the third mirrored PFET 498, $PFET_{A2}$, the fourth mirrored PFET 500, $PFET_{A3}$, the fifth mirrored PFET 502, $PFET_{A4}$, and the sixth mirrored PFET 504, $PFET_{A5}$, of the operational amplifier controlled $I_{COR}$ current circuit 470, respectively, by the sense scaling factor, $C_{SENSE\_SCALING}$. In other words, the channel widths of the transistor elements of the programmable array of mirrored sense source current elements 568 of the operational amplifier controlled $I_{COR\_SENSE}$ current circuit 472 are configured such that the current providing capacity of the programmable array of mirrored sense source current elements 568 is fractionally related to the current providing capacity of the programmable array of mirrored source current elements 490 of the operational amplifier controlled $I_{COR}$ current circuit 470. As an example, the channel width of the first sense mirrored PFET 572, $PFET_{S1}$, may be substantially related to the channel width of the second mirrored PFET 496, $PFET_{A1}$, as a function of the sense scaling factor, $C_{SENSE-SCALING}$. The channel width of the second sense mirrored PFET 574, $PFET_{S2}$, may be substantially related to the channel width of the third mirrored PFET 498, $PFET_{A2}$, as a function of the sense scaling factor, $C_{SENSE\_SCALING}$. The channel width of the third sense mirrored PFET 576, $PFET_{S3}$, may be substantially related to the channel width of the fourth mirrored PFET 500, $PFET_{A3}$, as a function of the sense scaling factor, $C_{SENSE\_SCALING}$.

The channel width of the fourth sense mirrored PFET 578, $PFET_{S4}$, may be substantially related to the channel width of the fifth mirrored PFET 502, $PFET_{A4}$, as a function of the sense scaling factor, $C_{SENSE\_SCALING}$. The channel width of the fifth sense mirrored PFET 580, $PFET_{S5}$, may be substantially related to the channel width of the sixth mirrored PFET 504, $PFET_{A5}$, as a function of the sense scaling factor, $C_{SENSE\_SCALING}$. As a result, the current carrying capacity of the first sense mirrored PFET 572, $PFET_{S1}$, the second sense mirrored PFET 574, $PFET_{S2}$, the third sense mirrored PFET 576, $PFET_{S3}$, the fourth sense mirrored PFET 578, $PFET_{S4}$, the fifth sense mirrored PFET 580, $PFET_{S5}$, are also configured to be substantially binary weighted. For example, the channel width of the mirrored source transistor elements of the programmable array of mirrored sense source current elements 568 may be configured such that the current carrying capacity of the second sense mirrored PFET 574, $PFET_{S2}$, is substantially twice the current carrying capacity of the first sense mirrored PFET 572, $PFET_{S1}$, the current carrying capacity of the third sense mirrored PFET 576, $PFET_{S3}$ is substantially twice the current carrying capacity of the second sense mirrored PFET 574, $PFET_{S2}$, the current carrying capacity of the fourth sense mirrored PFET 578, $PFET_{S4}$ is substantially twice the current carrying capacity of the third sense mirrored PFET 576, $PFET_{S3}$, and the current carrying capacity of the fifth sense mirrored PFET 580, $PFET_{S5}$, is substantially twice the current carrying capacity of the fourth sense mirrored PFET 578, $PFET_{S4}$. As a result, the current carrying capacities of the transistor elements of the programmable array of mirrored sense source current elements 568 may be substantially related to the corresponding transistor elements of the programmable array of mirrored source current elements 490 of the operational amplifier controlled $I_{COR}$ current circuit 470 by the sense scaling factor, $C_{SENSE\_SCALING}$, in order to maintain the fractional relationship of the scaled high frequency ripple compensation current estimate 418, $I_{COR\_SENSE}$, generated by the operational amplifier control $I_{COR\_SENSE}$ current circuit 472, to the high frequency ripple compensation current 416, $I_{COR}$, generated by the operational amplifier controlled $I_{COR}$ current circuit 470.

The programmable array of mirrored sense source current elements 568 may further include a first control sense mirrored PFET 584, $PFET_{SP1}$, a second control sense mirrored PFET 586, $PFET_{SP2}$, a third control sense mirrored PFET 588, $PFET_{SP3}$, a fourth control sense mirrored PFET 590, $PFET_{SP4}$, and a fifth control sense mirrored PFET 592, $PFET_{SP5}$. The first control sense mirrored PFET 584, $PFET_{SP1}$, the second control sense mirrored PFET 586, $PFET_{SP2}$, the third control sense mirrored PFET 588, $PFET_{SP3}$, the fourth control sense mirrored PFET 590, $PFET_{SP4}$, and the fifth control sense mirrored PFET 592, $PFET_{SP5}$, may be used in conjunction with the first sense mirrored PFET 572, $PFET_{S1}$, the second sense mirrored PFET 574, $PET_{S2}$, the third sense mirrored PFET 576, $PFET_{S3}$, the fourth sense mirrored PFET 578, $PFET_{S4}$, the fifth sense mirrored PFET 580, $PFET_{S5}$, and the $I_{COR\_SENSE}$ source current weight control bus 482, CNTR_SP_BUS (5:1) to create a first control sense mirrored PFET 584, $PFET_{SP1}$, a second control sense mirrored PFET 586, $PFET_{SP2}$, a third control sense mirrored PFET 588, $PFET_{SP3}$, a fourth control sense mirrored PFET 590, $PFET_{SP4}$, and a fifth control sense mirrored PFET 592, $PFET_{SP5}$, respectively, to form a first programmable sense mirrored source current element 572A, a second programmable sense mirrored source current element 574A, a third programmable sense mirrored source current element 576A, a fourth programmable sense mirrored source current element 578A, and a fifth programmable sense mirrored source current element 580A.

As further depicted in Figure 10B, the programmable array of mirrored sense source current elements 568 may be operably coupled to the $I_{COR\_SENSE}$ source current weight control bus 482, CNTR_SP_BUS (5:1). The $I_{COR\_SENSE}$ source current weight control bus 482, CNTR_SP_BUS (5:1) may include a first control sense mirrored PFET signal 594, CNTR_SP1, coupled to the gate of the first control sense mirrored PFET 584, $PFET_{SP1}$, a second control sense mirrored PFET signal 596, CNTR_SP2, coupled to the gate of the second control sense mirrored PFET 586, $PFET_{SP2}$, a third control sense mirrored PFET signal 598, CNTR_SP3, coupled to the gate of the third control sense mirrored PFET 588, $PFET_{SP3}$, a fourth control sense mirrored PFET signal 600, CNTR_SP4, coupled to the gate of the fourth control sense mirrored PFET 590, $PFET_{SP4}$, and a fifth control sense mirrored PFET signal 602, CNTR_SP5, coupled to the gate of the fifth control sense mirrored PFET 592, $PFET_{SP5}$.

The first control sense mirrored PFET signal 594, CNTR_SP1, may be configured to control the operational state (ON/OFF) of the first control sense mirrored PFET 584, $PFET_{SP1}$. The second control sense mirrored PFET signal 596, CNTR_SP2, may be configured to control the operational state (ON/OFF) of the second control sense mirrored PFET 586, $PFET_{SP2}$. The third control sense mirrored PFET signal 598, CNTR_SP3, may be configured to control the operational state (ON/OFF) of the third control sense mirrored PFET 588, $PFET_{SP3}$. The fourth control sense mirrored PFET signal 600, CNTR_SP4, may be configured to control the operational state (ON/OFF) of the fourth control sense mirrored PFET 590, $PFET_{SP4}$. The fifth control sense mirrored PFET signal 602, CNTR_SP5 may be configured to control the operational state (ON/OFF) of the fifth control sense mirrored PFET 592, $PFET_{SP5}$.

The first programmable sense mirrored source current element 572A may be formed by coupling the source of the first sense mirrored PFET 572, $PFET_{S1}$, to the circuit supply voltage, $V_{DD}$, and the drain of the first sense mirrored PFET 572, $PFET_{S1}$, to the source of the first control sense mirrored PFET 584, $PFET_{SP1}$. The drain of the first control sense mirrored PFET 584, $PFET_{SP1}$, is coupled to the operational amplifier controlled $I_{COR\text{-}SENSE}$ current output 472A. The second programmable sense mirrored source current element 574A may be formed by coupling the source of the second sense mirrored PFET 574, $PFET_{S2}$, to the circuit supply voltage, $V_{DD}$, and the drain of the second sense mirrored PFET 574, $PFET_{S2}$, to the source of the second control sense mirrored PFET 586, $PFET_{SP2}$. The drain of the second control sense mirrored PFET 586, $PFET_{SP2}$, is coupled to the operational amplifier controlled $I_{COR\_SENSE}$ current output 472A. The third programmable sense mirrored source current element 576A, may be formed by coupling the source of the third sense mirrored PFET 576, $PFET_{S3}$, to the circuit supply voltage, $V_{DD}$, and the drain of the third sense mirrored PFET 576, $PFET_{S3}$, to the source of the third control sense mirrored PFET 588, $PFET_{SP3}$. The drain of the third control sense mirrored PFET 588, $PFET_{SP3}$, is coupled to the operational amplifier controlled $I_{COR\_SENSE}$ current output 472A. The fourth programmable sense mirrored source current element 578A may be formed by coupling the source of the fourth sense mirrored PFET 578, $PFET_{S4}$, to the circuit supply voltage, $V_{DD}$, and the drain of the fourth sense mirrored PFET 578, $PFET_{S4}$, to the source of the fourth control sense mirrored PFET 590, $PFET_{SP4}$. The drain of the fourth control sense mirrored PFET 590, $PFET_{SP4}$, is coupled to the operational amplifier controlled $I_{COR\_SENSE}$ current output 472A. The fifth programmable sense mirrored source current element 580A may be formed by coupling the source of the fifth sense mirrored PFET 580, $PFET_{S5}$, to the circuit supply voltage, $V_{DD}$, and the drain of the fifth sense mirrored PFET 580, $PFET_{S5}$, to the source of the fifth control sense mirrored PFET 592, $PFET_{SP5}$. The drain of the fifth control sense mirrored PFET 592, $PFET_{SP4}$, is coupled to the operational amplifier controlled $I_{COR\_SENSE}$ current output 472A.

The gate of each of the first sense mirrored PFET 572, $PFET_{S1}$, the second sense mirrored PFET 574, $PFET_{S2}$, the third sense mirrored PFET 576, $PFET_{S3}$, the fourth sense mirrored PFET 578, $PFET_{S4}$, the fifth sense mirrored PFET 580, $PFET_{S5}$, and the sixth sense mirrored PFET 582, $PET_{S6}$, is coupled to the output stage $PFET_A$ control signal 474 such that the each of the first sense mirrored PFET 572, $PFET_{S1}$, the second sense mirrored PFET 574, $PFET_{S2}$, the third sense mirrored PFET 576, $PFET_{S3}$, the fourth sense mirrored PFET 578, $PFET_{S4}$, the fifth sense mirrored PFET 580, PFET-S5, and the sixth sense mirrored PFET 582, $PFET_{S6}$, is current mirrored to the first push-pull output PFET 486, $PFET_A$, of the operational amplifier push-pull output stage circuit 468. As a result, the gate voltage for each of the first sense mirrored PFET 572, $PETS_1$, the second sense mirrored PFET 574, $PFET_{S2}$, the third sense mirrored PFET 576, $PFET_{S3}$, the fourth sense mirrored PFET 578, $PFET_{S4}$, the fifth sense mirrored PFET 580, $PFET_{S5}$, and the sixth sense mirrored PFET 582, $PFET_{S6}$, is substantially set equal to the $PFET_A$ control voltage, $V_{PFET\_A\_CNTR}$, provided by the output stage $PFET_A$ control signal 474.

Accordingly, the magnitude of the current provided by the first sense mirrored PFET 572, $PFET_{S1}$, the second sense mirrored PFET 574, $PFET_{S2}$, the third sense mirrored PFET 576, $PFET_{S3}$, the fourth sense mirrored PFET 578, $PFET_{S4}$, and the fifth sense mirrored PFET 580, $PFET_{S5}$, is governed by the $PFET_A$ control voltage, $V_{PFET\_A\_CNTR}$. The controller 50 may configure the $I_{COR\_SENSE}$ source current weight control bus 482, CNTR_SP_BUS (5:1), to selectively place the first programmable sense mirrored source current element 572A, the second programmable sense mirrored source current element 574A, the third programmable sense mirrored source current element 576A, the fourth programmable sense mirrored source current element 578A, and the fifth programmable sense mirrored source current element 580A, in an OFF state or an ON state to govern the contribution of current sourced by each of the first sense mirrored PFET 572, $PFET_{S1}$, the second sense mirrored PFET 574, $PFET_{S2}$, the third sense mirrored PFET 576, $PFET_{S3}$, the fourth sense mirrored PFET 578, $PFET_{S4}$, and the fifth sense mirrored PFET 580, $PFET_{S5}$, to form the scaled high frequency ripple compensation current estimate 418, $I_{COR-SENSE}$. Because the sixth sense mirrored PFET 582, $PFET_{S6}$, is not part of a programmable source current element, the sixth sense mirrored PFET 582, $PFET_{S6}$, sources current to the output of the operational amplifier controlled $I_{COR\_SENSE}$ current output 472A dependent upon the $PFET_A$ control voltage, $V_{PFET\_A\_CNTR}$. The current sourced by the sixth sense mirrored PFET 582, $PFET_{S6}$, may be used to provide the $I_{COR\_SENSE}$ offset current carrying capacity of the substantially symmetric $I_{COR\_SENSE}$ current push-pull output stage 571.

As a non-limiting example, the programmable array of mirrored sense sink current elements 570 may include fewer mirrored transistor elements than the programmable array of mirrored sink current elements 492 of the operational amplifier controlled $I_{COR}$ current circuit 470. However, in order for the substantially symmetric push-pull output stage 567 to be balanced, the programmable array of mirrored sense source current elements 568 and the programmable array of mirrored sense sink current elements 570 have complementary numbers of mirrored transistor elements. Accordingly, in the example embodiment of the operational amplifier controlled $I_{COR\_SENSE}$ current circuit 472, the substantially symmetric push-pull output stage 567 further includes a first sense mirrored NFET 604, $NFET_{S1}$, a second sense mirrored NFET 606, $NET_{S2}$, a third sense mirrored NFET 608, $NET_{S3}$, a fourth sense mirrored NFET 610, $NFET_{S4}$, a fifth sense mirrored NFET 612, $NFET_{S5}$, and a sixth sense mirrored NFET 614, $NFET_{S6}$. The first sense mirrored NFET 604, $NFET_{S1}$, the second sense mirrored NFET 606, $NET_{S2}$, the third sense mirrored NFET 608, $NFET_{S3}$, the fourth sense mirrored NFET 610, $NFET_{S4}$, and the fifth sense mirrored NFET 612, $NFET_{S5}$, may be configured to form the programmable array of mirrored sense sink current elements 570.

Similar to the substantially symmetric push-pull output stage 567, the channel widths of the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, and the sixth sense mirrored NFET 614, $NFET_{S6}$, are configured such that current carrying capacity of each one of the first sense mirrored NFET 604, $NET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, and the sixth sense mirrored NFET 614, $NET_{S6}$, is fractionally related to the current carrying capacity of the second mirrored NFET 534, $NFET_{A1}$, the third mirrored NFET 536, $NFET_{A2}$, the fourth mirrored NFET 538, $NFET_{A3}$, the fifth mirrored NFET 540, $NFET_{A4}$, the sixth mirrored NFET 542, $NFET_{A5}$, and the seventh mirrored NFET 543, $NFET_{A6}$, of the programmable array of mirrored sink current elements 492, respectively, by the sense scaling factor, $C_{SENSE\_SCALING}$.

In other words, the channel widths of the transistor elements of the programmable array of mirrored sense sink current elements 570 of the operational amplifier controlled $I_{COR\_SENSE}$ current circuit 472 are configured such that the current providing capacity of the programmable array of mirrored sense sink current elements 570 is fractionally related to the current providing capacity of the programmable array of mirrored sink current elements 492 of the operational amplifier controlled $I_{COR}$ current circuit 470. As an example, the channel width of the first sense mirrored NFET 604, $NET_{S1}$, may be substantially related to the channel width of the second mirrored NFET 534, $NFET_{A1}$, as a function of the sense scaling factor, $C_{SENSE\_SCALING}$. The channel width of the second sense mirrored NFET 606, $NFET_{S2}$, may be substantially related to the channel width of the third mirrored NFET 536, $NFET_{A2}$, as a function of the sense scaling factor, $C_{SENSE\_SCALING}$. The channel width of the third sense mirrored NFET 608, $NFET_{S3}$, may be substantially related to the channel width of the fourth mirrored NFET 538, $NFET_{A3}$, as a function of the sense scaling factor, $C_{SENSE\_SCALING}$. The channel width of the fourth sense mirrored NFET 610, $NFET_{S4}$, may be substantially related to the channel width of the fifth mirrored NFET 540, $NFET_{A4}$, as a function of the sense scaling factor, $C_{SENSE\_SCALING}$. The channel width of the fifth sense mirrored NFET 612, $NFET_{S5}$, may be substantially related to the channel width of the sixth mirrored NFET 542, $PFET_{A5}$, as a function of the sense scaling factor, $C_{SENSE\_SCALING}$.

As a result, the current carrying capacity of the second sense mirrored NFET 606, $NFET_{S2}$, is substantially twice the current carrying capacity of the first sense mirrored NFET 604, $NET_{S1}$, the current carrying capacity of the third sense mirrored NFET 608, $NFET_{S3}$ is substantially twice the current carrying capacity of the second sense mirrored NFET 606, $NFET_{S2}$, the current carrying capacity of the fourth sense mirrored NFET 610, $NFET_{S4}$ is substantially twice the current carrying capacity of the third sense mirrored NFET 608, $NFET_{S3}$, and the current carrying capacity of the fifth sense mirrored NFET 612, $NFET_{S5}$, is substantially twice the current carrying capacity of the fourth sense mirrored NFET 610, $NFET_{S4}$. Thus the channel widths of the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, are substantially configured to sink binary weighted current.

As a result, similar to the programmable array of mirrored sense source current elements 568, the current carrying capacities of the transistor elements of the programmable array of mirrored sense sink current elements 570 may be substantially related to the corresponding transistor elements of the programmable array of mirrored sink current elements 492 of the operational amplifier controlled $I_{COR}$ current circuit 470 by the sense scaling factor, $C_{SENSE-SCALING}$, in order to maintain the fractional relationship of the scaled high frequency ripple compensation current estimate 418, $I_{COR\_SENSE}$, generated by the operational amplifier control $I_{COR\_SENSE}$ current circuit 472, to the high frequency ripple compensation current 416, $I_{COR}$, generated by the operational amplifier controlled $I_{COR}$ current circuit 470.

The programmable array of mirrored sense sink current elements 570 may further include a first control sense mirrored NFET 616, $NFET_{SN1}$, a second control sense mirrored NFET 618, $NFET_{SN2}$, a third control sense mirrored NFET 620, $NFET_{SN3}$, a fourth control sense mirrored NFET 622, $NFET_{SN4}$, and a fifth control sense mirrored NFET 624, $NFET_{SN5}$. The first control sense mirrored NFET 616, $NFET_{SN1}$, the second control sense mirrored NFET 618, $NFET_{SN2}$, the third control sense mirrored NFET 620, $NFET_{SN3}$, the fourth control sense mirrored NFET 622, $NFET_{SN4}$, and the fifth control sense mirrored NFET 624, $NFET_{SN5}$, may be used in conjunction with the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, and the $I_{COR\_SENSE}$ sink current weight control bus 484, CNTR_SN_BUS (5:1) to form a first programmable sense mirrored sink current element 604A, a second programmable sense mirrored sink current element 606A, a third programmable sense mirrored sink current element 608A, a fourth programmable sense mirrored sink current element 610A, and a fifth programmable sense mirrored sink current element 612A.

In some alternative embodiments of the operational amplifier circuitry 440A, portions of the $I_{COR\_SENSE}$ source current weight control bus 482, CNTR_SP_BUS (5:1), the $I_{COR\_SENSE}$ sink current weight control bus 484, CNTR_SN_BUS (5:1), the $I_{COR}$ source current weight control bus 478, CNTR_CP_BUS (5:0), and the $I_{COR}$ sink current weight control bus 480, CNTR_CN_BUS (5:0) may be combined to form a single control bus that controls both the operational amplifier controlled $I_{GOR}$ current circuit 470 and the operational amplifier controlled $I_{COR\_SENSE}$ current circuit 472.

As further depicted in Figure 10B, the programmable array of mirrored sense sink current elements 570 may be operably coupled to the $I_{COR-SENSE}$ sink current weight control bus 484, CNTR_SN_BUS (5:1). The $I_{COR-SENSE}$ sink current weight control bus 484, CNTR_SN_BUS (5:1) may include a first control sense mirrored NFET signal 626, CNTR_SN1, coupled to the gate of the first control sense mirrored NFET 616, $NFET_{SN1}$, a second control sense mirrored NFET signal 628, CNTR_SN2, coupled to the gate of the second control sense mirrored NFET 618, $NFET_{SN2}$, a third control sense mirrored NFET signal 630, CNTR_SN3, coupled to the gate of the third control sense mirrored NFET 620, $NFET_{SN3}$, a fourth control sense mirrored NFET signal 632, CNTR_SN4, coupled to the gate of the fourth control sense mirrored NFET 622, $NFET_{SN4}$, and a fifth control sense mirrored NFET signal 634, CNTR_SN5, coupled to the gate of the fifth control sense mirrored NFET 624, $NFET_{SN5}$.

The first control sense mirrored NFET signal 626, CNTR_SN1, may be configured to control the operational state (ON/OFF) of the first control sense mirrored NFET 616, $NFET_{SN1}$. The second control sense mirrored NFET signal 628, CNTR_SN2, may be configured to control the operational state (ON/OFF) of the second control sense mirrored NFET 618, $NFET_{SN2}$. The third control sense mirrored NFET signal 630, CNTR_SN3, may be configured to control the operational state (ON/OFF) of the third control sense mirrored NFET 620, $NFET_{SN3}$. The fourth control sense mirrored NFET signal 632, CNTR_SN4, may be configured to control the operational state (ON/OFF) of the fourth control sense mirrored NFET 622, $NFET_{SN4}$. The fifth control sense mirrored NFET signal 634, CNTR_SN5 may be configured to control the operational state (ON/OFF) of the fifth control sense mirrored NFET 624, $NFET_{SN5}$.

The first programmable sense mirrored sink current element 604A may be formed by coupling the source of the first sense mirrored NFET 604, $NFET_{S1}$, to ground, and the drain of the first sense mirrored NFET 604, $NFET_{S1}$, to the source of the first control sense mirrored NFET 616, $NFET_{SN1}$. The drain of the first control sense mirrored NFET 616, $NFET_{SN1}$, is coupled to the operational amplifier controlled $I_{COR\_SENSE}$ current output 472A. The second programmable sense mirrored sink current element 606A may be formed by coupling the source of the second sense mirrored NFET 606, $NFET_{S2}$, to ground, and the drain of the second sense mirrored NFET 606, $NFET_{S2}$, to the source of the second control sense mirrored NFET 618, $NFET_{SN2}$. The drain of the second control sense mirrored NFET 618, $NFET_{SN2}$, is coupled to the operational amplifier controlled $I_{COR\_SENSE}$ current output 472A. The third programmable sense mirrored sink current element 608A, may be formed by coupling the source of the third sense mirrored NFET 608, $NFET_{S3}$, to ground, and the drain of the third sense mirrored NFET 608, $NFET_{S3}$, to the source of the third control sense mirrored NFET 620, $NFET_{SN3}$. The drain of the third control sense mirrored NFET 620, $NFET_{SN3}$, is coupled to the operational amplifier controlled $I_{COR-SENSE}$ current output 472A. The fourth programmable sense mirrored sink current element 610A may be formed by coupling the source of the fourth sense mirrored NFET 610, $NFET_{S4}$, to ground, and the drain of the fourth sense mirrored NFET 610, $NFET_{S4}$, to the source of the fourth control sense mirrored NFET 622, $NFET_{SN4}$. The drain of the fourth control sense mirrored NFET 622, $NFET_{SN4}$, is coupled to the operational amplifier controlled $I_{COR\_SENSE}$ current output 472A. The fifth programmable sense mirrored sink current element 612A may be formed by coupling the source of the fifth sense mirrored NFET 612, $NFET_{S5}$, to ground, and the drain of the fifth sense mirrored NFET 612, $NFET_{S5}$, to the source of the fifth control sense mirrored NFET 624, $NFET_{SN5}$. The drain of the fifth control sense mirrored NFET 624, $NFET_{SN4}$, is coupled to the operational amplifier controlled $I_{COR\_SENSE}$ current output 472A.

The gate of each of the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, and the sixth sense mirrored NFET 614, $NFET_{S6}$, is coupled to the output stage $NFET_A$ control signal 476 such that the each of the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET\text{-}_{S5}$, and the sixth sense mirrored NFET 614, $NFET_{S6}$, is current mirrored to the first push-pull output NFET 488, $NFET_A$, of the operational amplifier push-pull output stage circuit 468. As a result, the gate voltage for each of the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, and the sixth sense mirrored NFET 614, $NFET_{S6}$, is substantially set equal to the $NFET_A$ control voltage, $V_{NFET\_A\_CNTR}$, provided by the output stage $NFET_A$ control signal 476.

Accordingly, the magnitude of the current provided by the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, is governed by the $NFET_A$ control voltage, $V_{NFET-A-CNTR}$, provided by the output stage $NFET_A$ control signal from the operational amplifier front-end stage circuit 466.

The controller 50 may configure the $I_{COR\_SENSE}$ sink current weight control bus 484, CNTR_SN_BUS (5:1), to selectively place the first programmable sense mirrored sink current element 604A, the second programmable sense mirrored sink current element 606A, the third programmable sense mirrored sink current element 608A, the fourth programmable sense mirrored sink current element 610A, and the fifth programmable sense mirrored sink current element 612A, in an OFF state or an ON state to govern the contribution of current sunk by each of the first sense mirrored NFET 604, $NFET_{S1}$, the second sense mirrored NFET 606, $NFET_{S2}$, the third sense mirrored NFET 608, $NFET_{S3}$, the fourth sense mirrored NFET 610, $NFET_{S4}$, the fifth sense mirrored NFET 612, $NFET_{S5}$, and the sixth sense mirrored NFET 614, $NFET_{S6}$. Because the sixth sense mirrored NFET 614, $NFET_{S6}$, is not part of a programmable sink current element, the sixth sense mirrored NFET 614, $NFET_{S6}$, sinks current from the output of the operational amplifier controlled $I_{COR\_SENSE}$ current output 472A dependent upon the $NFET_A$ control voltage, $V_{NFET\_A\_CNTR}$.

Accordingly, the substantially symmetric $I_{COR\_SENSE}$ current push-pull output stage 571 is formed by coupling the source of the sixth sense mirrored PFET 582, $PFET_{S6}$, to the circuit supply voltage, $V_{DD}$, and the source of the sixth sense mirrored NFET 614, NFET$_{S6}$, to ground. The drain of the sixth sense mirrored PFET 582, PFET-$_{S6}$, and the drain of the sixth sense mirrored NFET 582, NFET$_{S6}$, are each coupled to the operational amplifier controlled I$_{COR-SENSE}$ current output 472A. As previously described, the gate of the sixth sense mirrored PFET 582, PFET$_{S6}$, is coupled to the output stage PFET$_A$ control signal 474 and the gate of the sixth sense mirrored NFET 614, NFET$_{S6}$, are coupled to the output stage NFET$_A$ control signal 476. The sixth sense mirrored PFET 582, PFET$_{S6}$, and the sixth sense mirrored NFET 614, NFET$_{S6}$, form the substantially symmetric I$_{COR\_SENSE}$ current push-pull output stage 571 that is mirrored to the operational amplifier output current, I$_{AMP}$, provided by the operational amplifier push-pull output state circuit 468.

Furthermore, the channel width of the sixth sense mirrored PFET 582, PFET-$_{S6}$, and the sixth sense mirrored NFET 614, NFET$_{S6}$, are configured to be proportionally scaled to the seventh mirrored PFET 506, PFET$_{A6}$, and the seventh mirrored NFET 543, NFET$_{A6}$, such that the I$_{COR\_SENSE}$ offset current capacity is fractionally related to the I$_{COR}$ offset current carrying capacity by the sense scaling factor, C$_{SENSE\_SCALING}$.

In order to configure the programmable array of mirrored sense source current elements 568 and the programmable array of mirrored sense sink current elements 570 to operate as a substantially symmetric programmable I$_{COR\_SENSES}$ push-pull output stage 569, the controller 50 controls the I$_{COR\_SENSE}$ source current weight control bus 482, CNTR_SP_BUS (5:1), and the I$_{COR\_SENSE}$ sink current weight control bus 484, CNTR_SN_BUS (5:1), such that the operational state of the first programmable sense mirrored source current element 572A is associated with the operational state of the corresponding first programmable sense mirrored sink current element 604A, the operational state of the second programmable sense mirrored source current element 574A is associated with the operational state of the corresponding second programmable sense mirrored sink current element 606A, the operational state of the third programmable sense mirrored source current element 576A is associated with the operational state of the corresponding third programmable sense mirrored sink current element 608A, the operational state of the fourth programmable sense mirrored source current element 578A is associated with the operational state of the fourth programmable sense mirrored sink current element 610A, and the operational state of the fifth programmable sense mirrored source current element 580A is associated with the operational state of the corresponding fifth programmable sense mirrored sink current element 612A.

In addition, to maintain proper scaling between the scaled high frequency ripple compensation current estimate 418, I$_{COR\_SENSE}$, and the high frequency ripple compensation current 416, I$_{COR}$, the current carrying capacity of the first programmable sense mirrored source current element 572A, the second programmable sense mirrored source current element 574A, the third programmable sense mirrored source current element 576A, the fourth programmable sense mirrored source current element 578A, the fifth programmable sense mirrored source current element 580A, the first programmable sense mirrored sink current element 604A, the second programmable sense mirrored sink current element 606A, the third programmable sense mirrored sink current element 608A, the fourth programmable sense mirrored sink current element 610A, and the fifth programmable sense mirrored sink current element 612A, and the symmetric I$_{COR\_SENSE}$ current push-pull output stage 571 are scaled based on the sense scaling factor, C$_{SENSE-SCALING}$, with respect to the current carrying capacity of the second programmable mirrored source current element 496A, the third programmable mirrored source current element 498A, the fourth programmable mirrored source current element 500A, the fifth programmable mirrored source current element 502A, the sixth programmable mirrored source current element 504A, the second programmable mirrored sink current element 534A, the third programmable mirrored sink current element 536A, the fourth programmable mirrored sink current element 538A, the fifth programmable mirrored sink current element 540A, the sixth programmable mirrored sink current element 542A, and the substantially symmetric I$_{COR}$ current push-pull output stage 493.

In some embodiments, the controller configures the I$_{COR-SENSE}$ source current weight control bus 482, CNTR_SP_BUS (5:1) and the I$_{COR\_SENSE}$ sink current weight control bus 484, CNTR_SN_BUS (5:1), based on the five most significant bits of the programmable control word, CNTRN, used to configure the programmable I$_{COR}$ transconductance, Gm$_{ICOR}$, of the operational amplifier controlled I$_{COR}$ current circuit 470.

As an example, the controller 50 may configure the I$_{COR-SENSE}$ source current weight control bus 482, CNTR_SP_BUS (5:1) and the I$_{COR\_SENSE}$ sink current weight control bus 484, CNTR_SN_BUS (5:1), to substantially track the operation of the I$_{COR}$ source current weight control bus 478, CNTR_CP_BUS (5:0), and the I$_{COR}$ sink current weight control bus 480, CNTR_CN_BUS (5:0) in order to maintain the sense scaling factor, C$_{SENSE-SCALING}$, relationship between the scaled high frequency ripple compensation current estimate 418, I$_{COR\_SENSE}$, and the high frequency ripple compensation current 416, I$_{COR}$.

Illustratively, in the embodiment of the operational amplifier controlled I$_{COR-SENSE}$ current circuit 472 depicted in Figure 10B, which includes five programmable sense mirrored source current elements and five corresponding programmable sense mirrored sink current elements, the controller 50 may configure the second control mirrored PFET signal 522, CNTR_CP1, the second control mirrored NFET signal 558, CNTR_CN1, the first control sense mirrored PFET signal 594, CNTR_SP1, and the first control sense mirrored NFET signal 626, CNTR_SN1, to have the same on/off state based on the most significant bits of the programmable control word, CNTRN. The controller 50 may configure the third control mirrored PFET signal 524, CNTR_CP2, the third control mirrored NFET signal 560, CNTR_CN2, the second control sense mirrored PFET signal 596, CNTR_SP2, and the second control sense mirrored NFET signal 628, CNTR_SN2, to have the same on/off state based on the most significant bits of the programmable control word, CNTRN. The controller 50 may also configure the fourth control mirrored PFET signal 526, CNTR_CP3, the fourth control mirrored NFET signal 562, CNTR_CN3, the third control sense mirrored PFET signal 598, CNTR_SP3, and the third control sense mirrored NFET signal 630, CNTR_SN3, to have the same on/off state based on the most significant bits of the programmable control word, CNTRN. The controller 50 may also configure the fifth control mirrored PFET signal 528, CNTR_CP4, the fifth control mirrored NFET signal 564, CNTR_CN4, the fourth control sense mirrored PFET signal 600, CNTR_SP4, and the fourth control sense mirrored NFET signal 632, CNTR_SN4, to have the same on/off state based on the most significant bits of the programmable control word, CNTRN. And, the controller 50 may also configure the sixth control mirrored PFET signal 530, CNTR_CP5, the sixth control mirrored NFET signal 566, CNTR_CN5, the fifth control sense mirrored PFET signal 602, CNTR_SP5, and the fifth control sense mirrored NFET signal 634, CNTR_SN5, to have the same on/off state based on the most significant bits of the programmable control word, CNTRN.

As an example, the controller 50 may configure the $I_{COR\_SENSE}$ source current weight control bus 482, CNTR_SP_BUS(5:1) and the $I_{COR\_SENSE}$ sink current weight control bus 484, CNTR_SN_BUS(5:1), to substantially track the operation of the $I_{COR}$ source current weight control bus 478, CNTR_CP_BUS(5:0), and the $I_{COR}$ sink current weight control bus 480, CNTR_CN_BUS(5:0) in order to maintain the sense scaling factor, $C_{SENSE-SCALING}$, relationship between the scaled high frequency ripple compensation current estimate 418, $I_{COR\_SENSE}$, and the high frequency ripple compensation current 416, $I_{COR}$.

Illustratively, in the embodiment of the operational amplifier controlled $I_{COR\_SENSE}$ current circuit 472 depicted in Figure 10B, which includes five programmable sense mirrored source current elements and five corresponding programmable sense mirrored sink current elements, the controller 50 may configure the second control mirrored PFET signal 522, CNTR_CP1, the second control mirrored NFET signal 558, CNTR_CN1, the first control sense mirrored PFET signal 594, CNTR_SP1, and the first control sense mirrored NFET signal 626, CNTR_SN1, to have the same on/off state based on the most significant bits of the programmable control word, CNTRN. The controller 50 may configure the third control mirrored PFET signal 524, CNTR_CP2, the third control mirrored NFET signal 560, CNTR_CN2, the second control sense mirrored PFET signal 596, CNTR_SP2, and the second control sense mirrored NFET signal 628, CNTR_SN2, to have the same on/off state based on the most significant bits of the programmable control word, CNTRN. The controller 50 may also configure the fourth control mirrored PFET signal 526, CNTR_CP3, the fourth control mirrored NFET signal 562, CNTR_CN3, the third control sense mirrored PFET signal 598, CNTR_SP3, and the third control sense mirrored NFET signal 630, CNTR_SN3, to have the same on/off state based on the most significant bits of the programmable control word, CNTRN. The controller 50 may also configure the fifth control mirrored PFET signal 528, CNTR_CP4, the fifth control mirrored NFET signal 564, CNTR_CN4, the fourth control sense mirrored PFET signal 600, CNTR_SP4, and the fourth control sense mirrored NFET signal 632, CNTR_SN4, to have the same on/off state based on the most significant bits of the programmable control word, CNTRN. And, the controller 50 may also configure the sixth control mirrored PFET signal 530, CNTR_CP5, the sixth control mirrored NFET signal 566, CNTR_CN5, the fifth control sense mirrored PFET signal 602, CNTR_SP5, and the fifth control sense mirrored NFET signal 634, CNTR_SN5, to have the same on/off state based on the most significant bits of the programmable control word, CNTRN.

In addition, the controller 50 is configured to control the $I_{COR}$ source current weight control bus 478, CNTR_CP_BUS(5:0), the $I_{COR}$ sink current weight control bus 480, CNTR_CN_BUS(5:0), the $I_{COR\_SENSE}$ source current weight control bus 482, CNTR_SP_BUS(5:1), and the $I_{COR\_SENSE}$ sink current weight control bus 484, CNTR_SN_BUS(5:1), to maintain the desired scaling between the scaled high frequency ripple compensation current estimate 418, $I_{COR\_SENSE}$, and the high frequency ripple compensation current 416, $I_{COR}$.

The programmable $I_{COR\_SENSE}$ transconductance, $Gm_{ICOR\_SCALED}$, of the operational amplifier controlled $I_{COR\_SENSE}$ current circuit 472 is similar to the programmable $I_{COR}$ transconductance, $Gm_{ICOR}$, of the operational amplifier controlled $I_{COR}$ current circuit 470, except that the programmable $I_{COR-SENSE}$ transconductance, $Gm_{ICOR\_SCALED}$, of the operational amplifier controlled $I_{COR\_SENSE}$ current circuit 472, $Gm_{ICOR\_SCALED}$, is reduced by a factor of the sense scaling factor, $C_{SENSE\_SCALING}$. In addition, the granularity of the programmability of the programmable $I_{COR-SENSE}$ transconductance, $Gm_{ICOR\_SCALED}$, of the operational amplifier controlled $I_{COR-SENSE}$ current circuit is limited by the five bits of the $I_{COR\_SENSE}$ source current weight control bus 482, CNTR_SP_BUS(5:1) and the five bits of the $I_{COR\_SENSE}$ sink current weight control bus 484, CNTR_SN_BUS(5:1).

Continuing with the description of the operational amplifier circuitry 440A depicted in Figure 9A, Figure 10C depicts an example embodiment of the Gm bias circuit and operational amplifier isolation circuit of the embodiment of the operational amplifier circuitry depicted in Figure 9A. As previously discussed with respect to Figure 7A, the Gm bias circuit 444 may include the bias resistor 452 coupled in series with the bias capacitor 454 between the operational amplifier output 442C (not shown) and ground. As previously described, a Gm bias current, $I_{Gm\_BIAS}$, passes through the bias resistor 452 and the bias capacitor 454 to ground. Accordingly, as previously described, the operational amplifier transconductance, $Gm_{OP\_AMP}$, of the operational amplifier 442 may be set as a function of the bias resistance, $R_0$, of the bias resistor 452. Because operation of the Gm bias circuit 444 has been previously described with respect to the operational amplifier circuitry 440A, depicted in Figure 7A, further additional further description is not provided here.

Figure 10C further depicts the operational amplifier output isolation circuit 446 that includes an operational amplifier output isolation circuit input in communication with the follower NFET 448, $NFET_{FOLLOWER}$, where the source of the follower NFET 448, $NFET_{FOLLOWER}$, is coupled in series to the $I_{BIAS\_FOLLOWER}$ current source 450. The drain of the follower NFET 448, $NFET_{FOLLOWER}$, is coupled to the circuit supply voltage, $V_{DD}$. The gate voltage at the gate of the follower NFET 448, $NFET_{FOLLOWER}$ is equal to the operational amplifier output voltage, $V_{AMP}$. As previously discussed, with respect to Figure 7A, the gate current, $I_{GATE}$, that flows into the gate of the follower NFET 448, $NFET_{FOLLOWER}$, approaches zero due to the high gate impedance of the follower NFET 448, $NFET_{FOLLOWER}$. The $I_{BIAS\_FOLLOWER}$ current source 450 may include a bias follower NFET 636, $NFET_{BIAS\_FOLLOWER}$. The source of the bias follower NFET 636, $NFET_{BIAS\_FOLLOWER}$ is coupled to the first node 450A of the $I_{BIAS\_FOLLOWER}$ current source 450. The source of the bias follower NFET 636, $NFET_{BIAS\_FOLLOWER}$ is coupled to the first node 450B, where the first node 450B is coupled to ground. The gate of the bias follower NFET 636, $NFET_{BIAS\_FOLLOWER}$, is coupled to a follower bias voltage, $V_{BIAS\_FOLOWER}$, which may be provided by a biasing circuit (not shown) associated with the operational amplifier circuitry 440A. As previously discussed with respect to Figure 7A, the feedback voltage, $V_e$, is provided at an isolated feedback node 451 created at the junction of the source of the follower NFET 448, $NFET_{FOLLOWER}$, to the drain of the bias follower NFET 636, $NFET_{BIAS\_FOLLOWER}$. The isolated feedback node 451 provides the feedback voltage, $V_e$, as an output of the operational amplifier output isolation circuit 446. Accordingly, as previously discussed, from a small signal perspective, the follower NFET 448, $NFET_{FOLLOWER}$, provides an isolated feedback node 451 such that, referring back to the open loop ripple compensation assist circuit 414B, depicted in Figure 7A, the feedback current 456 does not impact the Gm bias current, $I_{Gm\_BIAS}$, that is used to set the operational amplifier transconductance, $Gm_{OP\_AMP}$, of the operational amplifier 442, depicted in Figure 9A.

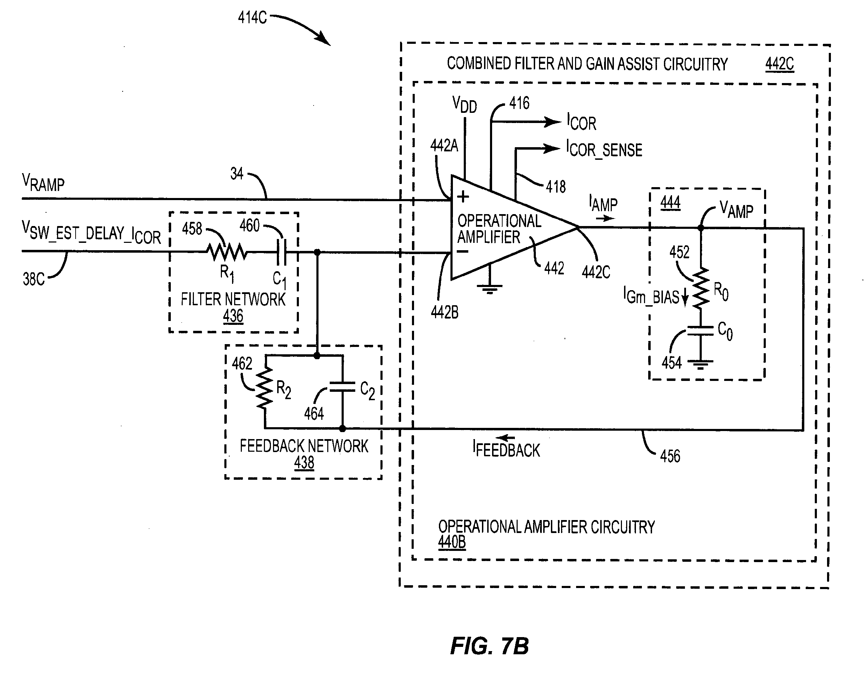

In contrast to the open loop ripple compensation assist circuit 414B, depicted in Figure 7A and the operational amplifier circuitry 440A, depicted in Figure 9A, an alternative example of the open loop ripple compensation assist circuit 414, depicted in Figure 7B, is an open loop ripple compensation assist circuit 414C that does not include the operational amplifier output isolation circuit 446. Except for the exclusion of the operational amplifier output isolation circuit 446, the open loop ripple compensation assist circuit 414C is similar in form and function to the open loop ripple compensation assist circuit 414B. Likewise, while controller 50 is not depicted in Figure 7A, it will be understood that as depicted in Figures 3A-D, controller 50 (not shown) may configure the various elements of the open loop ripple compensation assist circuit 414C depicted in Figure 7B.

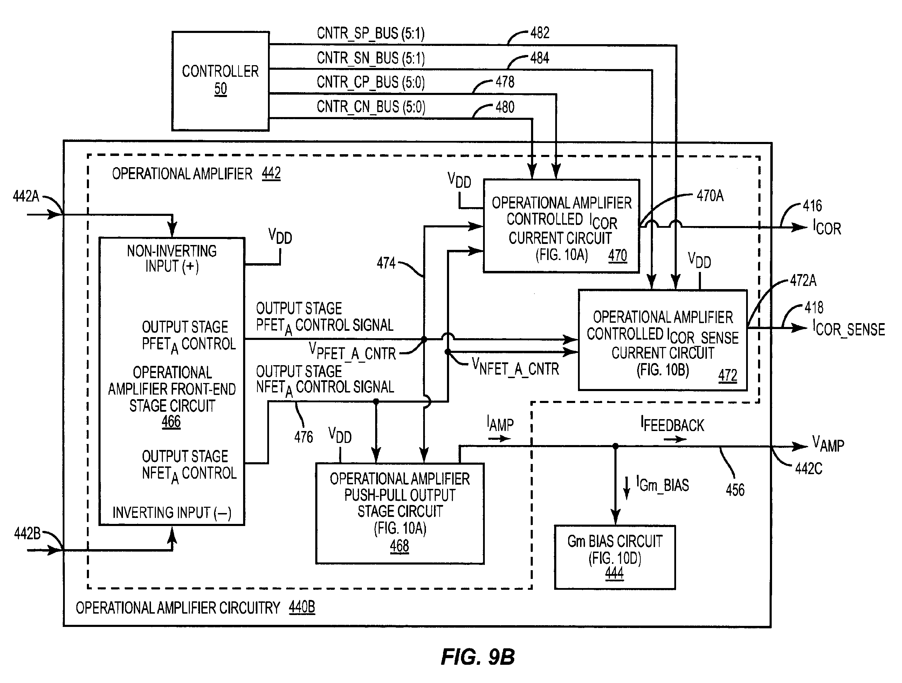

As a result, the open loop ripple compensation assist circuit 414C includes a combined filter and gain circuitry 422C having only the operational amplifier circuitry 440B. Thus, unlike the operational amplifier circuitry 440B, depicted in Figure 7A and Figure 9A, the operational amplifier circuitry 440B, depicted in Figure 7B and Figure 9B, does not include the operational amplifier output isolation circuit 446. As a result, the operational amplifier output 442C of the operational amplifier 442 is tied directly to the feedback network 438.

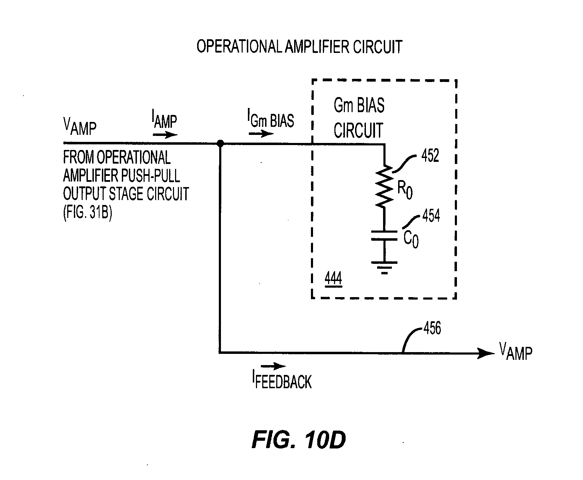

Referring briefly to the embodiment of the operational amplifier circuitry 440B, depicted in Figure 9B, the operational amplifier circuitry 440B is similar in form and function to the operational amplifier circuitry 440A, depicted in Figure 9A, except, the operational amplifier output isolation circuit 446 depicted in Figure 10C is eliminated. Thus, as depicted in Figure 10D, the Gm bias circuit 444 is not isolated from the feedback network 438, depicted in Figure 7B.

Accordingly, the operational amplifier output 442C may be configured to provide the operational amplifier output current, $I_{AMP}$, to provide the Gm bias current, $I_{Gm-\_BIAS}$, and the feedback current 456, $I_{FEEDBACK}$. In order to obtain ripple rejection response characteristics that are similar to the ripple rejection response characteristics obtained using the embodiment of the open loop ripple compensation assist circuit 414B , depicted in Figure 7A, the ratio of the Gm bias current, $I_{Gm\_BIAS}$, to the feedback current 456, $I_{FEEDBACK}$, must be controlled such that the feedback current 456, $I_{FEEDBACK}$, is at least 20dB lower in amplitude than the Gm bias current, $I_{Gm-BIAs}$, passing through the Gm bias circuit 444. In other words, to minimize the non-isolative effect of providing the feedback current 456, $I_{FEEDBACK}$, directly from the operational amplifier output 442C, it is desirable for the ratio of $I_{Gm\_BIAS}/ I_{FEEDBACK} \geq 10$.

The series impedance of the bias resistance, $R_0$, of the bias resistor 452, and the bias capacitance, $C_0$, of the bias capacitor 454, form a transconductance setting impedance, $Z_{Gm}$. The parallel impedance of the feedback resistance, $R_2$, of the feedback resistor 462 and the feedback capacitance, $C_2$, of the feedback capacitor 464 in combination with the series impedance of the filter resistance, $R_1$, of the filter resistor 458 and the filter capacitance, $C_1$, of the filter capacitor 460 form a feedback current setting impedance, $Z_{FEEDBACK}$.

To ensure the ratio of $I_{Gm\_BIAS}/ I_{FEEDBACK} \geq 10$, the fixed valued resistances and capacitances and the programmable valued resistances and capacitances of the respective bias resistor 452, feedback capacitor 464, filter resistor 458, filter capacitor 460, may be configured such that $Z_{Gm}, \geq 10 \times Z_{FEEDBACK}$.

Thus, in some embodiments of the open loop ripple compensation assist circuit 414B, the controller 50 may configure the filter resistor 458 to have a resistance value substantially equal to the filter resistance, $R_1$, the feedback resistor 462 to have a resistance value substantially equal to the feedback resistance, $R_2$, the filter capacitor 460 to have a capacitance value substantially equal to the filter capacitance, $C_1$, and the feedback capacitor 464 to have a capacitance value substantially equal to the feedback capacitance, $C_2$, such that relative to the series impedance formed by the bias resistance, $R_0$, of the bias resistor 452, and the bias capacitance, $C_0$, of the bias capacitor 454, result in the feedback current 456, $I_{FEEDBACK}$, passing through the parallel impedance of the feedback resistor 462 and feedback capacitor 464 to be around $1/10^{th}$ the magnitude of the Gm bias current, $I_{Gm\_BIAS}$, passing through the bias resistor 452 and the bias capacitor 454 in the range of frequencies near or within operational bandwidth of the linear RF power amplifier 22. In other words, in some embodiments of the open loop ripple compensation assist circuit 414C, the impedances of the filter network 436 and the feedback network 438 are configured such that the ratio of the transconductance setting impedance, $Z_{Gm}$, to the feedback current setting impedance, $Z_{FEEDBACK}$, minimizes the impact of the feedback current 456, $I_{FEEDBACK}$, on the operational amplifier transconductance, $Gm_{OP\_AMP}$, of the operational amplifier 442 set based on the bias resistance, $R_0$, of the bias resistor 452. Illustratively, for the ratio of $Z_{Gm} : Z_{FEEDBACK}$, equal to or greater than 1:10, the magnitude of the feedback current 456, $I_{FEEDBACK}$, relative to the Gm bias current, $I_{Gm-BIAS}$, may minimally affects the operational amplifier transconductance, $Gm_{OP\_AMP}$, of the operational amplifier 442. In other embodiments, the ratio of $Z_{Gm} : Z_{FEEDBACK}$, may equal to or greater than 1:8 without substantially impacting the ability to set the operational amplifier transconductance, $Gm_{OP\_AMP}$, of the operational amplifier circuitry 442 based on the bias resistance, $R_0$, of the bias resistor 452.

However, in some embodiments of the open loop ripple compensation assist circuit 414C, depicted in Figure 7B, the relative impedance relationship between the transconductance setting impedance, $Z_{Gm}$, and the feedback current setting impedance, $Z_{FEEDBACK}$, may result in reduced ripple rejection response characteristics of the pseudo-envelope follower power management systems.

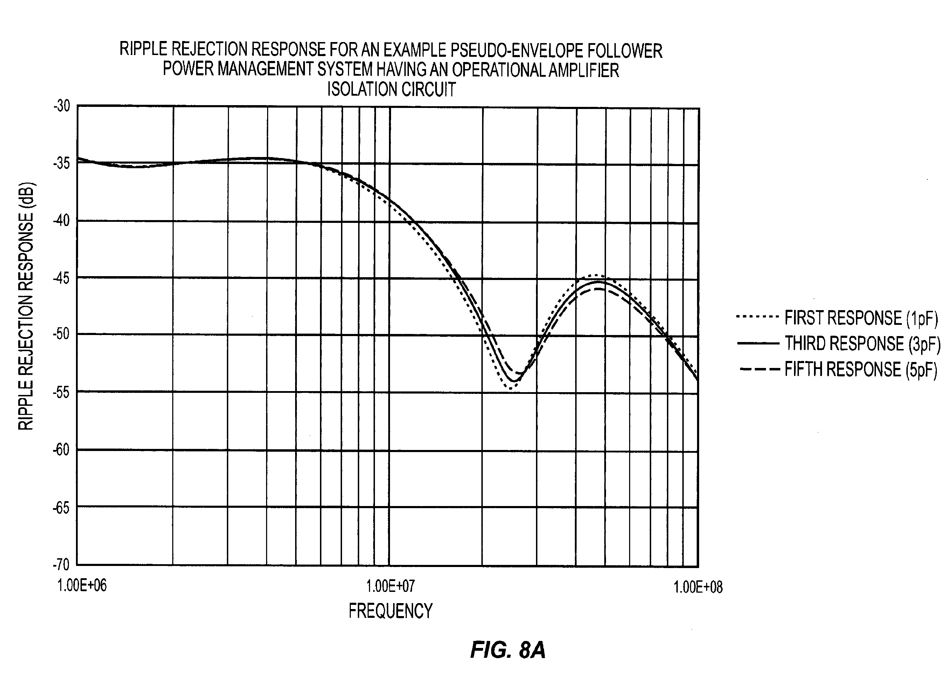

By way of example, and not by limitation, Figure 8A depicts the ripple rejection response characteristics of an embodiment of the pseudo-envelope follower power management systems similar to the pseudo-envelope follower power management systems depicted in Figures 3A-D, where the open loop ripple compensation assist circuit 414, depicted in Figures 3A-D, is similar to the open loop ripple compensation assist circuit 414B, depicted in Figure 7A. For the sake of illustration, and not by way of limitation, the bias resistance, $R_0$, of the bias resistor 452 is substantially equal to 500Ω, and the bias capacitance, $C_0$, of the bias capacitor 454 is substantially equal to 100pF. For the sake of simplicity, and not by way of limitation, the ripple rejection response curves are based on configuring the resistance values of the filter resistor 458 and the feedback resistor 462 such that $R_1 = R_2$. In addition, for the sake of simplicity, and not by way of limitation, the ripple rejection response curves are based on configuring the capacitance values of the filter capacitor 460 and the feedback capacitor 464 such that $C_1 = C_2$.

Figure 8A depicts a first ripple rejection response curve labeled "FIRST RESPONSE (1pF)," a second ripple rejection response curve labeled "THIRD RESPONSE (3pF)," and a third ripple rejection response curve labeled "FIFTH RESPONSE (5pF)" for a pseudo-envelope follower power management system similar to the pseudo-envelope follower power management systems depicted in Figures 3A-D, where the open loop ripple compensation assist circuit 414, depicted in Figures 3A-D, is similar to the open loop ripple compensation assist circuit 414B, depicted in Figure 7A. The first ripple rejection response curve is for the case where the filter capacitance, $C_1$ and the feedback capacitance, $C_2$ are substantially equal to 1pF, $(C_1 = C_2 = 1pF)$, and the filter resistance $R_1$ and the feedback resistance, $R_2$ are substantially equal to 26.5 KΩ, $(R_1 = R_2 = 26.5\ KΩ)$. Referring back to the mapping between the elements of equation (4) and equation (6), for $R_1 = R_2 = 26.5\ KΩ$ and $C_1 = C_2 = 1pF$, the open loop ripple compensation assist circuit 414B provides a high pass filtering response, where the first corner frequency, $f_{c1}$, and the second corner frequency, $f_{c2}$, are approximately 6.003MHz. The second ripple rejection response curve is for the case where the filter capacitance, $C_1$ and the feedback capacitance, $C_2$ are substantially equal to 3pF, $(C_1 = C_2 = 3pF)$, and the filter resistance $R_1$ and the feedback resistance, $R_2$ are substantially equal to 26.5 KΩ, $(R_1 = R_2 = 8.3\ KΩ)$. Referring back to the mapping between the elements of equation (4) and equation (6), for $R_1 = R_2 = 8.8\ KΩ$ and $C_1 = C_2 = 3pF$, the open loop ripple compensation assist circuit 414B provides a high pass filtering response, where the first corner frequency, $f_{c1}$, and the second corner frequency, $f_{c2}$, are approximately 6.026 MHz. The third ripple rejection response curve is for the case where the filter capacitance, $C_1$ and the feedback capacitance, $C_2$ are substantially equal to 5pF, $(C_1 = C_2 = 5pF)$, and the filter resistance $R_1$ and the feedback resistance, $R_2$ are substantially equal to 5.3 KΩ, $(R_1 = R_2 = 8.3\ KΩ)$. Referring back to the mapping between the elements of equation (4) and equation (6), for $R_1 = R_2 = 5.3\ KΩ$ and $C_1 = C_2 = 5pF$, the open loop ripple compensation assist circuit 414B provides a high pass filtering response, where the first corner frequency, $f_{c1}$, and the second corner frequency, $f_{c2}$, are approximately 6.003 MHz. The first ripple rejection response curve, the second ripple rejection response curve, and the third ripple rejection response curve are substantially similar with respect to placement, width, and depth of the notch in the ripple rejection response of the above-described pseudo-envelope follower power management systems.

As depicted in Figure 8A, the ripple rejection response curves for the embodiments of the pseudo-envelope follower power management systems similar to the pseudo-envelope follower power management systems, depicted in Figures 3A-D, that include the open loop ripple compensation assist circuit 414B, depicted in Figure 7A, which includes the operational amplifier output isolation circuit 446, are substantially insensitive to the values of the filter resistance, $R_1$, the feedback resistance, $R_2$, the filter capacitance, $C_1$, and the feedback capacitance, $C_2$. In addition, the depth of the notch in the first ripple rejection response curve, the second ripple rejection response curve, and the third ripple rejection response curve are substantially similar. Thus, advantageously, the values of the filter resistance, $R_1$, the feedback resistance, $R_2$, the filter capacitance, $C_1$, and the feedback capacitance, $C_2$, of the open loop ripple compensation assist circuit 414B may be selected such that parasitic capacitances and resistances present in the layout and circuitry of the example pseudo-envelope follower power management system minimally impact the location, width, and depth of the notch.

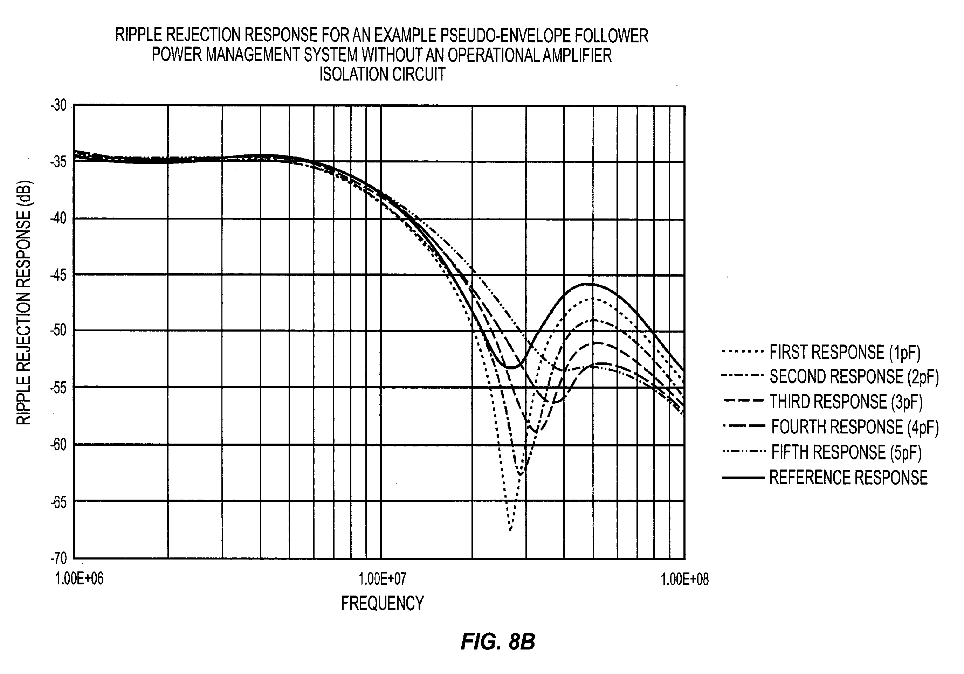

As another non-limiting example, Figure 8B depicts ripple rejection response curves for an embodiment of the pseudo-envelope follower power management systems similar to the pseudo-envelope follower power management systems depicted in Figures 3A-D, where the open loop ripple compensation assist circuit 414, depicted in Figures 3A-D, is similar to the open loop ripple compensation assist circuit 414C, depicted in Figure 7B. In addition, Figure 8A also depicts a reference ripple rejection curve, labeled "REFERENCE RESPONSE," which is the reference rejection response of the open loop ripple compensation assist circuit 414B, depicted in Figure 7A, for the case where the filter capacitance, $C_1$ and the feedback capacitance, $C_2$ are substantially equal to 5pF, ($C_1 = C_2 = 5pF$), and the filter resistance $R_1$ and the feedback resistance, $R_2$ are substantially equal to 5.3 K$\Omega$, ($R_1 = R_2 = 8.3$ K$\Omega$).

Figure 8B depicts a ripple rejection response curve, labeled "REFERENCE RESPONSE," that corresponds to, for the embodiment of the pseudo-envelope follower power management systems, depicted in Figure 7A, where the capacitance values of the filter capacitor 460 and the feedback capacitor 464 such that $C_1 = C_2 = 5pF$ and the resistance values of the filter resistor 458 and the feedback resistor 462 are substantially set such that $R_1 = R_2 = 5.3$K$\Omega$. Figure 8A further depicts a first ripple rejection response curve labeled "FIRST RESPONSE (1 pF)," a second ripple rejection response curve labeled "SECOND RESPONSE (2pF)," a third ripple rejection response curve labeled "THIRD RESPONSE (3pF)," a fourth ripple rejection response curve labeled "FOURTH RESPONSE (4pF)" and a fifth ripple rejection response curve labeled "FIFTH RESPONSE (5pF)" for a pseudo-envelope follower power management system similar to the pseudo-envelope follower power management systems depicted in Figures 3A-D, where the open loop ripple compensation assist circuit 414, depicted in Figures 3A-D, is similar to the open loop ripple compensation assist circuit 414C, depicted in Figure 7B.

The first ripple rejection response curve is for the case where the filter capacitance, $C_1$ and the feedback capacitance, $C_2$ are substantially equal to 1pF, ($C_1 = C_2 = 1$ pF), and the filter resistance $R_1$ and the feedback resistance, $R_2$ are substantially equal to 26.5 K$\Omega$, ($R_1 = R_2 = 26.5$ K$\Omega$).

The second ripple rejection response curve is for the case where the filter capacitance, $C_1$ and the feedback capacitance, $C_2$ are substantially equal to 2pF, ($C_1 = C_2 = 2pF$), and the filter resistance $R_1$ and the feedback resistance, $R_2$ are substantially equal to 13.25 K$\Omega$, ($R_1 = R_2 = 13.25$ K$\Omega$).

The third ripple rejection response curve is for the case where the filter capacitance, $C_1$ and the feedback capacitance, $C_2$ are substantially equal to 3pF, ($C_1 = C_2 = 3pF$), and the filter resistance $R_1$ and the feedback resistance, $R_2$ are substantially equal to 8.8 K$\Omega$, ($R_1 = R_2 = 8.8$ K$\Omega$).

The fourth ripple rejection response curve is for the case where the filter capacitance, $C_1$ and the feedback capacitance, $C_2$ are substantially equal to 3pF, ($C_1 = C_2 = 4pF$), and the filter resistance $R_1$ and the feedback resistance, $R_2$ are substantially equal to 6.6 K$\Omega$, ($R_1 = R_2 = 6.6$ K$\Omega$).

The fifth ripple rejection response curve is for the case where the filter capacitance, $C_1$ and the feedback capacitance, $C_2$ are substantially equal to 5pF, ($C_1 = C_2 = 5pF$), and the filter resistance $R_1$ and the feedback resistance, $R_2$ are substantially equal to 5.3 K$\Omega$, ($R_1 = R_2 = 5.3$ K$\Omega$). In contrast to the ripple rejection response curves depicted in Figure 8A, ripple rejection response curves, depicted in Figure 8B, vary substantially based on the values of the filter resistance, $R_1$, the feedback resistance, $R_2$, the filter capacitance, $C_1$, the feedback capacitance, $C_2$. For example, the notch depth and location of the first ripple rejection response curve labeled "FIRST RESPONSE (1 pF), depicted in Figure 8B, is substantially different than the location, width, and depth of the notch of the first ripple rejection response curve labeled "FIRST RESPONSE (1 pF), depicted in Figure 8B. In addition, advantageously, the typical depth of the notch in the first ripple rejection response curve, the second ripple rejection response curve labeled, the third ripple rejection response curve, the fourth ripple rejection response curve, and the fifth ripple rejection response curve, depicted in Figure 8B, is deeper than the "Reference Response," which represents the ripple rejection response curves obtained with the open loop ripple compensation assist circuit 414B.

Those skilled in the art will recognize improvements and modifications to the embodiments of the present disclosure. All such improvements and modifications are considered within the scope of the concepts disclosed herein and the claims that follow.

**Claims**

1. A pseudo-envelope follower power management system (10) with high frequency ripple compensation comprising:

a switch mode power supply converter (420) configured to:

generate a switching voltage output (26); and
generate an estimated switching voltage output (38B, $V_{SW\_EST}$), which provides an early indication of a future voltage level of the switching voltage output (26);

an open loop ripple compensation assist circuit (414) configured to:

receive the estimated switching voltage output (38B, $V_{SW-EST}$) and a $V_{RAMP}$ signal ($V_{RAMP}$);
generate a high frequency ripple compensation current (416, $I_{COR}$) based on the estimated switching voltage output (38B, $V_{SW-EST}$) and the $V_{RAMP}$ signal ($V_{RAMP}$); and
apply the high frequency ripple compensation current (416, $I_{COR}$) to a power amplifier supply output (28) to reduce a high frequency ripple current at the power amplifier supply output (28).

2. The pseudo-envelope follower power management system (10) with high frequency ripple compensation of claim 1 wherein the high frequency ripple compensation current (416, $I_{COR}$) is generated in a frequency band located substantially near a transmit to receive duplex offset for a band of operation in a communication network.

3. The pseudo-envelope follower power management system (10) with high frequency ripple compensation of claim 2 wherein the switch mode power supply converter (420) includes programmable delay circuitry (432) configured to delay generation of the estimated switching voltage output (38B, $V_{SW\_EST}$) by a programmable delay period.

4. The pseudo-envelope follower power management system (10) with high frequency ripple compensation of claim 3 wherein the programmable delay period is configured to temporally align the estimated switching voltage output (38B, $V_{SW\_EST}$) and the $V_{RAMP}$ signal ($V_{RAMP}$) to position a notch in a ripple rejection response of the power amplifier supply output (28) near the transmit to receive duplex offset for the band of operation.

5. The pseudo-envelope follower power management system (10) with high frequency ripple compensation of claim 1 wherein the open loop ripple compensation assist circuit (414) is further configured to generate a scaled high frequency ripple compensation current estimate (418, $I_{COR\_SENSE}$) based on the high frequency ripple compensation current (416, $I_{COR}$).

6. The pseudo-envelope follower power management system (10) with high frequency ripple compensation of claim 5 wherein the switch mode power supply converter (420) is further configured to receive a parallel amplifier circuit output current estimate (40, $I_{PAWA\_OUT\_EST}$), wherein the parallel amplifier circuit output current estimate (40, $I_{PAWA\_OUT\_EST}$) is based on the scaled high frequency ripple compensation current estimate (418, $I_{COR\_SENSE}$).

7. The pseudo-envelope follower power management system (10) with high frequency ripple compensation of claim 6 wherein the switch mode power supply converter (420) is further configured to adjust the switching voltage output (26) based on the parallel amplifier circuit output current estimate (40, $I_{PAWA\_OUT\_EST}$).

8. The pseudo-envelope follower power management system (10) with high frequency ripple compensation of claim 6 wherein the parallel amplifier circuit output current estimate (40, $I_{PAWA\_OUT\_EST}$) is further based on a scaled parallel amplifier output current estimate ($I_{PARA\_AMP\_SENSE}$).

9. The pseudo-envelope follower power management system (10) with high frequency ripple compensation of claim 1 further comprising a parallel amplifier (35) configured to:

receive a $V_{RAMP}$ signal ($V_{RAMP}$);
receive a power amplifier supply voltage (Vcc) from the power amplifier supply output (28);
generate a parallel amplifier output current ($I_{PARA\_AMP}$) based on a difference between the $V_{RAMP}$ signal ($V_{RAMP}$) and the power amplifier supply voltage (Vcc); and
apply the parallel amplifier output current ($I_{PARA\_AMP}$) to the power amplifier supply output (28).

10. The pseudo-envelope follower power management system (10) with high frequency ripple compensation of claim 9 wherein the parallel amplifier (35) is further configured to generate a scaled parallel amplifier output current estimate ($I_{PARA\_AMP\_SENSE}$) based on the parallel amplifier output current ($I_{PARA\_AMP}$).

**11.** The pseudo-envelope follower power management system (10) with high frequency ripple compensation of claim 1 wherein the open loop ripple compensation assist circuit (414) comprises:

a filter network (436) coupled to an operational amplifier (442) and configured to receive the estimated switching voltage output (38C, $V_{SW\_EST}$); and
the operational amplifier (442) configured to receive the $V_{RAMP}$ signal ($V_{RAMP}$) and generate the high frequency ripple compensation current (416, $I_{COR}$) based on the $V_{RAMP}$ signal ($V_{RAMP}$) and the estimated switching voltage output (38C, $V_{SW\_EST}$).

**12.** The pseudo-envelope follower power management system (10) with high frequency ripple compensation of claim 11 wherein the operational amplifier (442) is further configured to provide a scaled high frequency ripple compensation current estimate (418, $I_{COR\_SENSE}$) based on the $V_{RAMP}$ signal ($V_{RAMP}$) and the estimated switching voltage output (38C, $V_{SW\_EST}$).

**13.** The pseudo-envelope follower power management system (10) with high frequency ripple compensation of claim 1 wherein the switch mode power supply converter (420) is configured to operate as a buck converter.

**14.** The pseudo-envelope follower power management system (10) with high frequency ripple compensation of claim 1 wherein the switch mode power supply converter (420) is configured to operate as a multi-level charge pump buck converter.

**15.** A method for reducing high frequency ripple currents at a power amplifier supply output (28) comprising:

generating a switching voltage output (26);
generating an estimated switching voltage output (38B, $V_{SW\_EST}$), wherein the estimated switching voltage output (38B, $V_{SW\_EST}$) provides an early indication of a future voltage level of the switching voltage output (26);
receiving the estimated switching voltage output (38B, $V_{SW\_EST}$) and a $V_{RAMP}$ signal ($V_{RAMP}$);
generating a high frequency ripple compensation current (416, $I_{COR}$) based on the estimated switching voltage output (38B, $V_{SW\_EST}$) and the $V_{RAMP}$ signal ($V_{RAMP}$); and
applying the high frequency ripple compensation current (416, $I_{COR}$) to the power amplifier supply output (28) to reduce a high frequency ripple current at the power amplifier supply output (28).

**Patentansprüche**

**1.** Pseudo-Hüllkurvenfolger-Stromüberwachungssystem (10) mit hoher Restwelligkeitskompensation, umfassend:

einen Schaltnetzgerätwandler (420), der dazu konfiguriert ist:

einen Schaltspannungsausgang (26) zu erzeugen; und
einen geschätzten Schaltspannungsausgang (38B, $V_{SW\_EST}$) zu erzeugen, der eine frühzeitige Anzeige eines künftigen Spannungspegels des Schaltspannungsausgangs (26) bereitstellt;

eine Offenkreis-Restwelligkeitskompensationshilfsschaltung (414), die dazu konfiguriert ist:

den geschätzten Schaltspannungsausgang (38B, $V_{SW\_EST}$) und ein $V_{RAMP}$-Signal ($V_{RAMP}$) zu empfangen;
einen Hochfrequenz-Restwelligkeitskompensationsstrom (416, $I_{COR}$) auf Grundlage des geschätzten Schaltspannungsausgangs (38B, $V_{SW\_EST}$) und des $V_{RAMP}$-Signals ($V_{RAMP}$) zu erzeugen; und
den Hochfrequenz-Restwelligkeitskompensationsstrom (416, $I_{COR}$) an einen Leistungsverstärkerversorgungsausgang (28) anzulegen, um den Hochfrequenz-Restwelligkeitsstrom am Leistungsverstärkerversorgungsausgang(28) zu reduzieren.

**2.** Pseudo-Hüllkurvenfolger-Stromüberwachungssystem (10) mit hoher Restwelligkeitskompensation nach Anspruch 1, wobei der Hochfrequenz-Restwelligkeitskompensationsstrom (416, $I_{COR}$) auf einem Frequenzband erzeugt wird, das im Wesentlichen in der Nähe eines Transmit angeordnet ist, um einen Duplex-Offset für ein Betriebsband in einem Kommunikationsnetz zu empfangen.

**3.** Pseudo-Hüllkurvenfolger-Stromüberwachungssystem (10) mit hoher Restwelligkeitskompensation nach Anspruch 2, wobei der Schaltmodusstromversorgungswandler (420) programmierbare Verzögerungsschaltungen (432) aufweist, die dazu konfiguriert sind, die Erzeugung des geschätzten Schaltspannungsausgangs (38B, $V_{SW-EST}$) um eine programmierbare Verzögerungsperiode zu verzögern.

4. Pseudo-Hüllkurvenfolger-Stromüberwachungssystem (10) mit hoher Restwelligkeitskompensation nach Anspruch 3, wobei die programmierbare Verzögerungsperiode dazu konfiguriert ist, den geschätzten Schaltspannungsausgang (38B, $V_{SW\_EST}$) und das $V_{RAMP}$-Signal ($V_{RAMP}$) vorübergehend aneinander auszurichten, um eine Kerbe in einer Restwelligkeitszurückweisungsantwort des Leistungsverstärkerversorgungsausgangs (28) in der Nähe des Transmit zu positionieren, um einen Duplex-Offset für das Betriebsband zu empfangen.

5. Pseudo-Hüllkurvenfolger-Stromüberwachungssystem (10) mit hoher Restwelligkeitskompensation nach Anspruch 1, wobei die Offenkreis-Restwelligkeitskompensationshilfsschaltung (414) ferner dazu konfiguriert ist, eine skalierte Hochfrequenz-Restwelligkeitskompensationsstromschätzung (418, $I_{COR\_SENSE}$) auf Grundlage des Hochfrequenz-Restwelligkeitskompensationsstroms (416, $I_{COR}$) zu erzeugen.

6. Pseudo-Hüllkurvenfolger-Stromüberwachungssystem (10) mit hoher Restwelligkeitskompensation nach Anspruch 5, wobei der Schaltmodusstromversorgungswandler (420) ferner dazu konfiguriert ist, eine Parallelverstärkerschaltungsausgangsstromschätzung (40, $I_{PAWA\_OUT\_EST}$) zu empfangen, wobei die Parallelverstärkerschaltungsausgangsstromschätzung (40, $I_{PAWA\_OUT\_EST}$) auf der skalierten Hochfrequenz-Restwelligkeitskompensationsstromschätzung (418, $I_{COR\_SENSE}$) beruht.

7. Pseudo-Hüllkurvenfolger-Stromüberwachungssystem (10) mit hoher Restwelligkeitskompensation nach Anspruch 6, wobei der Schaltmodusstromversorgungswandler (420) ferner dazu konfiguriert ist, den Schaltspannungsausgang (26) auf Grundlage der Parallelverstärkerschaltungsausgangsstromschätzung (40, $I_{PAWA\_OUT\_EST}$) anzupassen.

8. Pseudo-Hüllkurvenfolger-Stromüberwachungssystem (10) mit hoher Restwelligkeitskompensation nach Anspruch 6, wobei die Parallelverstärkerschaltungsausgangsstromschätzung (40, $I_{PAWA\_OUT\_EST}$) ferner auf einer skalierten Parallelverstärkerausgangsstromschätzung ($I_{PARA\_AMP\_SENSE}$) beruht.

9. Pseudo-Hüllkurvenfolger-Stromüberwachungssystem (10) mit hoher Restwelligkeitskompensation nach Anspruch 1, ferner umfassend einen Parallelverstärker (35), der dazu konfiguriert ist:

ein $V_{RAMP}$-Signal ($V_{RAMP}$) zu empfangen;
eine Leistungsverstärkerversorgungsspannung (Vcc) vom Leistungsverstärkerversorgungsausgang (28) zu empfangen;
einen Parallelverstärkerausgangsstrom ($I_{PARA\_AMP}$) auf Grundlage einer Differenz zwischen dem $V_{RAMP}$-Signal ($V_{RAMP}$) und der Leistungsverstärkerversorgungsspannung (Vcc) zu erzeugen; und
den Parallelverstärkerausgangsstrom ($I_{PARA\_AMP}$) an den Leistungsverstärkerversorgungsausgang (28) anzulegen.

10. Pseudo-Hüllkurvenfolger-Stromüberwachungssystem (10) mit hoher Restwelligkeitskompensation nach Anspruch 9, wobei der Parallelverstärker (35) ferner dazu konfiguriert ist, eine skalierte Parallelverstärkerausgangsstromschätzung ($I_{PARA\_AMP\_SENSE}$) auf Grundlage des Parallelverstärkerausgangsstroms ($I_{PARA\_AMP}$) zu erzeugen.

11. Pseudo-Hüllkurvenfolger-Stromüberwachungssystem (10) mit hoher Restwelligkeitskompensation nach Anspruch 1 wobei die Offenkreis-Restwelligkeitskompensationshilfsschaltung (414) Folgendes umfasst:

ein Filternetz (436), das an einen Betriebsverstärker (442) gekoppelt ist und dazu konfiguriert ist, den geschätzten Schaltspannungsausgang (38C, $V_{SW\_EST}$) zu empfangen; und
wobei der Betriebsverstärker (442) dazu konfiguriert ist, das $V_{RAMP}$-Signal ($V_{RAMP}$) zu empfangen und den Hochfrequenz-Restwelligkeitskompensationsstrom (416, $I_{COR}$) auf Grundlage des $V_{RAMP}$-Signals ($V_{RAMP}$) und des geschätzten Schaltspannungsausgangs (38C, $V_{SW\_EST}$) zu erzeugen.

12. Pseudo-Hüllkurvenfolger-Stromüberwachungssystem (10) mit hoher Restwelligkeitskompensation nach Anspruch 11, wobei der Betriebsverstärker (442) ferner dazu konfiguriert ist, eine skalierte Hochfrequenz-Restwelligkeitskompensationsstromschätzung (418, $I_{COR\_SENSE}$) auf Grundlage des $V_{RAMP}$-Signals ($V_{RAMP}$) und des geschätzten Schaltspannungsausgangs (38C, $V_{SW\_EST}$) bereitzustellen.

**EP 2 649 724 B1**

**13.** Pseudo-Hüllkurvenfolger-Stromüberwachungssystem (10) mit hoher Restwelligkeitskompensation nach Anspruch 1, wobei der Schaltmodusstromversorgungswandler (420) dazu konfiguriert ist, als Abwärtswandler zu arbeiten.

**14.** Pseudo-Hüllkurvenfolger-Stromüberwachungssystem (10) mit hoher Restwelligkeitskompensation nach Anspruch 1 wobei der Schaltmodusstromversorgungswandler (420) dazu konfiguriert ist, als Mehrstufenladungpumpenabwärtswandler zu arbeiten.

**15.** Verfahren zum Reduzieren von Hochfrequenzrestwelligkeitsströmen an einem Leistungsverstärkerversorgungsausgang (28), umfassend:

Erzeugen eines Schaltspannungsausgangs (26);
Erzeugen eines geschätzten Schaltspannungsausgangs (38B, $V_{SW\_EST}$), wobei der geschätzte Schaltspannungsausgang (38B, $V_{SW\_EST}$) eine frühzeitige Anzeige eines künftigen Spannungspegels des Schaltspannungsausgangs (26) bereitstellt;
Empfangen des geschätzten Schaltspannungsausgangs (38B, $V_{SW\_EST}$) und eines $V_{RAMP}$-Signals ($V_{RAMP}$);
Erzeugen eines Hochfrequenz-Restwelligkeitskompensationsstroms (416, $I_{COR}$) auf Grundlage des geschätzten Schaltspannungsausgangs (38B, $V_{SW\_EST}$) und des $V_{RAMP}$-Signals ($V_{RAMP}$); und
Anlegen des Hochfrequenz-Restwelligkeitskompensationsstroms (416, $I_{COR}$) an den Leistungsverstärkerversorgungsausgang (28), um den Hochfrequenz-Restwelligkeitsstrom am Leistungsverstärkerversorgungsausgang(28) zu reduzieren.

**Revendications**

**1.** Système (10) de gestion de la puissance suiveur de pseudo-enveloppe à compensation des ondulations de hautes fréquences, comprenant :

un convertisseur d'alimentation électrique à mode de commutation (420) configuré pour :

produire une sortie de tension de commutation (26) ; et
produire une sortie estimée de tension de commutation (38B, $V_{SW\_EST}$), qui procure une indication précoce d'un niveau ultérieur de tension de la sortie de tension de commutation (26) ;

un circuit d'assistance (414) à la compensation d'ondulation en boucle ouverte configuré pour :

recevoir la sortie de tension estimée de commutation (38B, $V_{SW\_EST}$ et un signal $V_{RAMP}$ ($V_{RAMP}$)
produire un courant de compensation d'ondulation de haute fréquence (416, $I_{COR}$) en fonction de la sortie estimée de tension de commutation (38B, $V_{SW\_EST}$ et le signal $V_{RAMP}$ ($V_{RAMP}$) ; et
appliquer le courant de compensation d'ondulation de haute fréquence (416, $I_{COR}$) à une sortie (28) d'alimentation d'amplificateur de puissance, pour réduire un courant à ondulations à haute fréquence au niveau de la sortie (28) d'alimentation d'amplificateur de puissance.

**2.** Système (10) de gestion de la puissance suiveur de pseudo-enveloppe à compensation des ondulations de hautes fréquences selon la revendication 1, où le courant de compensation d'ondulation de haute fréquence (416, $I_{COR}$) est produit dans une bande de fréquences située sensiblement près d'un transmetteur, pour recevoir un décalage de duplex pour une bande de fonctionnement dans un réseau de télécommunication.

**3.** Système (10) de gestion de la puissance suiveur de pseudo-enveloppe à compensation des ondulations de hautes fréquences selon la revendication 2, où le convertisseur d'alimentation électrique à mode de commutation (420) comprend des circuits retard programmables (432) configurés pour retarder la production de la sortie estimée de tension de commutation (38B, $V_{SW\_EST}$) d'une période programmable de retard.

**4.** Système (10) de gestion de la puissance suiveur de pseudo-enveloppe à compensation des ondulations de hautes fréquences selon la revendication 3, où la période programmable de retard est configurée pour aligner temporairement la sortie estimée de tension de commutation (38B, $V_{SW\_EST}$) et le signal $V_{RAMP}$ ($V_{RAMP}$) pour positionner une encoche dans une réponse de rejet d'ondulation de la sortie (28) d'alimentation d'amplificateur de puissance près du transmetteur, pour recevoir un décalage en duplex pour la bande de fonctionnement.

**5.** Système (10) de gestion de la puissance suiveur de pseudo-enveloppe à compensation des ondulations de hautes fréquences selon la revendication 1, où le circuit d'assistance (414) à la compensation d'ondulation en boucle ouverte est en outre configuré pour produire une estimation proportionnée de courant de compensation d'ondulations à haute fréquence (418, $I_{COR\_SENSE}$) en fonction du courant de compensation des ondulations à haute fréquence (416, $I_{COR}$).

**6.** Système (10) de gestion de la puissance suiveur de pseudo-enveloppe à compensation des ondulations de hautes fréquences selon la revendication 5, où le convertisseur d'alimentation électrique à mode de commutation (420) est en outre configuré pour recevoir une estimation du courant de sortie du circuit à amplificateur en parallèle (40, $I_{PAWA\_OUT\_EST}$), l'estimation du courant de sortie du circuit à amplificateur en parallèle (40, $I_{PAWA\_OUT\_EST}$) étant fondée sur l'estimation proportionnée de courant de compensation d'ondulations à haute fréquence (418, $I_{COR\_SENSE}$).

**7.** Système (10) de gestion de la puissance suiveur de pseudo-enveloppe à compensation des ondulations de hautes fréquences selon la revendication 6, où le convertisseur d'alimentation électrique à mode de commutation (420) est en outre configuré pour ajuster la sortie de tension de commutation (26) en fonction de l'estimation du courant de sortie du circuit à amplificateur en parallèle (40, $I_{PAWA\_OUT\_EST}$).

**8.** Système (10) de gestion de la puissance suiveur de pseudo-enveloppe à compensation des ondulations de hautes fréquences selon la revendication 6, où l'estimation du courant de sortie du circuit à amplificateur en parallèle (40, $I_{PAWA\_OUT\_EST}$) est en outre fondée sur une estimation proportionnée du courant de sortie de l'amplificateur en parallèle ($I_{PARA\_AMP\_SENSE}$).

**9.** Système (10) de gestion de la puissance suiveur de pseudo-enveloppe à compensation des ondulations de hautes fréquences selon la revendication 1, comprenant en outre un amplificateur en parallèle (35) configuré pour :

   recevoir un signal $V_{RAMP}$ ($V_{RAMP}$);
   recevoir une tension d'alimentation d'amplificateur de puissance (Vcc) à partir de la sortie (28) d'alimentation d'amplificateur de puissance ;
   produire un courant de sortie de l'amplificateur en parallèle ($I_{PARA\_AMP}$) en fonction d'une différence entre le signal $V_{RAMP}$ ($V_{RAMP}$) et la tension d'alimentation d'amplificateur de puissance (Vcc) ; et
   appliquer le courant de sortie de l'amplificateur en parallèle ($I_{PARA\_AMP}$) à la sortie (28) d'alimentation d'amplificateur de puissance.

**10.** Système (10) de gestion de la puissance suiveur de pseudo-enveloppe à compensation des ondulations de hautes fréquences selon la revendication 9, où l'amplificateur en parallèle (35) est en outre configuré pour produire une estimation proportionnée du courant de sortie de l'amplificateur en parallèle ($I_{PARA\_AMP\_SENSE}$) en fonction du courant de sortie de l'amplificateur en parallèle ($I_{PARA\_AMP}$).

**11.** Système (10) de gestion de la puissance suiveur de pseudo-enveloppe à compensation des ondulations de hautes fréquences selon la revendication 1, où le circuit d'assistance (414) à la compensation d'ondulation en boucle ouverte comprend :

   un réseau de filtrage (436) couplé à un amplificateur opérationnel (442) et configuré pour recevoir la sortie estimée de tension de commutation (38C, $V_{SW-EST}$) ; et
   l'amplificateur opérationnel (442) configuré pour recevoir le signal $V_{RAMP}$ ($V_{RAMP}$) et pour produire le courant de compensation d'ondulation de haute fréquence (416, $I_{COR}$) en fonction du signal $V_{RAMP}$ ($V_{RAMP}$) et de la sortie estimée de tension de commutation (38C, $V_{SW\_EST}$).

**12.** Système (10) de gestion de la puissance suiveur de pseudo-enveloppe à compensation des ondulations de hautes fréquences selon la revendication 11, où l'amplificateur opérationnel (442) est en outre configuré pour procurer une estimation proportionnée de courant de compensation d'ondulations à haute fréquence (418, $I_{COR\_SENSE}$) en fonction du signal $V_{RAMP}$ ($V_{RAMP}$) et de la sortie estimée de tension de commutation (38C, $V_{SW\_EST}$).

**13.** Système (10) de gestion de la puissance suiveur de pseudo-enveloppe à compensation des ondulations de hautes fréquences selon la revendication 1, où le convertisseur d'alimentation électrique à mode de commutation (420) est configuré pour fonctionner comme un convertisseur mâle.

**14.** Système (10) de gestion de la puissance suiveur de pseudo-enveloppe à compensation des ondulations de hautes fréquences selon la revendication 1, où le convertisseur d'alimentation électrique à mode de commutation (420) est configuré pour fonctionner comme un convertisseur mâle de pompe de charge à niveaux multiples.

**15.** Procédé de réduction de courants d'ondulation à haute fréquence au niveau d'une sortie (28) d'alimentation d'amplificateur de puissance, comprenant :

la production d'une sortie de tension de commutation (26) ;
la production d'une sortie estimée de tension de commutation (38B, $V_{SW\_EST}$), la sortie estimée de tension de commutation (38B, $V_{SW\_EST}$) procurant une indication précoce d'un niveau ultérieur de tension de la sortie de tension de commutation (26) ;
la réception de la sortie estimée de tension de commutation (38B, $V_{SW-EST}$) et d'un signal $V_{RAMP}$ signal ($V_{RAMP}$);
la production d'un courant de compensation des ondulations à haute fréquence (416, $I_{COR}$) en fonction de la sortie estimée de tension de commutation (38B, $V_{SW\_EST}$) et du signal $V_{RAMP}$ signal ($V_{RAMP}$); et
l'application du courant de compensation des ondulations à haute fréquence (416, $I_{COR}$) à la sortie (28) d'alimentation d'amplificateur de puissance pour réduire un courant d'ondulation à haute fréquence au niveau de la sortie (28) d'alimentation d'amplificateur de puissance.

*FIG. 1A*

**FIG. 1B**

**FIG. 2A**

EP 2 649 724 B1

**FIG. 2B**

**FIG. 3A**

EP 2 649 724 B1

**FIG. 3B**

FIG. 3C

**FIG. 3D**

**FIG. 4**

RIPPLE REJECTION RESPONSES OF THE PSEUDO-ENVELOPE FOLLOWER POWER MANAGEMENT SYSTEM
AS A FUNCTION OF TEMPORAL ALIGNMENT OF THE GENERATION OF THE $I_{COR}$ CURRENT

FIG. 5

HIGH PASS FILTER CIRCUITRY

430

430A

| FIRST HIGH PASS FILTER CIRCUIT 435A |

| SECOND HIGH PASS FILTER CIRCUIT 435B |

430B

**FIG. 6**

EP 2 649 724 B1

**FIG. 7A**

**FIG. 7B**

EP 2 649 724 B1

RIPPLE REJECTION RESPONSE FOR AN EXAMPLE PSEUDO-ENVELOPE FOLLOWER
POWER MANAGEMENT SYSTEM HAVING AN OPERATIONAL AMPLIFIER
ISOLATION CIRCUIT

....... FIRST RESPONSE (1pF)
—— THIRD RESPONSE (3pF)
– – – FIFTH RESPONSE (5pF)

*FIG. 8A*

EP 2 649 724 B1

RIPPLE REJECTION RESPONSE FOR AN EXAMPLE PSEUDO-ENVELOPE FOLLOWER
POWER MANAGEMENT SYSTEM WITHOUT AN OPERATIONAL AMPLIFIER
ISOLATION CIRCUIT

........ FIRST RESPONSE (1pF)
—··—··— SECOND RESPONSE (2pF)
— — — THIRD RESPONSE (3pF)
·— — FOURTH RESPONSE (4pF)
··—··—·· FIFTH RESPONSE (5pF)
——— REFERENCE RESPONSE

*FIG. 8B*

EP 2 649 724 B1

**FIG. 9A**

**FIG. 9B**

CONTROLLER 50

CNTR_SP_BUS (5:1) — 482
CNTR_SN_BUS (5:1) — 484
CNTR_CP_BUS (5:0) — 478
CNTR_CN_BUS (5:0) — 480

OPERATIONAL AMPLIFIER 442

442A

NON-INVERTING INPUT (+)   $V_{DD}$

OUTPUT STAGE PFET$_A$ CONTROL

OPERATIONAL AMPLIFIER FRONT-END STAGE CIRCUIT 466

OUTPUT STAGE NFET$_A$ CONTROL

INVERTING INPUT (−)

442B

OUTPUT STAGE PFET$_A$ CONTROL SIGNAL

$V_{PFET\_A\_CNTR}$

OUTPUT STAGE NFET$_A$ CONTROL SIGNAL

474

476

$V_{DD}$

OPERATIONAL AMPLIFIER PUSH-PULL OUTPUT STAGE CIRCUIT (FIG. 10A) 468

$V_{DD}$

OPERATIONAL AMPLIFIER CONTROLLED $I_{COR}$ CURRENT CIRCUIT (FIG. 10A) 470

470A

416 — $I_{COR}$

$V_{DD}$

$V_{NFET\_A\_CNTR}$

OPERATIONAL AMPLIFIER CONTROLLED $I_{COR\_SENSE}$ CURRENT CIRCUIT (FIG. 10B) 472

472A

418 — $I_{COR\_SENSE}$

$I_{AMP}$

$I_{FEEDBACK}$

$V_{AMP}$

442C

$I_{Gm\_BIAS}$

Gm BIAS CIRCUIT (FIG. 10D) 444

456

OPERATIONAL AMPLIFIER CIRCUITRY 440B

EP 2 649 724 B1

FIG. 10A

OPERATIONAL AMPLIFIER CIRCUITRY

OPERATIONAL AMPLIFIER CONTROLLED $I_{COR\_SENSE}$ CURRENT CIRCUIT

FIG. 10B

EP 2 649 724 B1

OPERATIONAL AMPLIFIER CIRCUIT

**FIG. 10C**

EP 2 649 724 B1

OPERATIONAL AMPLIFIER CIRCUIT

**FIG. 10D**

PROGRAMMABLE Gm$_{ICOR}$ OF THE OPERATIONAL AMPLIFIER I$_{COR}$
CURRENT CIRCUIT VERSUS ZoutN(P)

FIG. 11

EP 2 649 724 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61421348 A
- US 61421475 A
- US 61469276 A
- US 08991711 A
- US 61325659 A
- US 21840011 A
- US 61376877 A
- US 218400 A

**Non-patent literature cited in the description**

- **JINSUNG CHOI et al.** A New Power Management IC Architecture for Envelope Tracking Power Amplifier. *IEEE TRANSACTIONS ON MICROWAVE THEORY AND TECHNIQUES,* 01 July 2011, vol. 59 (7), 1796-1802